(19) Europäisches Patentamt
European Patent Office
Office européen des brevets

(11) **EP 4 676 205 A1**

(12) **EUROPEAN PATENT APPLICATION**
published in accordance with Art. 153(4) EPC

(43) Date of publication:
**07.01.2026  Bulletin 2026/02**

(21) Application number: 24855502.1

(22) Date of filing: **08.07.2024**

(51) International Patent Classification (IPC):
**H10K 59/131** (2023.01)      **G09G 3/3225** (2016.01)
**G09G 3/32** (2016.01)

(52) Cooperative Patent Classification (CPC):
**G09G 3/32; G09G 3/3225; H10D 86/60;
H10K 59/12; H10K 59/131**

(86) International application number:
**PCT/CN2024/104211**

(87) International publication number:
**WO 2025/039773 (27.02.2025 Gazette 2025/09)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority:  23.08.2023  CN 202311068768

(71) Applicants:
• **Boe Technology Group Co., Ltd.
Beijing 100015 (CN)**
• **Chengdu BOE Optoelectronics Technology Co.,
Ltd.
Chengdu, Sichuan 611731 (CN)**

(72) Inventors:
• **ZHOU, Weifeng
Beijing 100176 (CN)**
• **SHI, Ling
Beijing 100176 (CN)**
• **ZHAO, Zhongman
Beijing 100176 (CN)**
• **HUANG, Chienpang
Beijing 100176 (CN)**

(74) Representative: **Durán-Corretjer, S.L.P.
Còrsega, 329
(Paseo de Gracia/Diagonal)
08037 Barcelona (ES)**

(54) **DISPLAY SUBSTRATE AND PREPARATION METHOD THEREFOR, AND DISPLAY APPARATUS**

(57)    A display substrate and a preparation method therefor, and a display apparatus. The display substrate comprises a drive structure layer and a light-emitting structure layer, wherein the drive structure layer comprises a first pixel drive circuit, a second pixel drive circuit and a third pixel drive circuit; and the light-emitting structure layer comprises a first light-emitting device, a second light-emitting device and a third light-emitting device, wherein the first light-emitting device is connected to the first pixel drive circuit, the second light-emitting device is connected to the second pixel drive circuit, and the third light-emitting device is connected to the third pixel drive circuit. The drive structure layer further comprises a first power supply line, a second power supply line, a third power supply line and a connecting line, wherein the first power supply line is connected to the first pixel drive circuit, the second power supply line is connected to the second pixel drive circuit, the third power supply line is connected to the third pixel drive circuit, and the con-necting line is connected to the first power supply line, the second power supply line or the third power supply line, so as to form, on the display substrate, a grid communication structure for transmitting a power supply signal.

FIG. 7

## Description

The present application claims priority to Chinese Patent Application No. 202311068768.8 filed to the CNIPA on August 23, 2023 and entitled "Display Substrate and Preparation method Therefor, and Display Apparatus", contents of which should be construed as being incorporated into the present application by reference.

Technical Field

The present disclosure relates to, but is not limited to, the field of display technologies, and particularly to a display substrate, a method for preparing the display substrate, and a display apparatus.

Background

An organic light emitting diode (OLED) and a quantum dot light emitting diode (QLED) are active light emitting display devices and have advantages of self-illumination, wide viewing angle, high contrast ratio, low power consumption, an very high response speed, lightness and thinness, flexibility, and low cost, etc. With constant development of display technologies, a flexible display apparatus (Flexible Display) in which an OLED or a QLED is used as a light emitting device and signal control is performed through a thin film transistor (TFT) has become a mainstream product in the field of display at present.

Summary

The following is a summary of subject matter described herein in detail. This summary is not intended to limit the protection scope of claims.

In one aspect, the present disclosure provides a display substrate, including a display area and a bonding area disposed on at least one side of the display area, wherein the display area includes a drive structure layer disposed on a base substrate and a light emitting structure layer disposed on a side of the drive structure layer away from the base substrate, the drive structure layer includes a plurality of circuit units forming a plurality of unit rows and a plurality of unit columns, a circuit unit at least includes a pixel drive circuit, the light emitting structure layer includes a plurality of light emitting units, a light emitting unit at least includes a light emitting device; the plurality of circuit units at least include a first circuit unit provided with a first pixel drive circuit, a second circuit unit provided with a second pixel drive circuit, and a third circuit unit provided with a third pixel drive circuit, the plurality of light emitting units at least include a first light emitting unit provided with a first light emitting device, a second light emitting unit provided with a second light emitting device, and a third light emitting unit provided with a third light emitting device, the first light emitting device, the second light emitting device, and the third light emitting device emit light of different colors; the first light emitting device is connected to the first pixel drive circuit, the second light emitting device is connected to the second pixel drive circuit, and the third light emitting device is connected to the third pixel drive circuit; the drive structure layer further includes at least one connection line extending at least partially along a first direction, and a first power supply line, a second power supply line, and a third power supply line extending at least partially along a second direction, the first direction intersects with the second direction, the first power supply line, the second power supply line, and the third power supply line have different potentials; the first power supply line is connected to the first pixel drive circuit, the second power supply line is connected to the second pixel drive circuit, and the third power supply line is connected to the third pixel drive circuit; and the at least one connection line is connected to the first power supply line, the second power supply line, or the third power supply line to form a grid communication structure for transmitting a power supply signal on the display substrate.

In an exemplary implementation mode, the first power supply line and the third power supply line are disposed in a same unit column, or the first power supply line and the third power supply line are disposed in different unit columns.

In an exemplary implementation mode, the drive structure layer includes a plurality of conductive layers in a direction perpendicular to the base substrate, and any one or more of the first power supply line, the second power supply line, and the third power supply line are disposed in at least one conductive layer.

In an exemplary implementation mode, the at least one connection line includes any one or more of a first connection line, a second connection line, and a third connection line; the first connection line is connected to the first power supply line to form a grid communication structure for transmitting a first power supply signal on the display substrate; the second connection line is connected to the second power supply line to form a grid communication structure for transmitting a second power supply signal on the display substrate; and the third connection line is connected to the third power supply line to form a grid communication structure for transmitting a third power supply signal on the display substrate.

In an exemplary implementation mode, any one or more of the first connection line, the second connection line, and the third connection line is disposed in at least one unit row.

In an exemplary implementation mode, the drive structure layer includes a plurality of conductive layers in a direction perpendicular to the base substrate, and any one or more of the first connection line, the second connection line, and the third connection line are disposed in at least one conductive layer.

In an exemplary implementation mode, the drive structure layer includes a plurality of conductive layers in a direction perpendicular to the base substrate, and the first power supply line and the first connection line are disposed in different conductive layers; or, the second power supply line and the second connection line are disposed in different conductive layers; or, the third power supply line and the third connection line are disposed in different conductive layers.

In an exemplary implementation mode, the plurality of circuit units further includes a fourth circuit unit provided with a fourth pixel drive circuit, the plurality of light emitting units further includes a fourth light emitting unit provided with a fourth light emitting device, the fourth light emitting unit and the second light emitting device emit light of a same color, and the drive structure layer further includes a fourth power supply line and a fourth connection line, the fourth power supply line is connected to the fourth pixel drive circuit, and the fourth connection line is connected to the fourth power supply line to form a grid communication structure for transmitting a fourth power supply signal on the display substrate.

In an exemplary implementation mode, the second connection line is further connected to the fourth power supply line, and the fourth connection line is further connected to the second power supply line.

In an exemplary implementation mode, the drive structure layer further includes a first data signal line, a second data signal line, and a third data signal line, the first data signal line is connected to the first pixel drive circuit, the second data signal line is connected to the second pixel drive circuit, and the third data signal line is connected to the third pixel drive circuit; any one or more of the first data signal line, the second data signal line, and the third data signal line are disposed in at least one unit column.

In an exemplary implementation mode, the drive structure layer further includes a fifth power supply line, a sixth power supply line, and a seventh power supply line, the fifth power supply line is connected to a cathode of the first light emitting device, the sixth power supply line is connected to a cathode of the second light emitting device, and the seventh power supply line is connected to a cathode of the third light emitting device.

In an exemplary implementation mode, in a direction perpendicular to the base substrate, the display substrate includes a plurality of conductive layers, an anode transfer line is disposed in any one or more of the conductive layers, the first power supply line and the third power supply line are disposed in different unit columns, the first pixel drive circuit is connected to the first light emitting device through the anode transfer line, and/or the third pixel drive circuit is connected to the third light emitting device through the anode transfer line.

In an exemplary implementation mode, the first light emitting device at least includes a first anode, the first anode at least includes a main body portion and a connection portion, orthographic projections of main body portions of at least some first anodes on a base substrate plane are not overlapped with an orthographic projection of the first pixel drive circuit on the base substrate plane, a first end of the anode transfer line is connected to the main body portion of the first anode, a second end of the anode transfer line is connected to the connection portion of the first anode, and the connection portion of the first anode is connected to the first pixel drive circuit; and/or the third light emitting device at least includes a third anode, the third anode at least includes a main body portion and a connection portion, orthographic projections of main body portions of at least some third anodes on the base substrate plane are not overlapped with an orthographic projection of the third pixel drive circuit on the base substrate plane, a first end of the anode transfer line is connected to the main body portion of the third anode, a second end of the anode transfer line is connected to the connection portion of the third anode, and the connection portion of the third anode is connected to the third pixel drive circuit.

In an exemplary implementation mode, orthographic projections of main body portions of at least some first anodes on the base substrate plane are at least partially overlapped with the orthographic projection of the third pixel drive circuit on the base substrate plane; and/or orthographic projections of main body portions of at least some third anodes on the base substrate plane are at least partially overlapped with the orthographic projection of the first pixel drive circuit on the base substrate plane.

In an exemplary implementation mode, an orthographic projection of the anode transfer line on the base substrate plane is at least partially overlapped with an orthographic projection of the second pixel drive circuit on the base substrate plane; and/or the orthographic projection of the anode transfer line on the base substrate plane is at least partially overlapped with an orthographic projection of the fourth pixel drive circuit on the base substrate plane.

In an exemplary implementation mode, the first light emitting device at least includes a first anode, the first anode at least includes a main body portion and a connection portion, a first end of the connection portion of the first anode is connected to the main body portion of the first anode, a second end of the connection portion of the first anode is connected to the first pixel drive circuit, and orthographic projections of main body portions of at least some first anodes on the base substrate plane are at least partially overlapped with an orthographic projection of the first pixel drive circuit on the base substrate plane; and/or the third light emitting device at least includes a third anode, the third anode at least includes a main body portion and a connection portion, a first end of the connection portion of the third anode is connected to the main body portion of the third anode, a second end of the connection portion of the third anode is connected to the third pixel drive circuit, and orthographic projections of main body portions of at least some third anodes on the base substrate plane are at least partially overlapped with an orthographic projection of the third pixel drive circuit on the base substrate plane.

In an exemplary implementation mode, the bonding area at least includes a first high-potential power supply lead line, a second high-potential power supply lead line, and a third high-potential power supply lead line, wherein the first power supply line is connected to the first high-potential power supply lead line, the second power supply line is connected to the second high-potential power supply lead line, and the third power supply line is connected to the third high-potential power supply lead line.

In an exemplary implementation mode, the display substrate further includes a flexible printed circuit bonded to the bonding area, the flexible printed circuit at least includes a control circuit, a plurality of circuit board pads, and a plurality of power supply transmission lines, the control circuit at least includes a first control circuit providing a first power supply signal, a second control circuit providing a second power supply signal, and a third control circuit providing a third power supply signal, the plurality of circuit board pads at least include a first pad, a second pad, and a third pad, and the plurality of power supply transmission lines at least include a first transmission line, a second transmission line, and a third transmission line; the first control circuit is connected to the first high-potential power supply lead line of the bonding area through the first transmission line and the first pad, the second control circuit is connected to the second high-potential power supply lead line of the bonding area through the second transmission line and the second pad, and the third control circuit is connected to the third high-potential power supply lead line of the bonding area through the third transmission line and the third pad.

In an exemplary embodiment, the display substrate further includes a flexible printed circuit bonded to the bonding area, the flexible printed circuit at least includes a control circuit, a plurality of circuit board pads, and a plurality of power supply transmission lines, the control circuit at least includes a management integrated circuit, the management integrated circuit at least includes a first signal channel providing a first power supply signal, a second signal channel providing a second power supply signal, and a third signal channel providing a third power supply signal, the plurality of circuit board pads at least include a first pad, a second pad, and a third pad, and the plurality of power supply transmission lines at least include a first transmission line, a second transmission line, and a third transmission line; the first signal channel is connected to the first high-potential power supply lead line of the bonding area through the first transmission line and the first pad, the second signal channel is connected to the second high-potential power supply lead line of the bonding area through the second transmission line and the second pad, and the third signal channel is connected to the third high-potential power supply lead line of the bonding area through the third transmission line and the third pad.

In another aspect, a display apparatus is also provided in the present disclosure, and the display apparatus includes the display substrate described above.

In yet another aspect, the present disclosure also provides a preparation method of a display substrate, including a display area and a bonding area disposed on at least a side of the display area, the preparation method includes:

forming a drive structure layer on a base substrate of the display area, wherein the drive structure layer includes a plurality of circuit units forming a plurality of unit rows and a plurality of unit columns, the plurality of circuit units at least include a first circuit unit provided with a first pixel drive circuit, a second circuit unit provided with a second pixel drive circuit, and a third circuit unit provided with a third pixel drive circuit; the drive structure layer further includes at least one connection line extending at least partially along a first direction, and a first power supply line, a second power supply line, and a third power supply line extending at least partially along a second direction, the first direction intersects with the second direction, the first power supply line, the second power supply line, and the third power supply line have different potentials; the first power supply line is connected to the first pixel drive circuit, the second power supply line is connected to the second pixel drive circuit, and the third power supply line is connected to the third pixel drive circuit; and the at least one connection line is connected to the first power supply line, the second power supply line, or the third power supply line to form a grid communication structure for transmitting a power supply signal on the display substrate; and

forming a light emitting structure layer on the drive structure layer, wherein the light emitting structure layer includes a plurality of light emitting units, the plurality of light emitting units at least include a first light emitting unit provided with a first light emitting device, a second light emitting unit provided with a second light emitting device, and a third light emitting unit provided with a third light emitting device, the first light emitting device, the second light emitting device, and the third light emitting device emit light of different colors; the first light emitting device is connected to the first pixel drive circuit, the second light emitting device is connected to the second pixel drive circuit, and the third light emitting device is connected to the third pixel drive circuit.

Other aspects of the present disclosure may be comprehended after the drawings and the detailed descriptions are read and understood.

Brief Description of Drawings

Accompanying drawings are used to provide understanding of technical solutions of the present disclosure, and form a part of the specification. The accompanying drawings and embodiments of the present disclosure are used to explain the technical solutions of the present disclosure, and do not form limitations on the technical solutions of the present disclosure.

FIG. 1 is a schematic diagram of a structure of a display apparatus.

FIG. 2 is a schematic diagram of a structure of a display substrate.

FIG. 3 is a schematic diagram of a planar structure of a display area in a display substrate.

FIG. 4 is a schematic diagram of a sectional structure of a display area in a display substrate.

FIG.5 is an equivalent circuit diagram of a pixel drive circuit.

FIGs. 6A to 6C are schematic diagrams of connection between a circuit unit and a light emitting unit according to the present disclosure.

FIG. 7 is a schematic diagram of connection between power supply lines and connection lines in a display substrate according to the present disclosure.

FIG. 8A and FIG. 8B are schematic diagrams of a display substrate after a pattern of a first semiconductor layer is formed according to the present disclosure.

FIGs. 9A to 9C are schematic diagrams of a display substrate after a pattern of a first conductive layer is formed according to the present disclosure.

FIGs. 10A to 10C are schematic diagrams of a display substrate after a pattern of a second conductive layer is formed according to the present disclosure.

FIGs. 11A to 11C are schematic diagrams of a display substrate after a pattern of a second semiconductor layer is formed according to the present disclosure.

FIGs. 12A to 12C are schematic diagrams of a display substrate after a pattern of a third conductive layer is formed according to the present disclosure.

FIGs. 13A and 13B are schematic diagrams of a display substrate after a pattern of a six insulation layer according to the present disclosure.

FIGs. 14A to 14C are schematic diagrams of a display substrate after a pattern of a fourth conductive layer is formed according to the present disclosure.

FIGs. 15A and 15B are schematic diagrams of a display substrate after a pattern of a first planarization layer is formed according to the present disclosure.

FIGs. 16A to 16C are schematic diagrams of a display substrate after a pattern of a fifth conductive layer is formed according to the present disclosure.

FIGs. 16D to 16F are schematic diagrams of connection of a data signal line according to an embodiment of the present disclosure.

FIGs. 17A and 17B are schematic diagrams of a display substrate after a pattern of a second planarization layer is formed according to the present disclosure.

FIGs. 18A to 18C are schematic diagrams of a display substrate after a pattern of a sixth conductive layer is formed according to the present disclosure.

FIG. 18D is a schematic diagram of connection of a connection line according to an embodiment of the present disclosure.

FIGs. 19A and 19B are schematic diagrams of a display substrate after a pattern of a third planarization layer is formed according to the present disclosure.

FIGs. 20A and 20B are schematic diagrams of a display substrate after a pattern of an anode conductive layer is formed according to the present disclosure.

FIGs. 21A to 21C are schematic diagrams of another connection between a circuit unit and a light emitting unit according to the present disclosure.

FIG. 22 is a schematic diagram of connection between a power supply line and a connection line in another display substrate according to the present disclosure.

FIGs. 23A to 23C are schematic diagrams of another display substrate after a pattern of a fourth conductive layer is formed according to the present disclosure.

FIGs. 24A and 24B are schematic diagrams of another display substrate after a pattern of a first planarization layer is formed according to the present disclosure.

FIGs. 25A to 25C are schematic diagrams of another display substrate after a pattern of a fifth conductive layer is formed according to the present disclosure.

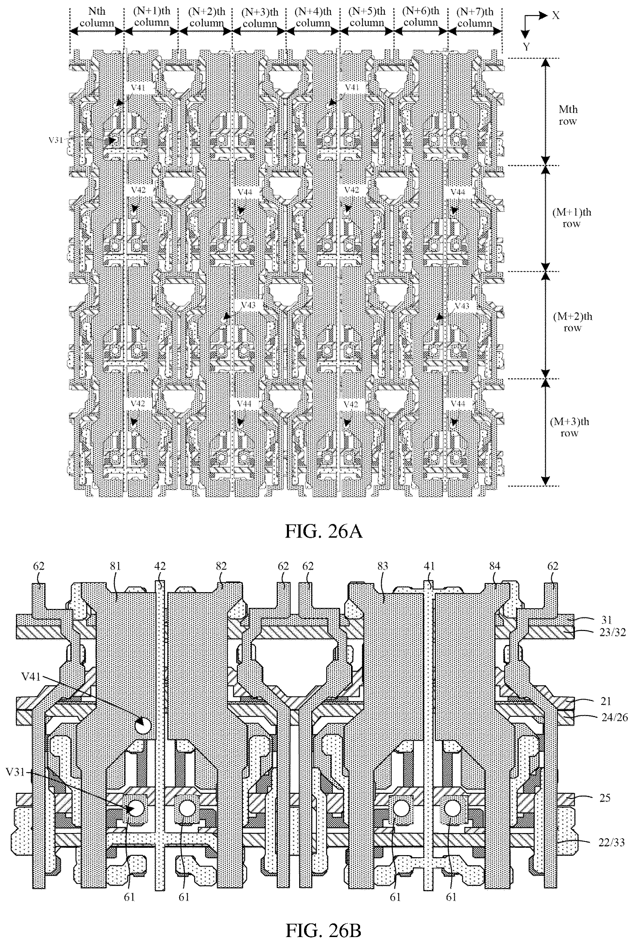

FIGs. 26A and 26B are schematic diagrams of another display substrate after a pattern of a second planarization layer is formed according to the present disclosure.

FIGs. 27A to 27C are schematic diagrams of another display substrate after a pattern of a sixth conductive layer is formed according to the present disclosure.

FIGs. 28A and 28B are schematic diagrams of another display substrate after a pattern of a third planarization layer is formed according to the present disclosure.

FIGs. 29A and 29B are schematic diagrams of another display substrate after a pattern of an anode conductive layer is formed according to the present disclosure.

FIG. 29C is a schematic diagram of connection of an anode transfer line according to an embodiment of the present disclosure.

FIGs. 30A to 30C are schematic diagrams of another connection between a circuit unit and a light emitting unit according to the present disclosure.

FIG. 31 is a schematic diagram of connection between a power supply line and a connection line in another display substrate according to the present disclosure.

FIGs. 32A to 32C are schematic diagrams of another connection between a circuit unit and a light emitting unit according to the present disclosure.

FIG. 33 is a schematic diagram of connection between a power supply line and a connection line in another display substrate according to the present disclosure.

FIGs. 34A to 34C are schematic diagrams of another connection between a circuit unit and a light emitting unit according to the present disclosure.

FIG. 35 is a schematic diagram of connection between a power supply line and a connection line in another display substrate according to the present disclosure.

FIG. 36 is a schematic diagram of a power supply trace in a bonding area according to an exemplary embodiment of the present disclosure.

FIG. 37 is a schematic diagram of a power supply trace in a flexible printed circuit according to an exemplary embodiment of the present disclosure.

FIG. 38 is a schematic diagram of a power supply trace in another flexible printed circuit according to an exemplary embodiment of the present disclosure.

FIG. 39 is a schematic diagram of connection between a low-potential power supply line and a low-potential connection line in a display substrate according to the present disclosure.

FIG. 40 is a schematic diagram of a power supply trace in a bezel area according to an exemplary embodiment of the present disclosure.

Reference signs are described as follows.

| | | |
|---|---|---|
| 11-first active layer; | 12-second active layer; | 13-third active layer; |
| 14-fourth active layer; | 15-fifth active layer; | 16-sixth active layer; |
| 17-seventh active layer; | 18-eighth active layer; | 21-first scan signal line; |
| 22-second scan signal line | 23-third scan signal line; | 24-fourth scan signal line; |
| 25-light emitting signal line; | 26-shield line; | 31-first initial signal line; |
| 32-second initial signal line; | 33-third initial signal line; | 41-first initial connection line; |
| 42-second initial connection line; | 43-first initial connection strip; | 44-second initial connection strip; |
| 51-first connection electrode; | 52-second connection electrode; | 53-third connection electrode; |
| 54-fourth connection electrode; | 55-fifth connection electrode; | 56-sixth connection electrode; |
| 57-seventh connection electrode; | 58-eighth connection electrode; | 59-ninth connection electrode; |
| 61-eleventh connection electrode; | 62-data signal line; | 63-anode connection electrode; |
| 71-first plate; | 72-second plate; | 73-opening; |
| 81-first power supply line; | 82-second power supply line; | 83-third power supply line; |
| 84-fourth power supply line; | 85-fifth power supply line; | 86-sixth power supply line; |
| 87-seventh power supply line; | 90a-first anode; | 90b-second anode; |
| 90c-third anode; | 90d-fourth anode; | 91-first connection line; |
| 92-second connection line; | 93-third connection line; | 94-fourth connection line; |
| 95-fifth connection line; | 96-sixth connection line; | 97-seventh connection line; |
| 100-display area; | 101-base substrate; | 102-drive circuit layer; |
| 103-light emitting structure layer | structure layer; | 110-main body portion; |
| 120-connection portion; | 130-anode transfer line; | 200-bonding area; |
| 201-first high-potential power supply lead line; | 202-second high-potential power supply lead line; | 203-third high-potential power supply lead line; |
| 210-control circuit; | 211-first control circuit; | 212-second control circuit; |
| 213-third control circuit; | 214-management integrated circuit; | 214a-first signal channel; |
| 214b-second signal channel; | 214c-third signal channel; | 221-first pad; |
| 222-second pad; | 223-third pad; | 231-first transmission line; |
| 232-second transmission line; | 233-third transmission line; | 300-bezel area; |
| 301-first low-potential power supply lead line; | 302-second low-potential power supply lead line; | 303-third low-potential power supply lead line; |
| 310-first cathode line; | 320-second cathode line; | 330-third cathode line. |

Detailed Description

To make objectives, technical solutions, and advantages of the present disclosure clearer, the embodiments of the present disclosure will be described in detail below with reference to the accompanying drawings. It is to be noted that implementation modes may be implemented in a plurality of different forms. Those of ordinary skills in the art may easily understand such a fact that implementation modes and contents may be transformed into various forms without departing from the purpose and scope of the present disclosure. Therefore, the present disclosure should not be explained as being limited to the contents recorded in the following implementation modes only. The embodiments and features in the embodiments of the present disclosure may be randomly combined with each other if there is no conflict.

Scales of the drawings in the present disclosure may be used as a reference in actual processes, but are not limited thereto. For example, a width-length ratio of a channel, a thickness and spacing of each film layer, and a width and spacing of each signal line may be adjusted according to actual needs. A quantity of pixels in a display substrate and a quantity of sub-pixels in each pixel are not limited to numbers shown in the drawings. The drawings described in the present disclosure are schematic structural diagrams only, and one implementation mode of the present disclosure is not limited to shapes, numerical values, or the like shown in the drawings.

Ordinal numerals "first", "second", "third", etc., in the specification are set not to form limits in numbers but only to avoid confusion between constituent elements.

In the specification, for convenience, expressions "central", "above", "below", "front", "back", "vertical", "horizontal", "top", "bottom", "inside", "outside", etc., for indicating directional or positional relationships are used to illustrate positional relationships between the constituent elements with reference to the accompanying drawings, not to indicate or imply that involved devices or elements are required to have specific orientations or are structured and operated in the specific orientations but only to easily describe the present specification and simplify the description, and thus should not be understood as limitations on the present disclosure. The positional relationships between the constituent elements may be changed as appropriate based on a direction according to which each constituent element is described. Therefore, appropriate replacements based on situations are allowed, which is not limited to the expressions in the specification.

In the specification, unless otherwise explicitly specified and defined, terms "mount", "couple", and "connect" should be understood in a broad sense. For example, a connection may be a fixed connection, or a detachable connection, or an integral connection; it may be a mechanical connection or an electrical connection; it may be a direct connection, or an indirect connection through a middleware, or an internal communication between two elements. Those of ordinary skills in the art may understand specific meanings of the above terms in the present disclosure according to specific situations.

In the specification, a transistor refers to an element that at least includes three terminals, i.e., a gate electrode, a drain electrode, and a source electrode. The transistor has a channel region between the drain electrode (drain electrode terminal, drain region, or drain) and the source electrode (source electrode terminal, source region, or source), and a current can flow through the drain electrode, the channel region, and the source electrode. It is to be noted that in the specification, the channel region refers to a region through which a current mainly flows.

In the specification, a first electrode may be a drain electrode, and a second electrode may be a source electrode. Or, the first electrode may be a source electrode, and the second electrode may be a drain electrode. In a case that transistors with opposite polarities are used, or in a case that a direction of a current changes during operation of a circuit, or the like, functions of the "source electrode" and the "drain electrode" are sometimes interchangeable. Therefore, the "source electrode" and the "drain electrode", as well as a "source electrode" and a "drain electrode", are interchangeable in the specification.

In the specification, an "electrical connection" includes a case that constituent elements are connected together through an element with a certain electrical action. The "element with a certain electrical action" is not particularly limited as long as electrical signals between the connected constituent elements may be sent and received. Examples of the "element with a certain electrical action" not only include an electrode and a wiring, but also include a switching element such as a transistor, a resistor, an inductor, a capacitor, other elements with various functions, etc.

In the specification, "parallel" refers to a state in which an angle formed by two straight lines is above -10° and below 10°, and thus may include a state in which the angle is above -5° and below 5°. In addition, "perpendicular" refers to a state in which an angle formed by two straight lines is above 80° and below 100°, and thus may include a state in which the angle is above 85° and below 95°.

In the specification, a "film" and a "layer" are interchangeable. For example, a "conductive layer" may be replaced with a "conductive film" sometimes. Similarly, an "insulation film" may be replaced with an "insulation layer" sometimes.

A triangle, rectangle, trapezoid, pentagon, or hexagon, etc. in the specification is not strictly defined, and it may be an approximate triangle, rectangle, trapezoid, pentagon, or hexagon, etc. There may be some small deformations caused by tolerance, and there may be a chamfer, an arc edge, deformation, etc.

In the present disclosure, "about" means that a boundary is not defined so strictly and numerical values within process and measurement error ranges are allowed.

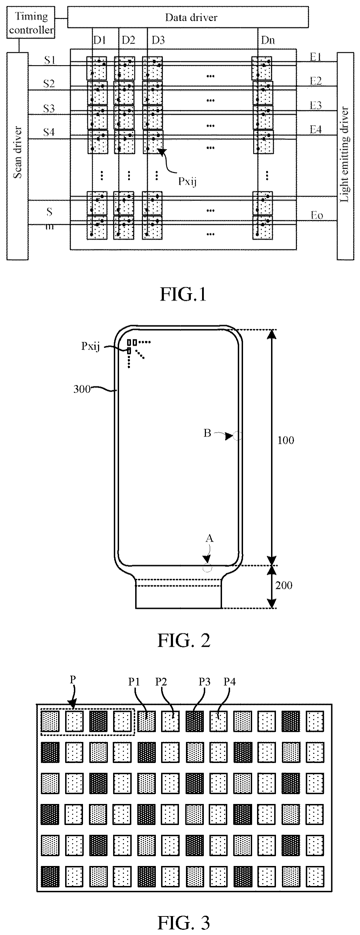

FIG. 1 is a schematic diagram of a structure of a display apparatus. As shown in FIG.1, the display apparatus may include a timing controller, a data driver, a scan driver, a light emitting driver, and a pixel array. The timing controller is connected to the data driver, the scan driver, and the light emitting driver respectively. The data driver is connected to a plurality of data signal lines (D1 to Dn) respectively. The scan driver is connected to a plurality of scan signal lines (S1 to Sm) respectively. The light emitting driver is connected to a plurality of light emitting signal lines (E1 to Eo) respectively. The pixel array may include a plurality of sub-pixels Pxij, i and j may be natural numbers, at least one sub-pixel Pxij may include a circuit unit and a light emitting unit. The circuit unit may at least include a pixel drive circuit connected to a scan signal line, a light emitting signal line and a data signal line respectively. The light emitting unit may include a light emitting device connected to the pixel drive circuit of the circuit unit. In an exemplary implementation mode, the timing controller may provide the data driver with a grayscale value and a control signal which are suitable for a specification of the data driver, provide the scan driver with a clock signal and a scan start signal and the like which are suitable for a specification of the scan driver, and provide the light emitting driver with a clock signal and an emission stop signal and the like which are suitable for a specification of the light emitting driver. The data driver may generate data voltages to be provided to the data signal lines D1, D2, D3, ..., and Dn using the grayscale value and the control signal that are received from the timing controller. For example, the data driver may sample the grayscale value using the clock signal and apply a data voltage corresponding to the grayscale value to the data signal lines DATA1 to Dn by taking a pixel row as a unit, wherein n may be a natural number. The scan driver may generate a scan signals to be provided to the scan signal lines S1, S2, S3, ..., and Sm by receiving the clock signal and the scan start signal from the timing controller. For example, the scan driver may sequentially provide a scan signal with an on-level pulse to the scan signal lines S1 to Sm. For example, the scan driver may be constructed in a form of a shift register and may generate a scan signal by transmitting the scan start signal provided in a form of an on-level pulse to a next-stage circuit sequentially under control of the clock signal, wherein m may be a natural number. The light emitting driver may receive the clock signal, the emission stop signal, and the like, from the timing controller to generate an emission signal to be provided to the light emitting signal lines E1, E2, E3, ..., and Eo. For example, the light emitting driver may sequentially provide an emission signal with an off-level pulse to the light emitting signal lines E1 to Eo. For example, the light emitting driver may be constructed in a form of a shift register and generate an emission signal by sequentially transmitting the emission stop signal provided in a form of an off-level pulse to a next-stage circuit under control of the clock signal, wherein o may be a natural number. In an exemplary implementation mode, the pixel array may be arranged on a display substrate.

FIG. 2 is a schematic diagram of a structure of a display substrate. As shown in FIG. 2, the display substrate may include a display area 100, a bonding area 200 located on a side of the display area 100, and a bezel area 300 located on another side of the display area 100. In an exemplary implementation mode, the display area 100 may be a planar region including a plurality of sub-pixels Pxij that form a pixel array. The plurality of sub-pixels are configured to display a dynamic picture or a still image, and the display area 100 may be referred to as an active area (AA for short). In an exemplary implementation mode, the display substrate may be a flexible substrate, so that the display substrate may be deformable, for example, be curled, bent, folded, or rolled.

In an exemplary implementation mode, the bonding area 200 may include a fan-out region, a bending region, a drive chip region, and a bonding pin region that are disposed sequentially along a direction away from the display area 100. The fan-out region is connected to the display area 100 and may include at least a plurality of data lead-out lines. The bending region is connected to the fan-out region and may include a composite insulation layer provided with a groove, and the groove is configured to enable the bonding area to be bent to a back of the display area. The drive chip region may at least include an Integrated Circuit (IC for short), and the Integrated Circuit is configured to be connected to a plurality of data leading-out lines. The bonding pin region may at least include a plurality of bonding pads, and the bonding pads are configured to be bonded to and connected to an external Flexible Printed Circuit (FPC for short).

In an exemplary implementation mode, the bezel area 300 may at least include a circuit region. The circuit region is connected to the display area 100, and may at least include a gate drive circuit, and the gate drive circuit is connected to the pixel drive circuit in the display area 100.

In an exemplary implementation mode, at least one dam spacer may be provided in the bonding area 200 and the bezel area 300, the dam spacer may extend along a direction parallel to an edge of the display area to form an annular structure surrounding the display area 100. The edge of the display area is an edge of the display area close to the bonding area, or the bezel area.

FIG. 3 is a schematic diagram of a planar structure of a display area in a display substrate. As shown in FIG. 3, the display area may include a plurality of pixel units P arranged in a matrix manner. At least one pixel unit P may include a first sub-pixel P1 emitting light of a first color, a second sub-pixel P2 emitting light of a second color, a third sub-pixel P3 emitting light of a third color, and a fourth sub-pixel P4 emitting light of a fourth color. Each sub-pixel may include a circuit unit and a light emitting unit. The circuit unit may at least include a pixel drive circuit. The pixel drive circuit is connected to a scan signal line, a light emitting signal line, a data signal line, and a high-potential power supply line respectively, and the pixel drive circuit is configured to receive a data voltage transmitted by the data signal line and output a corresponding current to the light emitting unit under control of the scan signal line and the light emitting signal line. A light emitting unit in each sub-pixel is connected to a pixel drive circuit of the sub-pixel where the light emitting unit is located, and is configured to emit light with corresponding brightness in response to a current output by the pixel drive circuit of the sub-pixel where the light emitting unit is located.

In an exemplary implementation mode, the first sub-pixel P1 may be a red sub-pixel (R) that emits red light, the second sub-pixel P2 may be a first green sub-pixel (G1) that emits green light, the third sub-pixel P3 may be a blue sub-pixel (B) that emits blue light, and the fourth sub-pixel P4 may be a second green sub-pixel (G2) that emits green light. In an exemplary implementation mode, a sub-pixel may be in a shape of a rectangle, a diamond, a pentagon, or a hexagon. The four sub-pixels may be arranged in a manner to form a diamond to form an RGBG pixel arrangement. In some other exemplary implementation modes, the four sub-pixels may be arranged side by side horizontally, side by side vertically, or in a manner to form a square, which is not limited in the present disclosure.

In an exemplary implementation mode, a pixel unit may include three sub-pixels, and the three sub-pixels may be arranged side by side horizontally, side by side vertically, or in a manner to form a triangle, etc., which is not limited here in the present disclosure.

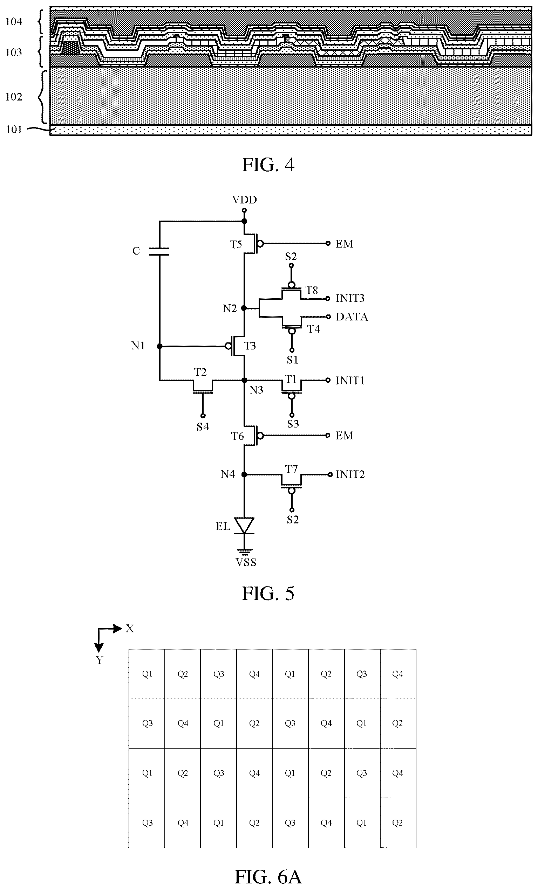

FIG. 4 is a schematic diagram of cross-sectional structure of a display area in a display substrate, illustrating a structure of four sub-pixels in the display area. As shown in FIG. 4, on a plane perpendicular to the display substrate, the display substrate may include a drive circuit layer 102 arranged on a base substrate 101, a light emitting structure layer 103 arranged on a side of the drive circuit layer 102 away from the base substrate 101, and an encapsulation structure layer 104 arranged on a side of the light emitting structure layer 103 away from the base substrate 101. In some possible implementation modes, the display substrate may include another film layer, such as a touch structure layer, which is not limited here in the present disclosure.

In an exemplary implementation mode, the base substrate 101 may be a flexible base substrate, or may be a rigid base substrate. The drive circuit layer 102 may include a plurality of circuit units, each of which may at least include a pixel drive circuit composed of a plurality of transistors and a storage capacitor. The light emitting structure layer 103 may include a plurality of light emitting units, each light emitting unit may at least include a light emitting device, and the light emitting device may at least include an anode, an organic emitting layer, and a cathode. The anode is connected to the pixel drive circuit. The organic emitting layer is connected to the anode and cathode respectively. The organic emitting layer emits light of a corresponding color under drive of the anode and the cathode. The encapsulation structure layer 104 may include a first encapsulation layer, a second encapsulation layer, and a third encapsulation layer that are stacked. The first encapsulation layer and the third encapsulation layer may be made of an inorganic material, the second encapsulation layer may be made of an organic material, and the second encapsulation layer is arranged between the first encapsulation layer and the third encapsulation layer to form a stacked structure of inorganic material/organic material/inorganic material and ensure that external moisture cannot enter the light emitting structure layer 103.

FIG. 5 is an equivalent circuit diagram of a pixel drive circuit. In an exemplary implementation mode, the pixel drive circuit may have a structure of 3T1C, 4T1C, 5T1C, 5T2C, 6T1C, 7T1C, or 8T1C. As shown in FIG. 5, the pixel drive circuit may include eight transistors (a first transistor T1 to an eighth transistor T8) and one storage capacitor C, and the pixel drive circuit is connected to 10 signal lines (a first scan signal line S1, a second scan signal line S2, a third scan signal line S3, a fourth scan signal line S4, a light emitting signal line EM, a first initial signal line INIT1, a second initial signal line INIT2, a third initial signal line INIT3, a data signal line DATA and a high-potential power supply line VDD) respectively.

In an exemplary implementation mode, the pixel drive circuit may include a first node N1, a second node N2, a third node N3, and a fourth node N4. The first node N1 is connected to a first electrode of the second transistor T2, a gate electrode of the third transistor T3 and a first end of the storage capacitor C respectively. The second node N2 is connected to a first electrode of the third transistor T3, a second electrode of the fourth transistor T4, a second electrode of the fifth transistor T5 and a second electrode of the eighth transistor T8 respectively. The third node N3 is connected to a second electrode of the first transistor T1, a second electrode of the second transistor T2, a second electrode of the third transistor T3 and a first electrode of the sixth transistor T6. The fourth node N4 is connected to a second electrode of the sixth transistor T6 and a second electrode of the seventh transistor T7 respectively, and the fourth node N4 is further connected to an anode of the light emitting device EL.

In an exemplary implementation mode, the first end of the storage capacitor C is connected to the first node N1, and a second end of the storage capacitor C is connected to the high-potential power supply line VDD.

In an exemplary implementation mode, the first transistor T1 may be referred to as a first initialization transistor, a gate electrode of the first transistor T1 is connected to the third scan signal line S3, a first electrode of the first transistor T1 is connected to the first initial signal line INIT1, and a second electrode of the first transistor T1 is connected to the third node N3. The second transistor T2 may be referred to as a compensation transistor, a gate electrode of the second transistor T2 is connected to the fourth scan signal line S4, a first electrode of the second transistor T2 is connected to the first node N1, and a second electrode of the second transistor T2 is connected to the third node N3. The third transistor T3 may be referred to as a drive transistor, a gate electrode of the third transistor T3 is connected to the first node N1, i.e., a gate electrode of the third transistor T3 is connected to a first end of the storage capacitor C, a first electrode of the third transistor T3 is connected to the second node N2, and a second electrode of the third transistor T3 is connected to the third node N3. The fourth transistor T4 may be referred to as a data writing transistor, a gate electrode of the fourth transistor T4 is connected to the first scan signal line S1, a first electrode of the fourth transistor T4 is connected to the data signal line DATA, and a second electrode of the fourth transistor T4 is connected to the second node N2. The fifth transistor T5 may be referred to as a first light emitting control transistor, a gate electrode of the fifth transistor T5 is connected to the light emitting signal line EM, a first electrode of the fifth transistor T5 is connected to the high-potential power supply line VDD, and a second electrode of the fifth transistor T5 is connected to the second node N2. The sixth transistor T6 may be referred to as a second light emitting control transistor, a gate electrode of the sixth transistor T6 is connected to the light emitting signal line EM, a first electrode of the sixth transistor T6 is connected to the third node N3, and a second electrode of the sixth transistor T6 is connected to the fourth node N4. The seventh transistor T7 may be referred to as a second initialization transistor, a gate electrode of the seventh transistor T7 is connected to the second scan signal line S2, a first electrode of the seventh transistor T7 is connected to the second initial signal line INIT2, and a second electrode of the seventh transistor T7 is connected to the fourth node N4. The eighth transistor T8 may be referred to as a third initialization transistor, a gate electrode of the eighth transistor T8 is connected to the second scan signal line S2, a first electrode of the eighth transistor T8 is connected to the third initial signal line INIT3, and a second electrode of the eighth transistor T8 is connected to the second node N2.

In an exemplary implementation mode, the light emitting device EL may be an OLED including an anode (first electrode), an organic emitting layer, and a cathode (second electrode) that are stacked, or may be a QLED including an anode (first electrode), a quantum dot emitting layer, and a cathode (second electrode) that are stacked.

In an exemplary implementation mode, a first electrode of a light emitting device EL is connected to the fourth node N4, and a second electrode of the light emitting device EL is connected to a low-potential power supply line VSS.

In an exemplary implementation mode, a signal of the high-potential power supply line VDD is a high-level signal continuously provided, and a signal of the low-potential power supply line VSS is a low-level signal continuously provided.

In an exemplary implementation mode, the first transistor T1 to the eighth transistor T8 may be P-type transistors or N-type transistors. Use of a same type of transistors in a pixel drive circuit may simplify a process flow, reduce a process difficulty of a display panel, and improve a product yield. In some possible implementation modes, the first transistor T1 to the eighth transistor T8 may include P-type transistors and N-type transistors.

In an exemplary implementation mode, the first transistor T1 to the eighth transistor T8 may be a low temperature poly-silicon transistor, or may be an oxide transistor, or may be both of the low temperature poly-silicon transistor and the metal oxide transistor. Low Temperature Poly-Silicon (LTPS for short) is used for an active layer of a low temperature polysilicon transistor and a metal oxide semiconductor (Oxide) is used for an active layer of a metal oxide transistor. The low temperature polysilicon transistor has advantages such as a high migration rate and fast charging, and the oxide transistor has advantages such as a low drain current. The low temperature polysilicon transistor and the metal oxide transistor are integrated on one display substrate to form a Low Temperature Polycrystalline Oxide (LTPO for short) display substrate, such that advantages of the low temperature polysilicon transistor and the metal oxide transistor may be utilized, low-frequency drive may be achieved, power consumption may be reduced, and display quality may be improved.

In an exemplary implementation mode, the second transistor T2 may be an N-type transistor of metal oxide, and the first transistor T1, the third transistor T3 to the eighth transistor T8 may be P-type transistors of low temperature poly silicon.

In an exemplary implementation mode, a working process of the pixel drive circuit shown in FIG. 5 may include the first stage to the fourth stage.

A first stage is referred to as a reset stage of a second node N2 and a fourth node N4. In this stage, a signal of the second scan signal line S2 is a low-level signal, and signals of the first scan signal line S1, the third scan signal line S3, the fourth scan signal line S4 and the light emitting signal line EM are high-level signals.

The signal of the second scan signal line S2 is the low-level signal, so that the seventh transistor T7 and the eighth transistor T8 are turned on, a signal of the second initial signal line INIT2 is provided to the fourth node N4, to initialize (reset) the first electrode of the light emitting device EL, and clear original charges in the first electrode of the light emitting device EL, so that a potential of the fourth node N4 is Vinit2. A signal of the third initial signal line INIT3 is provided to the second node N2, to initialize (reset) the second node N2, and clear original charges in the second node N2, so that a potential of the second node N2 is Vinit3. In this stage, the third transistor T3 is turned on. A signal of the fourth scan signal line S4 is a high-level signal, and the second transistor T2 is turned on. A signal of the second node N2 is provided to the first node N1 and the third node N3, the first node N1 and the third node N3 are initialized, signals of the first scan signal line S1, the third scan signal line S3 and the light emitting signal line EM are high-level signals, and the first transistor T1, the fourth transistor T4, the fifth transistor T5 and the sixth transistor T6 are turned off.

A second stage is referred to as a reset stage for the first node N1. In this stage, a signal of the third scan signal line S3 is a low-level signal, and signals of the first scan signal line S1, the second scan signal line S2, the fourth scan signal line S4 and the light emitting signal line EM are high-level signals.

The signal of the third scan signal line S3 is changed to a low-level signal, so that the first transistor T1 is turned on. Because the signal of the fourth scan signal line S4 is a high-level signal in this stage and the second transistor T2 is turned on, a signal of the first initial signal line INIT1 is provided to the first node N1 through the third node N3, to reset the first node N1 again, and a potential of the first node N1 is Vinit1. Signals of the first scan signal line S1, the second scan signal line S2 and the light emitting signal line EM are high-level signals, and the fourth transistor T4, the fifth transistor T5, the sixth transistor T6, the seventh transistor T7 and the eighth transistor T8 are turned off.

The third stage is referred to as a data writing stage or a threshold compensation stage. In this stage, a signal of the first scan signal line S1 is a low-level signal, and signals of the second scan signal line S2, the third scan signal line S3, the fourth scan signal line S4 and the light emitting signal line EM are high-level signals.

The signal of the first scan signal line S1 is a low-level signal to turn on the fourth transistor T4. Because the third transistor T3 is continuously turned on in this stage and the signal of the fourth scan signal line S4 is a high-level signal to turn on the second transistor T2, a data voltage output by the data signal line DATA is provided to the first node N1 through the turned-on fourth transistor T4, the second node N2, the turned-on third transistor T3, the third node N3 and the turned-on second transistor T2, and the capacitor C is charged with a difference between the data voltage output by the data signal line DATA and a threshold voltage of the third transistor T3. A voltage of the first node N1 is Vd-|Vth|, Vd is the data voltage output by the data signal line, Vth is the threshold voltage of the third transistor T3, signals of the second scan signal line S2, the third scan signal line S3 and the light emitting signal line EM are high-level signals, and the first transistor T1, the fifth transistor T5, the sixth transistor T6, the seventh transistor T7 and the eighth transistor T8 are turned off.

A fourth stage is referred to as continuous compensation stage. Signals of the first scan signal line S1, the second scan signal line S2, the third scan signal line S3, the fourth scan signal line S4 and the light emitting signal line EM are high-level signals.

The signal of the fourth scan signal line S4 is a high-level signal, the second transistor T2 is continuously turned on, signals of the first scan signal line S1, the third scan signal line S3, the second scan signal line S2 and the light emitting signal line EM are high-level signals, and the first transistor T1, the fourth transistor T4, the fifth transistor T5, the sixth transistor T6, the seventh transistor T7 and the eighth transistor T8 are turned off. Although the signal of the data signal line DATA is stopped being written, a signal of the second node N2 is provided to the first node N1 through the turned-on third transistor T3, the third node N3, and the turned-on second transistor T2, to continuously compensate the threshold voltage of the third transistor T3 .

A fifth stage is referred to as a reset stage for the second node N2 and the fourth node N4. Signals of the second scan signal line S2 and the fourth scan signal line S4 are low-level signals, and the signals of the first scan signal line S1, the third scan signal line S3 and the light emitting signal line EM are high-level signals.

The signals of the first scan signal line S1, the third scan signal line S3, and the light emitting signal line EM are high-level signals, the signal of the fourth scan signal line S4 is a low-level signal, and the first transistor T1, the second transistor T2, the fourth transistor T4, the fifth transistor T5, and the sixth transistor T6 are all turned off. The signal of the second scan signal line S2 is a low-level signal, the seventh transistor T7 and the eighth transistor T8 are turned on, because the third transistor T3 is continuously turned on in this stage, the signal of the third initial signal line INIT3 is written into the second node N2 and the third node N3, and the signal of the second initial signal line INIT2 is written into the fourth node N3, to reset the second node N2, the third node N3 and the fourth node N4 respectively. Potentials of the second node N2 and the third node N3 are Vinit3, and a potential of the fourth node N4 is Vinit2. The reset of the second node N2 and the third node N3 and the fourth node N4 can eliminate or alleviate a hysteresis deviation caused by difference in grayscale between adjacent pixels, reduce the hysteresis deviation, and can further periodically reset the anode of the OLED to improve low-frequency flickering.

A sixth stage is referred to as a light emitting stage. In this stage, signals of the light emitting signal line EM and the fourth scan signal line S4 are low-level signals, and signals of the first scan signal line S1, the second scan signal line S2 and the third scan signal line S3 are high-level signals. A signal of the light emitting signal line E is a low-level signal, so that the fifth transistor T5 and the sixth transistor T6 are turned on, and a power supply voltage output from the high-potential power supply line VDD provides a drive voltage to the first electrode of the light emitting device EL through the fifth transistor T5, the third transistor T3 and the sixth transistor T6 which are turned on, to drive the light emitting device EL to emit light.

In a drive process of the pixel drive circuit, a drive current flowing through the third transistor T3 (drive transistor) is determined by a voltage difference between a gate electrode and a first electrode of the third transistor T3. Since a voltage of the first node N1 is Vdata-|Vth|, the drive current of the third transistor T3 is as follows:

$$I = K*(Vgs-Vth)^2 = K*[(Vdd-Vd+|Vth|)-Vth]^2 = K*[(Vdd-Vd]^2$$

Herein, I is the drive current flowing through the third transistor T3, i.e., a drive current for driving the light emitting device EL, K is a constant, Vgs is the voltage difference between the gate electrode and the first electrode of the third transistor T3, Vth is the threshold voltage of the third transistor T3, Vd is the data voltage output by the data signal line D, and Vdd is the power voltage output by the high-potential power supply line VDD.

It may be seen from a derivation result of the above current formula that in the light emitting stage, the drive current of the third transistor T3 is not affected by the threshold voltage of the third transistor T3. Therefore, an influence of the threshold voltage of the third transistor T3 on the drive current is eliminated, which may ensure uniformity of display brightness of a display product, and improve an overall display effect of the display product.

A display substrate is provided in an exemplary embodiment of the present disclosure. In an exemplary implementation mode, on a plane perpendicular to the display substrate, the display substrate may at least include a drive structure layer disposed on a base substrate and a light emitting structure layer disposed at a side of the drive structure layer away from the base substrate. On a plane parallel to the display substrate, the drive structure layer may include a plurality of circuit units constituting a plurality of unit rows and a plurality of unit columns, and at least one of the circuit units may include a pixel drive circuit configured to output a corresponding current to a light emitting device connected to the pixel drive circuit. The light emitting structure layer may include a plurality of light emitting units, and at least one of the light emitting units may include a light emitting device connected to a pixel drive circuit of a corresponding circuit unit. The light emitting device is configured to emit light with corresponding brightness in response to a current output by a pixel drive circuit connected to the light emitting device.

In an exemplary implementation mode, circuit units mentioned in the present disclosure refer to regions divided according to pixel drive circuits, and light emitting units mentioned in the present disclosure refer to regions divided according to light emitting devices. **In** an exemplary implementation mode, a position and a shape of an orthographic projection of a light emitting unit on the base substrate may correspond to a position and a shape of an orthographic projection of a circuit unit on the base substrate, or a position and a shape of an orthographic projection of a light emitting unit on the base substrate may not correspond to a position and a shape of an orthographic projection of a circuit unit on the base substrate.

In an exemplary implementation mode, a display substrate provided by an exemplary embodiment of the present disclosure includes a display area and a bonding area disposed on at least a side of the display area. The display area includes a drive structure layer disposed on a base substrate and a light emitting structure layer disposed on a side of the drive structure layer away from the base substrate. The drive structure layer includes a plurality of circuit units forming a plurality of unit rows and a plurality of unit columns. The circuit units at least include a pixel drive circuit, the light emitting structure layer includes a plurality of light emitting units, and the light emitting units at least include a light emitting device. The plurality of circuit units at least include a first circuit unit provided with a first pixel drive circuit, a second circuit unit provided with a second pixel drive circuit, and a third circuit unit provided with a third pixel drive circuit. The plurality of light emitting units at least include a first light emitting unit provided with a first light emitting device, a second light emitting unit provided with a second light emitting device, and a third light emitting unit provided with a third light emitting device. The first light emitting device, the second light emitting device, and the third light emitting device emit light of different colors. The first light emitting device is connected to the first pixel drive circuit, the second light emitting device is connected to the second pixel drive circuit, and the third light emitting device is connected to the third pixel drive circuit. The drive structure layer further includes at least one connection line extending at least partially along a first direction, and a first power supply line, a second power supply line, and a third power supply line extending at least partially along a second direction. The first direction intersects with the second direction, the first power supply line, the second power supply line, and the third power supply line have different potentials, and are all high-potential power supply lines. The first power supply line is connected to the first pixel drive circuit, the second power supply line is connected to the second pixel drive circuit, and the third power supply line is connected to the third pixel drive circuit. The at least one connection line is connected to the first power supply line, the second power supply line, or the third power supply line to form a grid communication structure for transmitting a power supply signal on the display substrate.

In an exemplary implementation mode, the first power supply line and the third power supply line are disposed in a same unit column, or the first power supply line and the third power supply line are disposed in different unit columns.

In an exemplary implementation mode, the at least one connection line includes any one or more of a first connection line, a second connection line, and a third connection line. The first connection line is connected to the first power supply line to form a grid communication structure for transmitting a first power supply signal on the display substrate. The second connection line is connected to the second power supply line to form a grid communication structure for transmitting a second power supply signal on the display substrate. The third connection line is connected to the third power supply line to form a grid communication structure for transmitting a third power supply signal on the display substrate.

In an exemplary implementation mode, the plurality of circuit units further includes a fourth circuit unit provided with a fourth pixel drive circuit, and the plurality of light emitting units further includes a fourth light emitting unit provided with a fourth light emitting device. The fourth light emitting unit and the second light emitting device emit light of a same color, and the drive structure layer further includes a fourth power supply line and a fourth connection line. The fourth power supply line is connected to the fourth pixel drive circuit, and the fourth connection line is connected to the fourth power supply line to form a grid communication structure for transmitting a fourth power supply signal on the display substrate.

In an exemplary implementation mode, the second connection line is also connected to the fourth power supply line, and the fourth connection line is also connected to the second power supply line.

In an exemplary implementation mode, the first power supply line and the third power supply line are disposed in different unit columns, the drive structure layer further includes an anode transfer line, the first pixel drive circuit is connected to the first light emitting device through the anode transfer line, and/or the third pixel drive circuit is connected to the third light emitting device through the anode transfer line.

In an exemplary implementation mode, in a direction perpendicular to the base substrate, the drive structure layer includes a plurality of conductive layers, and the anode transfer line is disposed in any one conductive layer or the plurality of conductive layers.

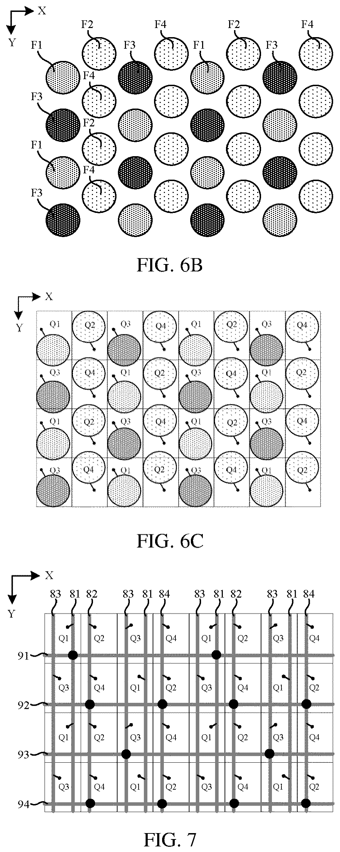

FIG. 6A is a schematic diagram of an arrangement of circuit units according to an exemplary embodiment of the present disclosure, FIG. 6B is a schematic diagram of an arrangement of light emitting units according to an exemplary embodiment of the present disclosure, and FIG. 6C is a schematic diagram of connection between a circuit unit and a light emitting unit according to an exemplary embodiment of the present disclosure. As shown in FIGs. 6A, 6B, and 6C, on a plane parallel to the display substrate, a drive structure layer may include a plurality of circuit units. The plurality of circuit units may constitute a plurality of unit rows and a plurality of unit columns. A unit row may include a plurality of circuit units sequentially disposed in a first direction X, a unit column may include a plurality of circuit units sequentially disposed in a second direction Y, and a circuit unit may include at least a pixel drive circuit. A light emitting structure layer may include a plurality of light emitting units, and the plurality of light emitting units may constitute a plurality of light emitting rows and a plurality of light emitting columns. A light emitting row may include a plurality of light emitting units sequentially disposed in the first direction X, a light emitting column may include a plurality of light emitting units sequentially disposed in the second direction Y, and a light emitting unit may include at least a light emitting device. In an exemplary implementation mode, the first direction X intersects with the second direction Y. In an exemplary implementation mode, a direction of the unit row may be the first direction X and a direction of the unit column may be the second direction Y.

In an exemplary implementation mode, the plurality of circuit units may include a first circuit unit Q1, a second circuit unit Q2, and a third circuit unit Q3, and a fourth circuit unit Q4. In a unit row, the first circuit unit Q1, the second circuit unit Q2, the third circuit unit Q3, and the fourth circuit unit Q4 may be periodically arranged in the first direction X, and corresponding circuit units of an odd-numbered unit row and an even-numbered unit row are staggered. In one unit column, the first circuit unit Q1 and the third circuit unit Q3 are alternately disposed in the second direction Y, and in another unit column, the second circuit unit Q2 and the fourth circuit unit Q4 are alternately disposed in the second direction Y.

In an exemplary implementation mode, the plurality of light emitting units may include a first light emitting unit F1, a second light emitting unit F2, a third light emitting unit F3, and a fourth light emitting unit F4. In a light emitting row, the first light emitting unit F1, the second light emitting unit F2, the third light emitting unit F3, and the fourth light emitting unit F4 may be periodically arranged in the first direction X, and corresponding light emitting units of odd-numbered light emitting rows and even-numbered-numbered light emitting rows are staggered. In one light emitting column, the first light emitting unit F1 and the third light emitting unit F3 are alternately disposed in the second direction Y, and in another light emitting column, the second light emitting unit F2 and the fourth light emitting unit F4 are alternately disposed in the second direction Y.

In an exemplary implementation mode, the first circuit unit Q1 may include a first pixel drive circuit, the second circuit unit Q2 may include a second pixel drive circuit, the third circuit unit Q3 may include a third pixel drive circuit, and the fourth circuit unit Q4 may include a fourth pixel drive circuit. The first light emitting unit F1 may include a first light emitting device that emits light of a first color, the second light emitting unit F2 may include a second light emitting device that emits light of a second color, the third light emitting unit F3 may include a third light emitting device that emits light of a third color, and the fourth light emitting unit F4 may include a fourth light emitting device that emits light of a fourth color.

In an exemplary implementation mode, the light of the first color may be red light, the light of the second color may be green light, the light of the third color may be blue light, and the light of the fourth color may be green light.

In an exemplary implementation mode, the first light emitting device of the first light emitting unit F1 is connected to the first pixel drive circuit of the first circuit unit Q1, and a position of an orthographic projection of the first light emitting device on the base substrate corresponds to a position of an orthographic projection of the first pixel drive circuit on the base substrate. The second light emitting device of the second light emitting unit F2 is connected to the second pixel drive circuit of the second circuit unit Q2, and a position of an orthographic projection of the second light emitting device on the base substrate corresponds to a position of an orthographic projection of the second pixel drive circuit on the base substrate. The third light emitting device of the third light emitting unit F3 is connected to the third pixel drive circuit of the third circuit unit Q3, and a position of an orthographic projection of the third light emitting device on the base substrate corresponds to a position of an orthographic projection of the third pixel drive circuit on the base substrate. The fourth light emitting device of the fourth light emitting unit F4 is connected to the fourth pixel drive circuit of the fourth circuit unit Q4, and a position of an orthographic projection of the fourth light emitting device on the base substrate corresponds to a position of an orthographic projection of the fourth pixel drive circuit on the base substrate.

In an exemplary implementation mode, a shape of the circuit unit may include any one or more of following: a triangle, a rectangle, a rhombus, a pentagon, and a hexagon, and a shape of a light emitting unit may include any one or more of following: a triangle, a rectangle, a rhombus, a pentagon, and a hexagon.

FIG. 7 is a schematic diagram of connection between power supply lines and connection lines in a display substrate according to an exemplary embodiment of the present disclosure. As shown in FIG. 7, in an exemplary embodiment of the present disclosure, the power supply lines may include a first power supply line 81, a second power supply line 82, a third power supply line 83, and a fourth power supply line 84, and the connection lines may include a first connection line 91, a second connection line 92, a third connection line 93, and a fourth connection line 94.

In an exemplary implementation mode, the first power supply line 81, the second power supply line 82, the third power supply line 83, and the fourth power supply line 84 may each be in a shape of a straight line or a polyline extending at least partially along the second direction Y, or may each be in a shape of a straight line or a polyline with a main body portion extending along the second direction Y. The first connection line 91, the second connection line 92, the third connection line 93, and the fourth connection line 94 may each be in a shape of a straight line or a polyline extending at least partially along the first direction X, or may each be in a shape of a straight line or a polyline with a main body portion extending along the first direction X. In the present disclosure, "A extends along a B direction" refers to that A may include a main portion and a secondary portion connected to the main portion, wherein the main portion is a line, a line segment, or a strip-shaped body, the main portion extends along the B direction, and a length of the main portion extending along the B direction is greater than a length of the secondary portion extending along another direction. In following description, "A extends along a B direction" refers to "a main portion of A extends along the B direction".

In an exemplary implementation mode, the first power supply line 81 and the third power supply line 83 may be disposed together in one unit column including the first circuit unit Q1 and the third circuit unit Q3 to form a unit column with a dual power supply line structure. The second power supply line 82 may be separately disposed in one unit column including the second circuit unit Q2 and the fourth circuit unit Q4, and the fourth power supply line 84 may be separately disposed in one unit column including the second circuit unit Q2 and the fourth circuit unit Q4 to form a unit column with a single power supply line structure.

In an exemplary implementation mode, the first power supply line 81 is respectively connected to first pixel drive circuits of a plurality of first circuit units Q1 in a unit column where the first power supply line 81 is located, and the first power supply line 81 is configured to provide a first power supply signal to the plurality of first pixel drive circuits in the unit column where the first power supply line 81 is located. The second power supply line 82 is respectively connected to second pixel drive circuits of a plurality of second circuit units Q2 in a unit column where the second power supply line 82 is located, and the second power supply line 82 is configured to provide a second power supply signal to the plurality of second pixel drive circuits in the unit column where the second power supply line 82 is located. The third power supply line 83 is respectively connected to third pixel drive circuits of a plurality of third circuit units Q3 in a unit column where the third power supply line 83 is located, and the third power supply line 83 is configured to provide a third power supply signal to the plurality of third pixel drive circuits in the unit column where the third power supply line 83 is located. The fourth power supply line 84 is respectively connected to fourth pixel drive circuits of a plurality of fourth circuit units Q4 in a unit column where the fourth power supply line 84 is located, and the fourth power supply line 84 is configured to provide a fourth power supply signal to the plurality of fourth pixel drive circuits in the unit column where the fourth power supply line 84 is located.

In an exemplary implementation mode, any one or more of the first connection line 91, the second connection line 92, the third connection line 93, and the fourth connection line 94 may be disposed in at least one unit row.

In an exemplary implementation mode, the first connection line 91 may be disposed in one unit row and connected to a plurality of first power supply lines 81 respectively, to achieve mutual connection between the first connection line 91 with a main body portion extending along the first direction X and the first power supply lines 81 with main body portions extending along the second direction Y, so that the first power supply lines 81 and the first connection line 91 constitute a grid communication structure for transmitting the first power supply signal on the display substrate.

In an exemplary implementation mode, the second connection line 92 may be disposed in another unit row and connected to a plurality of second power supply lines 82, respectively, to achieve mutual connection between the second connection line 92 with a main body portion extending along the first direction X and the second power supply lines 82 with main body portions extending along the second direction Y, so that the second power supply lines 82 and the second connection line 92 constitute a grid communication structure for transmitting the second power supply signal on the display substrate.

In an exemplary implementation mode, the third connection line 93 may be disposed in yet another unit row and connected to a plurality of third power supply lines 83 respectively, to achieve mutual connection between the third connection line 93 with a main body portion extending along the first direction X and the third power supply lines 83 with main body portions extending along the second direction Y, so that the third power supply lines 83 and the third connection line 93 constitute a grid communication structure for transmitting the third power supply signal on the display substrate.

In an exemplary implementation mode, the fourth connection line 94 may be disposed in still another unit row and connected to a plurality of fourth power supply lines 84 respectively, to achieve mutual connection between the fourth connection line 94 with a main body portion extending along the first direction X and the fourth power supply lines 84 with main body portions extending along the second direction Y, so that the fourth power supply lines 84 and the fourth connection line 94 constitute a grid communication structure for transmitting the fourth power supply signal on the display substrate.

In an exemplary implementation mode, the first power supply signal, the second power supply signal, the third power supply signal, and the fourth power supply signal may be different, that is, the first power supply line 81, the second power supply line 82, the third power supply line 83, and the fourth power supply line 84 have different potentials.

In another exemplary implementation mode, the first power supply line 81, the second power supply line 82, and the third power supply line 83 have different potentials, and the second power supply line 82 and the fourth power supply line 84 have a same potential.

In an exemplary implementation mode, the second power supply line 82 is also connected to fourth pixel drive circuits of a plurality of fourth circuit units Q4 in a unit column where the second power supply line 82 is located, and the fourth power supply line 84 is also connected to second pixel drive circuits of a plurality of second circuit units Q2 in a unit column where the fourth power supply line 84 is located.

In an exemplary implementation mode, in at least one unit row, the second connection line 92 is simultaneously connected to the plurality of second power supply lines 82 and the plurality of fourth power supply lines 84, and the fourth connection line 94 is simultaneously connected to the plurality of second power supply lines 82 and the plurality of fourth power supply lines 84, so that the second power supply lines 82 and the fourth power supply lines 84 are connected to one another through the second connection line 92 and the fourth connection line 94, and the second power supply lines 82 and the fourth power supply lines 84 have a same potential.

In an exemplary implementation mode, in the direction perpendicular to the base substrate, the drive structure layer may include a plurality of conductive layers, and the first power supply lines 81, the second power supply lines 82, the third power supply lines 83, and the fourth power supply lines 84 may be disposed in a same conductive layer, or may be disposed in different conductive layers. The first connection line 91, the second connection line 92, the third connection line 93, and the fourth connection line 94 may be disposed in a same conductive layer, or may be disposed in different conductive layers.

In an exemplary implementation mode, a first power supply line 81 and the first connection line 91 may be disposed in different conductive layers, and the first connection line 91 may be connected to the first power supply line 81 through a via. A second power supply line 82 and the second connection line 92 may be disposed in different conductive layers, and the second connection line 92 may be connected to the second power supply line 82 through a via. A third power supply line 83 and the third connection line 93 may be disposed in different conductive layers, and the third connection line 93 may be connected to the third power supply line 83 through a via. A fourth power supply line 84 and the fourth connection line 94 may be disposed in different conductive layers, and the fourth connection line 94 may be connected to the fourth power supply line 84 through a via.

In an exemplary implementation mode, the plurality of conductive layers in the drive structure layer may at least include a first source-drain metal layer, a second source-drain metal layer, and a third source-drain metal layer disposed sequentially along a direction away from the base substrate. The first power supply lines 81, the second power supply lines 82, the third power supply lines 83, and the fourth power supply lines 84 may be disposed in the second source-drain metal layer, and the first connection line 91, the second connection line 92, the third connection line 93, and the fourth connection line 94 may be disposed in the third source-drain metal layer.

Exemplary description is made below through a manufacturing process of a display substrate. A "patterning process" mentioned in the present disclosure includes treatments such as deposition of a film layer, photoresist coating on a film layer, mask exposure, development, etching, and photoresist stripping for a metal material, an inorganic material, or a transparent conductive material, and includes treatments such as organic material coating, mask exposure, and development for an organic material. Deposition may be any one or more of sputtering, evaporation, and chemical vapor deposition, coating may be any one or more of spray coating, spin coating, and inkjet printing, and etching may be any one or more of dry etching and wet etching, the present disclosure is not limited thereto. A "thin film" refers to a layer of thin film made of a certain material on a base substrate using deposition, coating, or other processes. If the "thin film" does not need to be processed through a patterning process in the entire manufacturing process, the "thin film" may also be called a "layer". If the "thin film" needs to be processed through the patterning process in the entire manufacturing process, the "thin film" is called a "thin film" before the patterning process is performed and is called a "layer" after the patterning process is performed. At least one "pattern" is contained in the "layer" which has been processed through the patterning process. "A and B are provided in a same layer" in the present disclosure means that A and B are formed simultaneously through a same patterning process, and a "thickness" of a film layer is a dimension of the film layer in a direction perpendicular to a display substrate. In an exemplary implementation of the present disclosure, "an orthographic projection of B is within a range of an orthographic projection of A" or "an orthographic projection of A contains an orthographic projection of B" refers to that a boundary of the orthographic projection of B falls within a range of a boundary of the orthographic projection of A, or the boundary of the orthographic projection of A coincides with the boundary of the orthographic projection of B.

In an exemplary implementation mode, taking thirty-two circuit units (four unit rows and eight unit columns) as an example, a preparation process of the display substrate according to the present embodiment may include following operations. In an M-th unit row and an (M+2)-th unit row, circuit units of an N-th unit column to an (N+3)-th unit column and an (N+4) unit column to an (N+7)-th unit column are the first circuit unit, the second circuit unit, the third circuit unit, and the fourth circuit unit respectively. In an (M+1)-th unit row and an (M+3)-th unit row, circuit units of the N-th unit column to the (N+3)-th unit column, and the (N+4)-th unit column to the (N+7)-th unit column are the third circuit unit, the fourth circuit unit, the first circuit unit, and the second circuit unit respectively.

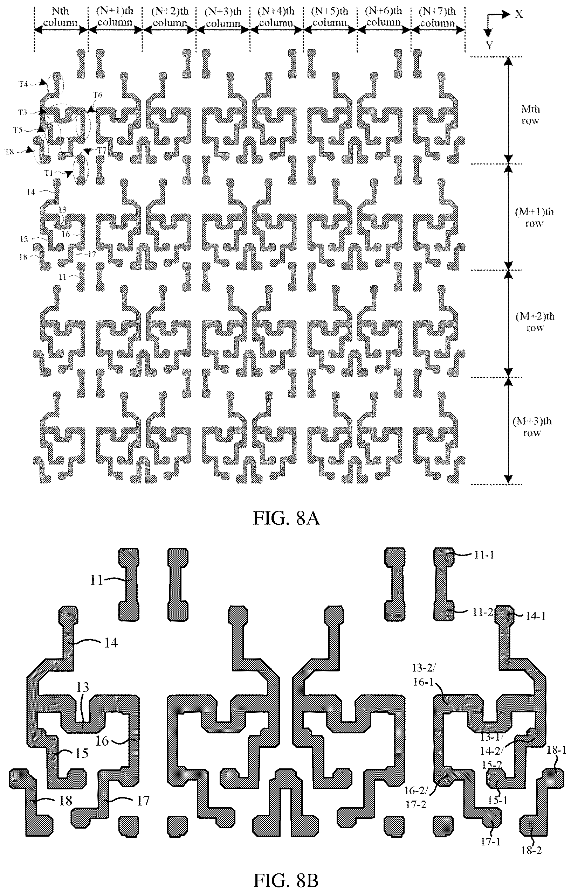

(1) Forming a pattern of a first semiconductor layer. In an exemplary implementation mode, forming the pattern of the first semiconductor layer may include: depositing sequentially a first insulation thin film and a first semiconductor thin film on a base substrate, patterning the first semiconductor thin film through a patterning process to form a first insulation layer disposed on the base substrate, and the pattern of the first semiconductor layer disposed on the first insulation layer, as shown in FIGs. 8A and 8B, and FIG. 8B is a schematic diagram of a structure of four circuit units in FIG. 8A.

In an exemplary implementation mode, the pattern of the first semiconductor layer of each circuit unit may at least include a first active layer 11 of the first transistor T1, a third active layer 13 of the third transistor T3 to an eighth active layer 18 of the eighth transistor T8, and the third active layer 13 to the seventh active layer 17 are of an interconnected integral structure, and the first active layer 11 and the eighth active layer 18 are separately disposed.

In an exemplary implementation mode, in the second direction Y, the first active layer 11 and the fourth active layer 14 may be located on a side of the third active layer 13 in the present circuit unit in an opposite direction of the second direction Y, and the fifth active layer 15, the sixth active layer 16, the seventh active layer 17 and the eighth active layer 18 may be located on a side of the third active layer 13 in the present circuit unit in the second direction Y.

In an exemplary implementation mode, the third active layer 13 may be in a shape of an inverted "Ω", the first active layer 11, the fourth active layer 14, and the sixth active layer 16 may be in a shape of an "I", and the fifth active layer 15, the seventh active layer 17 and the eighth active layer 18 may be in a shape of an "L".

In an exemplary implementation mode, the first active layer 11, the third active layer 13 to the eighth active layer 18 may each include a first region, a second region, and a channel region located between the first region and the second region.

In an exemplary implementation mode, a first region 13-1 of the third active layer, a second region 14-2 of the fourth active layer and a second region 15-2 of the fifth active layer may be connected to each other, a second region 13-2 of the third active layer and a first region 16-1 of the sixth active layer may be connected to each other, and a second region 16-2 of the sixth active layer and a second region 17-2 of the seventh active layer may be connected to each other, i.e., the first region 13-1 of the third active layer may simultaneously serve as the second region 14-2 of the fourth active layer and the second region 15-2 of the fifth active layer, the second region 13-2 of the third active layer may serve as the first region 16-1 of the sixth active layer, and the second region 16-2 of the sixth active layer may serve as the second region 17-2 of the seventh active layer.

In an exemplary implementation mode, a first region 11-1 of the first active layer, a second region 11-2 of the first active layer, a first region 14-1 of the fourth active layer, a first region 15-1 of the fifth active layer, a first region 17-1 of the seventh active layer, a first region 18-1 of the eighth active layer, and a second region 18-2 of the eighth active layer may be separately disposed.

In an exemplary implementation mode, in one unit row, first regions 18-1 of eighth active layers in some two adjacent circuit units may be connected to each other, and the eighth active layers 18 in the two adjacent circuit units may be of an interconnected integral structure. For example, an eighth active layer 18 of the (N+1)-th unit column and an eighth active layer 18 of the (N+2)-th unit column may be of an interconnected integral structure. For another example, an eighth active layer 18 of the (N+3)-th unit column and an eighth active layer 18 of the (N+4)-th unit column may be of an interconnected integral structure. For another example, an eighth active layer 18 of the (N+5)-th unit column and an eighth active layer 18 of the (N+6)-th unit column may be of an interconnected integral structure. Since the first region 18-1 of the eighth active layer in each circuit unit is configured to be connected to the third initial signal line to be formed subsequently, by forming eighth active layers of adjacent circuit units into an interconnected integral structure, not only a quantity of signal lines and a quantity of corresponding vias may be reduced, an area occupied by the pixel drive circuit can be reduced, which is beneficial to improving the resolution, but also first electrodes of the eighth transistors of adjacent circuit units may be ensured to have a same potential, which is beneficial to improving uniformity of the display substrate, avoiding poor display of the display substrate and ensuring a display effect of the display substrate.

In an exemplary implementation mode, the first active layer 11 may be disposed across two adjacent unit rows, the second region 11-2 of the first active layer may be located within a current circuit unit, and the first region 11-1 of the first active layer may be located within a circuit unit of a previous unit row.

In an exemplary implementation mode, first semiconductor layers of adjacent unit columns may be mirror symmetric with respect to a column dividing line, the column dividing line may be a straight line located between adjacent unit columns and extending along the second direction Y. For example, a first semiconductor layer in the N-th unit column and a first semiconductor layer in the (N+1)-th unit column may be mirror symmetric with respect to a column dividing line. For another example, the first semiconductor layer in the (N+1)-th unit column and a first semiconductor layer in the (N+2)-th unit column may be mirror symmetric with respect to a column dividing line. For another example, the first semiconductor layer in the (N+2)-th unit column and a first semiconductor layer in the (N+3)-th unit column may be mirror symmetric with respect to a column dividing line.

In an exemplary implementation mode, shapes of first semiconductor layers in a plurality of unit rows may be substantially the same.

In an exemplary implementation mode, the first semiconductor layer may be made of poly Silicon (p-Si), i.e. the first transistor T1 and the third transistor T3 to the eighth transistor T8 are LTPS transistors. In an exemplary implementation mode, the patterning the first semiconductor thin film through the patterning process may include: forming an amorphous silicon (a-si) thin film on the first insulation thin film, dehydrogenating the amorphous silicon thin film, and crystallizing the dehydrogenated amorphous silicon thin film to form a polysilicon thin film. Subsequently, the polysilicon thin film is patterned to form the pattern of the first semiconductor layer.

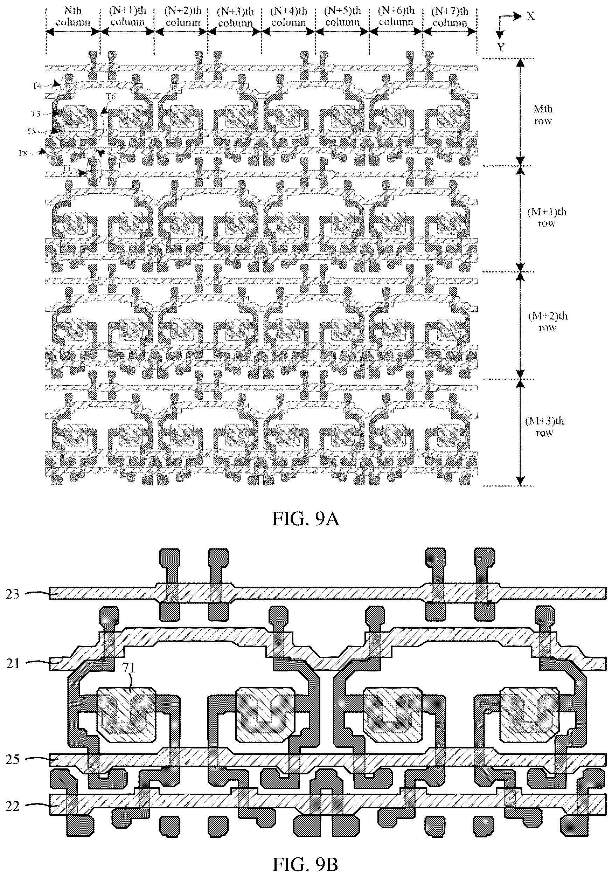

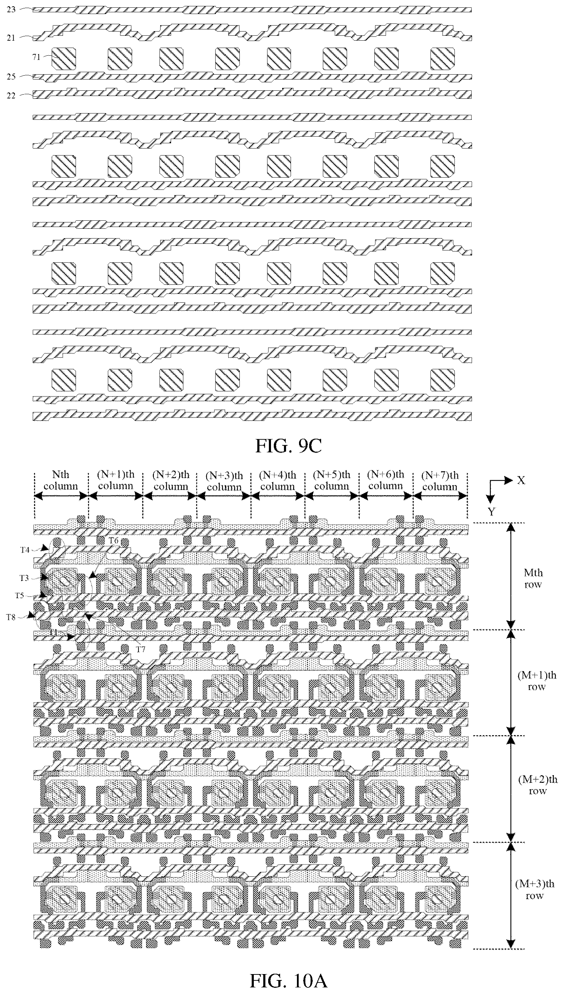

(2) Forming a pattern of a first conductive layer. In an exemplary implementation mode, forming the pattern of the first conductive layer may include: sequentially depositing a second insulation thin film and a first conductive thin film on the base substrate on which the above-mentioned pattern is formed, and patterning the first conductive thin film through a patterning process to form a second insulation layer that covers the pattern of the first semiconductor layer and form the pattern of the first conductive layer disposed on the second insulation layer, as shown in FIGs. 9A, 9B and 9C, wherein FIG. 9B is a schematic diagram of a structure of four circuit units in FIG. 9A, and FIG. 9C is a schematic plan view of the first conductive layer in FIG. 9A. In an exemplary implementation mode, the first conductive layer may be referred to as a first gate metal (GATE1) layer.

In an exemplary implementation mode, the pattern of the first conductive layer of each circuit unit at least includes: a first scan signal line 21, a second scan signal line 22, a third scan signal line 23, a light emitting signal line 25, and a first plate 71 of a storage capacitor.

In an exemplary implementation mode, the first plate 71 may be in a shape of a rectangle, and a chamfer may be provided at a corner of the rectangle. An orthographic projection of the first plate 71 on the base substrate is at least partially overlapped with an orthographic projection of the third active layer of the third transistor T3 on the base substrate. In an exemplary implementation mode, the first plate 71 may simultaneously serve as a lower plate of the storage capacitor and a gate electrode of the third transistor T3.

In an exemplary implementation mode, the first scan signal line 21 may be in a shape of a straight line or a polyline with a main body portion extending along the first direction X, the first scan signal line 21 may be located on a side of the first plate 71 in the opposite direction of the second direction Y, and a region where the first scan signal line 21 is overlapped with the fourth active layer may serve as a gate electrode of the fourth transistor T4.

In an exemplary implementation mode, the second scan signal line 22 may be in a shape of a straight line or a polyline with a main body portion extending along the first direction X, the second scan signal line 22 may be located on a side of the first plate 71 in the second direction Y, a region where the second scan signal line 22 is overlapped with the seventh active layer may serve as a gate electrode of the seventh transistor T7, and a region where the second scan signal line 22 is overlapped with the eighth active layer may serve as a gate electrode of the eighth transistor T8.

In an exemplary implementation mode, the third scan signal line 23 may be in a shape of a straight line or a bending line with a main body portion extending along the first direction X, the third scan signal line 23 may be located at a side of the first scan signal line 21 away from the first plate 71, and a region where the third scan signal line 23 is overlapped with the first active layer may serve as the gate electrode of the first transistor T1.

In an exemplary implementation mode, the light emitting signal line 25 may be in a shape of a straight line or a polyline with a main body portion extending along the first direction X, the light emitting signal line 25 may be located between the first plate 71 and the second scan signal line 22, a region where the light emitting signal line 25 is overlapped with the fifth active layer may serve as a gate electrode of the fifth transistor T5, and a region where the light emitting signal line 25 is overlapped with the sixth active layer may serve as a gate electrode of the sixth transistor T6.

In an exemplary implementation mode, the first scan signal line 21, the second scan signal line 22, the third scan signal line 23, and the light emitting signal line 25 may be designed with unequal widths, and the widths are dimensions in the second direction Y, so that not only a layout of a pixel structure may be facilitated, but also a parasitic capacitance between signal lines may be reduced, which is not limited here in the present disclosure.

In an exemplary implementation mode, the first scan signal line 21, the second scan signal line 22, the third scan signal line 23, and the light emitting signal line 25 may include a region overlapped with the first semiconductor layer and a region not overlapped with the first semiconductor layer, and a width of the signal line in the region overlapped with the first semiconductor layer may be greater than a width of the signal line in the region not overlapped with the first semiconductor layer.

In an exemplary implementation mode, first conductive layers of adjacent unit columns may be mirror symmetric with respect to a column dividing line. For example, a first conductive layer in the N-th unit column and a first conductive layer in the (N+1)-th unit column may be mirror symmetric with respect to a column dividing line. For another example, the first conductive layer in the (N+1)-th unit column and a first conductive layer in the (N+2)-th unit column may be mirror symmetric with respect to a column dividing line. For another example, the first conductive layer in the (N+2)-th unit column and a first conductive layer in the (N+3)-th unit column may be mirror symmetric with respect to a column dividing line.

In an exemplary implementation mode, shapes of first conductive layers in a plurality of unit rows may be substantially the same.

In an exemplary implementation mode, after the pattern of the first conductive layer is formed, a conductive treatment may be performed on the first semiconductor layer by using the first conductive layer as a shield. A region of the first semiconductor layer, which is shielded by the first conductive layer, forms channel regions of the first transistor T1, the third transistor T3 to the eighth transistor T8, and a region of the first semiconductor layer, which is not shielded by the first conductive layer, is made to be conductive, that is, first regions and second regions of the first transistor T1, and the third transistor T3 to the eighth transistor T8 are all made to be conductive.

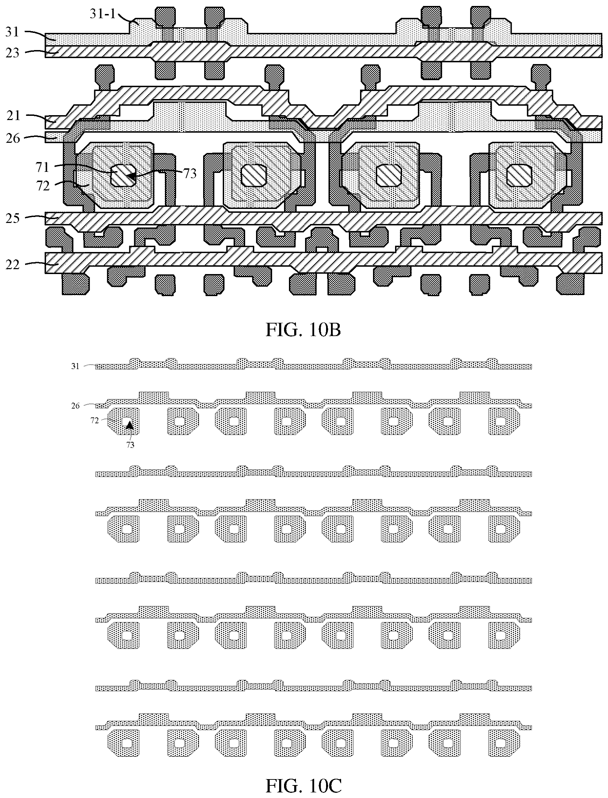

(3) Forming a pattern of a second conductive layer. In an exemplary implementation mode, forming the pattern of the second conductive layer may include: sequentially depositing a third insulation thin film and a second conductive thin film on the base substrate on which the aforementioned patterns are formed, and patterning the second conductive thin film through a patterning process to form a third insulation layer covering the first conductive layer, and the pattern of the second conductive layer disposed on the third insulation layer, as shown in FIGs. 10A, 10B, and 10C, wherein FIG. 10B is an schematic diagram of a structure of four circuit unit in FIG. 10A, and FIG. 10C is a schematic plan view of the second conductive layer in FIG. 10A. In an exemplary implementation mode, the second conductive layer may be referred to as a second gate metal (GATE2) layer.

In an exemplary implementation mode, the pattern of the second conductive layer of each circuit unit at least includes a shield line 26, a first initial signal line 31 and a second plate 72 of the storage capacitor.

In an exemplary implementation mode, the shield line 26 may be in a shape of a straight line or a polyline with a main body portion extending along the first direction X, the shield line 26 may be located between the first scan signal line 21 and the first plate 71, and the shield line 26 is configured as a shielding layer of the second transistor T2 for shielding a channel region of the second transistor T2, ensuring electrical performance of the oxide second transistor T2, and the shield line 26 is also configured to serve as a bottom gate electrode of the second transistor T2.

In an exemplary implementation mode, the first initial signal line 31 may be in a shape of a straight line or a polyline with a main body portion extending along the first direction X, the first initial signal line 31 may be located on a side of the third scan signal line 23 away from the first plate 71, and the first initial signal line 31 is configured to write a first initial signal to the first electrode of the first transistor T1 through connection between a seventh connection electrode to be formed subsequently and the first region of the first active layer.

In an exemplary implementation mode, a first initial connection block 31-1 is provided on the first initial signal line 31 of each circuit unit. A shape of the first initial connection block 31-1 may be a block, and the first initial connection block 31-1 may be provided on a side of the first initial signal line 31 away from the second plate 72, and the first initial connection block 31-1 is configured to be connected to the first region of the first active layer through a seventh connection electrode to be formed subsequently.

In an exemplary implementation mode, the shield line 26 and the first initial signal line may be designed with unequal widths, which can not only facilitate the layout of the pixel structure, but also reduce the parasitic capacitance between the signal lines.

In an exemplary implementation mode, a profile of the second plate 72 may be in a shape of a rectangle, a chamfer may be provided at a corner of the rectangle, an orthographic projection of the second plate 72 on the base substrate is at least overlapped with an orthographic projection of the first plate 71 on the base substrate, the second plate 72 may serve as an upper plate of the storage capacitor, and the first plate 71 and the second plate 72 constitute a storage capacitor of a pixel drive circuit.

In an exemplary implementation mode, the second plate 72 is provided with an opening 73. The opening 73 may have a rectangular shape and may be located in the middle of the second plate 72, so that the second plate 72 forms an annular structure. The opening 73 exposes the third insulation layer covering the first plate 71, and an orthographic projection of the first plate 71 on the base substrate contains an orthographic projection of the opening 73 on the base substrate. In an exemplary implementation mode, the opening 73 is configured to accommodate a thirteenth via to be formed subsequently, and the thirteenth via is located within the opening 73 and exposes the first plate 71, so that a first connection electrode to be formed subsequently is connected to the first plate 71.

In an exemplary implementation mode, second conductive layers of adjacent unit columns may be mirror symmetric with respect to a column dividing line. For example, a second conductive layer in the N-th unit column and a second conductive layer in the (N+1)-th unit column may be mirror symmetric with respect to a column dividing line. For another example, the second conductive layer in the (N+1)-th unit column and a second conductive layer in the (N+2)-th unit column may be mirror symmetric with respect to a column dividing line. For another example, the second conductive layer in the (N+2)-th unit column and a second conductive layer in the (N+3)-th unit column may be mirror symmetric with respect to a column dividing line.

In an exemplary implementation mode, shapes of second conductive layers in a plurality of unit rows may be substantially the same.

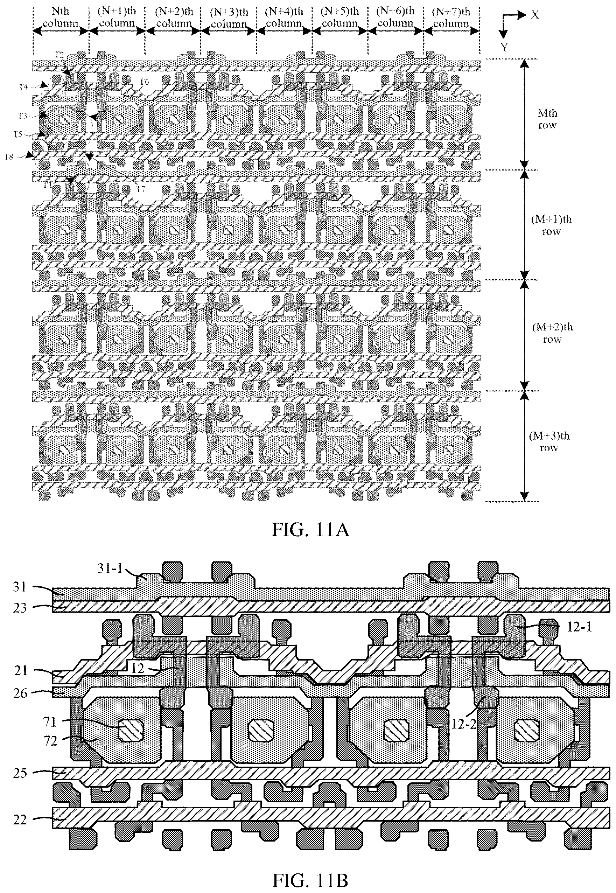

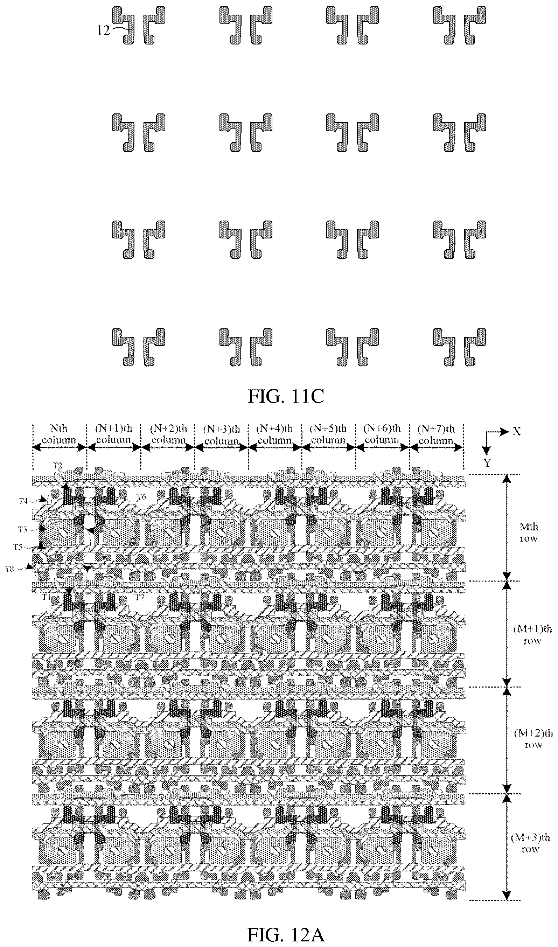

(4) Forming a pattern of a second semiconductor layer. In an exemplary implementation mode, forming the pattern of the second semiconductor layer may include: sequentially depositing a fourth insulation thin film and a second semiconductor thin film on the base substrate on which the aforementioned patterns are formed, patterning the second semiconductor thin film through a patterning process to form a fourth insulation layer covering the base substrate, and the pattern of the second semiconductor layer disposed on the fourth insulation layer, as shown in FIGs. 11A, 11B, and 11C, wherein FIG. 11B is a schematic diagram of a structure of four circuit units in FIG. 11A, and FIG. 11C is a schematic plan view of the second conductive layer in FIG. 11A.

In an exemplary implementation mode, the pattern of the second semiconductor layer of each circuit unit at least includes a second active layer 12 of the second transistor T2.

In an exemplary implementation mode, the second active layer 12 may be in a shape of a polyline, and an orthographic projection of the second active layer 12 on the base substrate is at least partially overlapped with an orthographic projection of the shield line 26 on the base substrate.

In an exemplary implementation mode, the second active layer 12 may include a first region, a second region, and a channel region located between the first region and the second region. A first region 12-1 of the second active layer may be located on a side of the shield line 26 away from the second plate 72, and a second region 12-2 of the second active layer may be located on a side of the shield line 26 close to the second plate 72.

In an exemplary implementation mode, second semiconductor layers of adjacent unit columns may be mirror symmetric with respect to a column dividing line. For example, a second semiconductor layer in the N-th unit column and a second semiconductor layer in the (N+1)-th unit column may be mirror symmetric with respect to a column dividing line. For another example, the second semiconductor layer in the (N+1)-th unit column and a second semiconductor layer in the (N+2)-th unit column may be mirror symmetric with respect to a column dividing line. For another example, the second semiconductor layer in the (N+2)-th unit column and a second semiconductor layer in the (N+3)-th unit column may be mirror symmetric with respect to a column dividing line.

In an exemplary implementation mode, shapes of second semiconductor layers in a plurality of unit rows may be substantially the same.

In an exemplary implementation mode, the second semiconductor layer may be made of an oxide, i.e., the eighth transistor T8 is an oxide transistor. In an exemplary implementation mode, the second semiconductor thin film may be made of Indium Gallium Zinc Oxide (IGZO), wherein electron mobility of the Indium Gallium Zinc Oxide (IGZO) is higher than that of amorphous silicon.

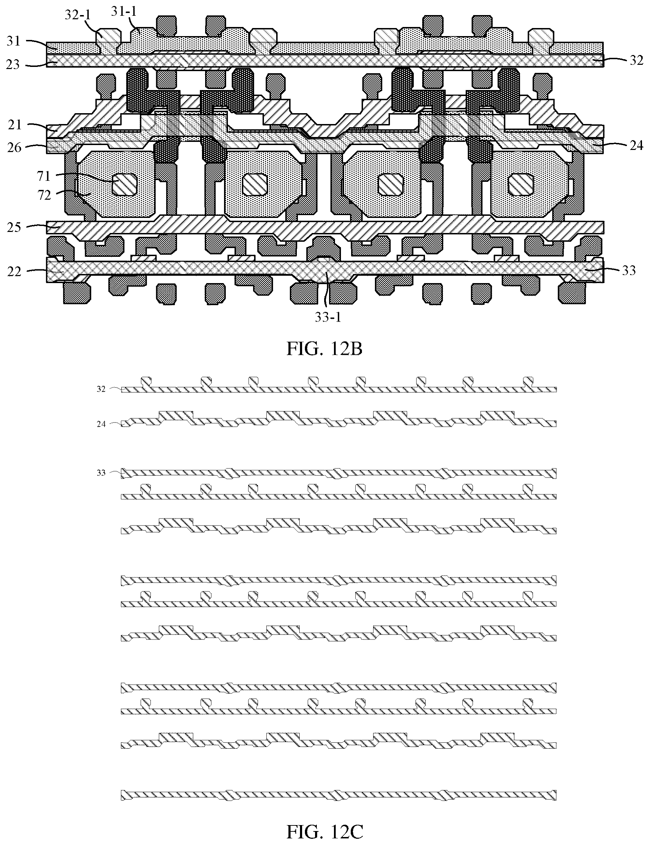

(5) Forming a pattern of a third conductive layer. In an exemplary implementation mode, forming the pattern of the third conductive layer may include: depositing sequentially a fifth insulation thin film and a third conductive thin film on the base substrate on which the aforementioned patterns are formed, patterning the third conductive thin film through a patterning process to form a fifth insulation layer covering the second semiconductor layer and the pattern of the third conductive layer disposed on the fifth insulation layer, as shown in FIGs. 12A, 12B, and 12C, wherein FIG. 12B is a schematic diagram of a structure of four circuit units in FIG. 12A, and FIG. 12C is a schematic plan view of the third conductive layer in FIG. 12A. In an exemplary implementation mode, the second conductive layer may be referred to as a third gate metal (GATE3) layer.

In an exemplary implementation mode, the pattern of the third conductive layer of each circuit unit at least includes a fourth scan signal line 24, a second initial signal line 32 and a third initial signal line 33.

In an exemplary implementation mode, the fourth scan signal line 24 may be in a shape of a straight line or a polyline with a main body portion extending along the first direction X, the fourth scan signal line 24 may be located between the first scan signal line 21 and the second plate 72, an orthographic projection of the fourth scan signal line 24 on the base substrate is at least partially overlapped with an orthographic projection of the shield line 26 on the base substrate, and a region where the fourth scan signal line 24 is overlapped with the second active layer may serve as a gate electrode of the second transistor T2.

In an exemplary implementation mode, the fourth scan signal line 24 and the shield line 26 may be connected to a same signal source so that the shield line 26 may serve as a bottom gate electrode of the second transistor T2, and the fourth scan signal line 24 may serve as a top gate electrode of the second transistor T2 to form the second transistor T2 with a top gate and bottom gate structure.

In an exemplary implementation mode, the second initial signal line 32 may be in a shape of a straight line or a polyline with a main body portion extending along the first direction X, the second initial signal line 32 may be located on a side of the first initial signal line 31 close to the second plate 72, and the second initial signal line 32 is configured to write a second initial signal to a first electrode of the seventh transistor T7 through connection between an eighth connection electrode to be formed subsequently and the first region of the seventh active layer.

In an exemplary implementation mode, a second initial connection block 32-1 is provided on the second initial signal line 32 of each circuit unit, and a shape of the second initial connection block 32-1 may be a block shape, and may be provided on a side of the second initial signal line 32 away from the second plate 72, and the second initial connection block 32-1 is configured to be connected to the first region of the seven active layer through an eighth connection electrode to be formed subsequently.

In the exemplary implementation mode, an orthographic projection of the second initial signal line 32 on the base substrate is at least partially overlapped with an orthographic projection of the third scan signal line 23 on the base substrate, so that the second initial signal line 32 having a constant potential may effectively shield an influence of a scan signal on a pixel drive circuit, and improve drive performance of the pixel drive circuit.

In an exemplary implementation mode, the third initial signal line 33 may be in a shape of a straight line or a polyline with a main body portion extending along the first direction X, the third initial signal line 33 may be located on a side of the light emitting signal line 25 away from the second plate 72, and the third initial signal line 33 is configured to write a third initial signal to a first electrode of the eighth transistor T8 through connection between a ninth connection electrode to be formed subsequently and a first region of the eighth active layer.

In an exemplary implementation mode, a third initial connection block 33-1 is provided on the third initial signal line 33 of each circuit unit, and a shape of the third initial connection block 33-1 may be a block shape, and may be provided on a side of the third initial signal line 33 away from the second plate 72, and the third initial connection block 33-1 is configured to be connected to the first region of the eighth active layer through a ninth connection electrode to be formed subsequently.

In an exemplary implementation mode, since eighth active layers in some adjacent circuit units in a unit row are of an interconnected integral structure, the third initial connection block 33-1 may be located between adjacent circuit units, so that some adjacent circuit units may share a third initial connection block 33-1.

In the exemplary implementation mode, an orthographic projection of the third initial signal line 33 on the base substrate is at least partially overlapped with an orthographic projection of the second scan signal line 22 on the base substrate, so that the third initial signal line 33 having a constant potential may effectively shield an influence of a scan signal on a pixel drive circuit, and improve drive performance of the pixel drive circuit.

In an exemplary implementation mode, third conductive layers of adjacent unit columns may be mirror symmetric with respect to a column dividing line. For example, a third conductive layer in the N-th unit column and a third conductive layer in the (N+1)-th unit column may be mirror symmetric with respect to a column dividing line. For another example, the third conductive layer in the (N+1)-th unit column and a third conductive layer in the (N+2)-th unit column may be mirror symmetric with respect to a column dividing line. For another example, the third conductive layer in the (N+2)-th unit column and a third conductive layer in the (N+3)-th unit column may be mirror symmetric with respect to a column dividing line.

In an exemplary implementation mode, shapes of third conductive layers in a plurality of unit rows may be substantially the same.

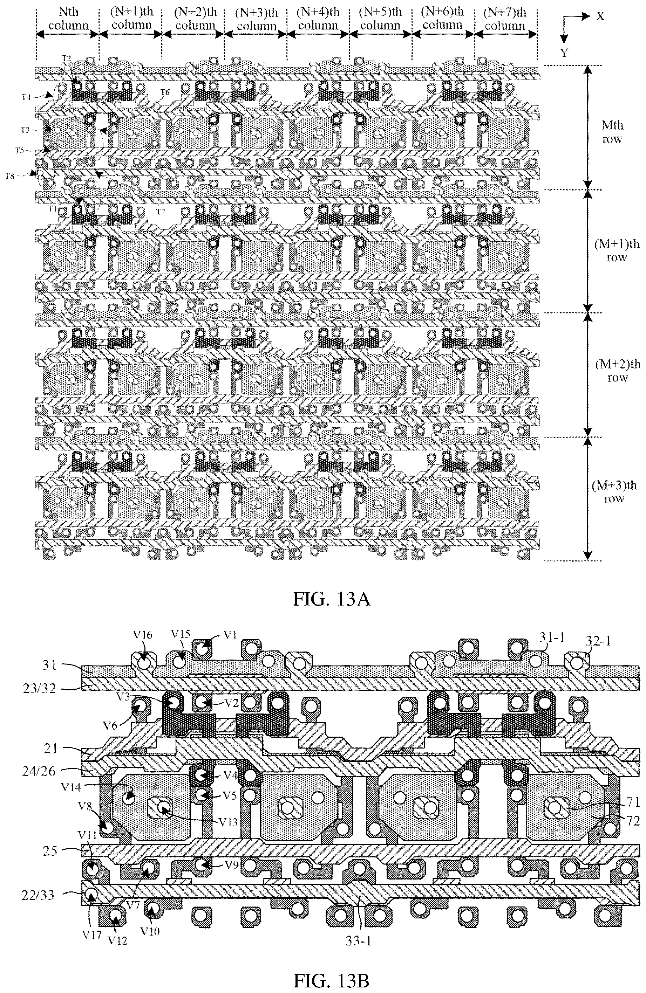

(6) Forming a pattern of a sixth insulation layer. In an exemplary implementation mode, forming the pattern of the sixth insulation layer may include: depositing a sixth insulation thin film on the base substrate on which the aforementioned patterns are formed, and patterning the fifth insulation thin film through a patterning process, to form the sixth insulation layer covering the third conductive layer, wherein a plurality of vias are provided on the sixth insulation layer, as shown in FIGs. 13A and 13B. FIG. 13B is a schematic diagram of a structure of four circuit units in FIG. 13A.

In an exemplary implementation mode, a plurality of vias of each circuit unit at least include a first via V1, a second via V2, a third via V3, a fourth via V4, a fifth via V5, a sixth via V6, a seventh via V7, an eighth via V8, a ninth via V9, a tenth via V10, an eleventh via V11, a twelfth via V12, a thirteenth via V13, a fourteenth via V14, a fifteenth via V15, a sixteenth via V16, and a seventeenth via V17.

In an exemplary implementation mode, an orthographic projection of the first via V1 on the base substrate is within a range of an orthographic projection of the first region of the first active layer on the base substrate, the sixth insulation layer, the fifth insulation layer, the fourth insulation layer, the third insulation layer and the second insulation layer within the first via V1 are etched away to expose a surface of the first region of the first active layer, and the first via V1 is configured such that a seventh connection electrode to be formed subsequently is connected to the first region of the first active layer through the first via V1.

In an exemplary implementation mode, an orthographic projection of the second via V2 on the base substrate is within a range of an orthographic projection of a second region of the first active layer on the base substrate, the sixth insulation layer, the fifth insulation layer, the fourth insulation layer, the third insulation layer and the second insulation layer within the second via V2 are etched away to expose a surface of the second region of the first active layer, and the second via V2 is configured such that a second connection electrode to be formed subsequently is connected to the second region of the first active layer through the second via V2.

In an exemplary implementation mode, an orthographic projection of the third via V3 on the base substrate is within a range of an orthographic projection of a first region of the second active layer on the base substrate, the sixth insulation layer and the fifth insulation layer within the third via V3 are etched away to expose a surface of the first region of the second active layer, and the third via V3 is configured such that a first connection electrode to be formed subsequently is connected to the first region of the second active layer through the third via V3.

In an exemplary implementation mode, an orthographic projection of the fourth via V4 on the base substrate is within a range of an orthographic projection of a second region of the second active layer on the base substrate, the sixth insulation layer and the fifth insulation layer within the fourth via V4 are etched away to expose a surface of the second region of the second active layer, and the fourth via V4 is configured such that a second connection electrode to be formed subsequently is connected to the second region of the second active layer through the fourth via V4.

In an exemplary implementation mode, an orthographic projection of the fifth via V5 on the base substrate is within an orthographic projection of the second region of the third active layer (also a first region of the sixth active layer) on the base substrate, the sixth insulation layer, the fifth insulation layer, the fourth insulation layer, the third insulation layer and the second insulation layer within the fifth via V5 are etched away to expose a surface of the second region of the third active layer (also the first region of the sixth active layer), and the fifth via V5 is configured such that a second connection electrode to be formed subsequently is connected to the second region of the third active layer (also the first region of the sixth active layer) through the fifth via V5.

In an exemplary implementation mode, an orthographic projection of the sixth via V6 on the base substrate is within a range of an orthographic projection of a first region of the fourth active layer on the base substrate, the sixth insulation layer, the fifth insulation layer, the fourth insulation layer, the third insulation layer and the second insulation layer within the sixth via V6 are etched away to expose a surface of the first region of the fourth active layer, and the sixth via V6 is configured such that a third connection electrode to be formed subsequently is connected to the first region of the fourth active layer through the sixth via V6.

In an exemplary implementation mode, an orthographic projection of the seventh via V7 on the base substrate is within a range of an orthographic projection of a first region of the fifth active layer on the base substrate, the sixth insulation layer, the fifth insulation layer, the fourth insulation layer, the third insulation layer and the second insulation layer within the seventh via V7 are etched away to expose a surface of the first region of the fifth active layer, and the seventh via V7 is configured such that a fourth connection electrode to be formed subsequently is connected to the first region of the fifth active layer through the seventh via V7.

In an exemplary implementation mode, an orthographic projection of the eighth via V8 on the base substrate is within a range of an orthographic projection of a first region of the third active layer (also a second region of the fourth active layer and a second region of the fifth active layer) on the base substrate, the sixth insulation layer, fifth insulation layer, fourth insulation layer, third insulation layer and second insulation layer within the eighth via V8 are etched away to expose a surface of the first region of the third active layer (also the second region of the fourth active layer and the second region of the fifth active layer), and the eighth via V8 is configured such that a fifth connection electrode to be formed subsequently is connected to the first region of the third active layer (also the second region of the fourth active layer and the second region of the fifth active layer) through the fifth via V5.

In an exemplary implementation mode, an orthographic projection of the ninth via V9 on the base substrate is within a range of an orthographic projection of the second region of the sixth active layer (also a second region of the seventh active layer) on the base substrate, the sixth insulation layer, the fifth insulation layer, the fourth insulation layer, the third insulation layer and the second insulation layer within the ninth via V9 are etched away to expose a surface of the second region of the sixth active layer (also the second region of the seventh active layer), and the ninth via V9 is configured such that a sixth connection electrode to be formed subsequently is connected to the second region of the sixth active layer (also the second region of the seventh active layer) through the ninth via V9.

In an exemplary implementation mode, an orthographic projection of the tenth via V10 on the base substrate is within a range of an orthographic projection of a first region of the seventh active layer on the base substrate, the sixth insulation layer, the fifth insulation layer, the fourth insulation layer, the third insulation layer and the second insulation layer within the tenth via V10 are etched away to expose a surface of the first region of the seventh active layer, and the tenth via V10 is configured such that an eighth connection electrode to be formed subsequently is connected to the first region of the seventh active layer through the tenth via V10.

In an exemplary implementation mode, an orthographic projection of the eleventh via V11 on the base substrate is within an orthographic projection of the first region of the eighth active layer on the base substrate, the sixth insulation layer, the fifth insulation layer, the fourth insulation layer, the third insulation layer and the second insulation layer within the eleventh via V11 are etched away to expose a surface of the first region of the eighth active layer, and the eleventh via V11 is configured such that a ninth connection electrode to be formed subsequently is connected to the first region of the eighth active layer through the eleventh via V11. In an exemplary implementation mode, since the first regions of the eighth active layers of some adjacent circuit units in a unit row are connected to each other, some adjacent circuit units may share an eleventh via V11.

In an exemplary implementation mode, an orthographic projection of the twelfth via V12 on the base substrate is within a range of an orthographic projection of a second region of the eighth active layer on the base substrate, the sixth insulation layer, the fifth insulation layer, the fourth insulation layer, the third insulation layer and the second insulation layer within the twelfth via V12 are etched away to expose a surface of the second region of the eighth active layer, and the twelfth via V12 is configured such that a fifth connection electrode to be formed subsequently is connected to the second region of the eighth active layer through the twelfth via V12.

In an exemplary implementation mode, an orthographic projection of the thirteenth via V13 on the base substrate is within a range of an orthographic projection of the opening 73 on the base substrate, the sixth insulation layer, the fifth insulation layer, the fourth insulation layer and the third insulation layer in the thirteenth via V13 are etched away to expose a surface of the first plate 71, and the thirteenth via V13 is configured such that a first connection electrode to be to be formed subsequently is connected to the first plate 71 through the thirteenth via V13.

In an exemplary implementation mode, an orthographic projection of the fourteenth via V14 on the base substrate is within a range of an orthographic projection of the second plate 72 on the base substrate, the sixth insulation layer, the fifth insulation layer and the fourth insulation layer in the fourteenth via V14 are etched away to expose a surface of the second plate 72, and the fourteenth via V14 is configured such that a fourth connection electrode to be formed subsequently is connected to the second plate 72 through the fourteenth via V14.

In an exemplary implementation mode, an orthographic projection of the fifteenth via V15 on the base substrate is within a range of an orthographic projection of the first initial connection block 31-1 of the first initial signal line 31 on the base substrate, the sixth insulation layer, the fifth insulation layer and the fourth insulation layer in the fifteenth via V15 are etched away to expose a surface of the first initial connection block 31-1, and the fifteenth via V15 is configured such that a seventh connection electrode to be formed subsequently is connected to the first initial connection block 31-1 through the fifteenth via V15.

In an exemplary implementation mode, an orthographic projection of the sixteenth via V16 on the base substrate is within a range of an orthographic projection of the second initial connection block 32-1 of the second initial signal line 32 on the base substrate, the sixth insulation layer in the sixteenth via V16 is etched away to expose a surface of the second initial connection block 32-1, and the sixteenth via V16 is configured such that an eighth connection electrode to be to be formed subsequently is connected to the second initial connection block 32-1 through the sixteenth via V16.

In an exemplary implementation mode, an orthographic projection of the seventeenth via V17 on the base substrate is within a range of an orthographic projection of the third initial connection block 33-1 of the third initial signal line 33 on the base substrate, the sixth insulation layer in the seventeenth via V17 is etched away to expose a surface of the third initial connection block 33-1, and the seventeenth via V17 is configured such that a ninth connection electrode to be to be formed subsequently is connected to the third initial connection block 33-1 through the seventeenth via V17.

In an exemplary implementation mode, a plurality of vias of adjacent unit columns may be mirror symmetric with respect to a column dividing line, and shapes of a plurality of vias in a plurality of unit rows may be substantially the same.

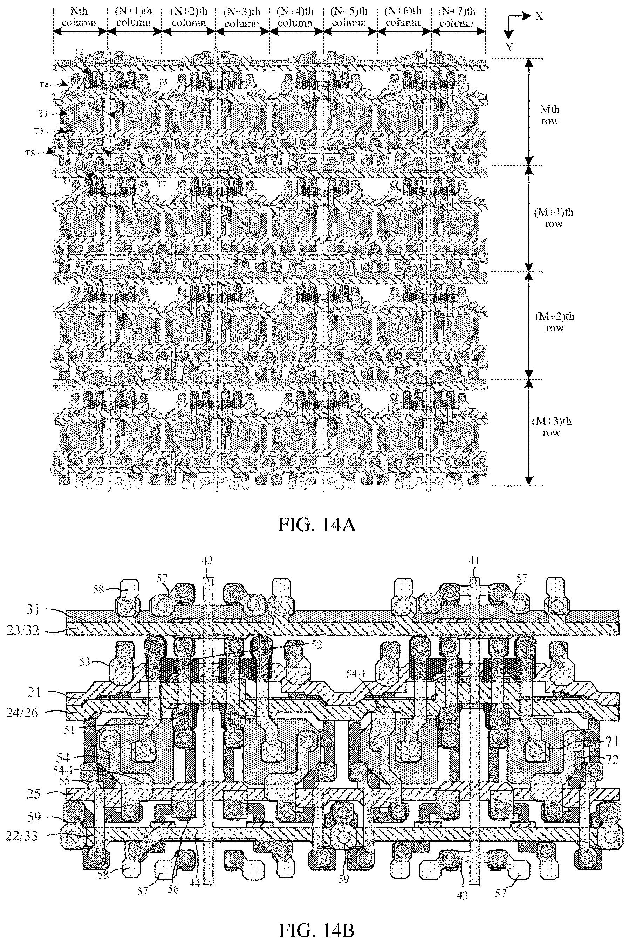

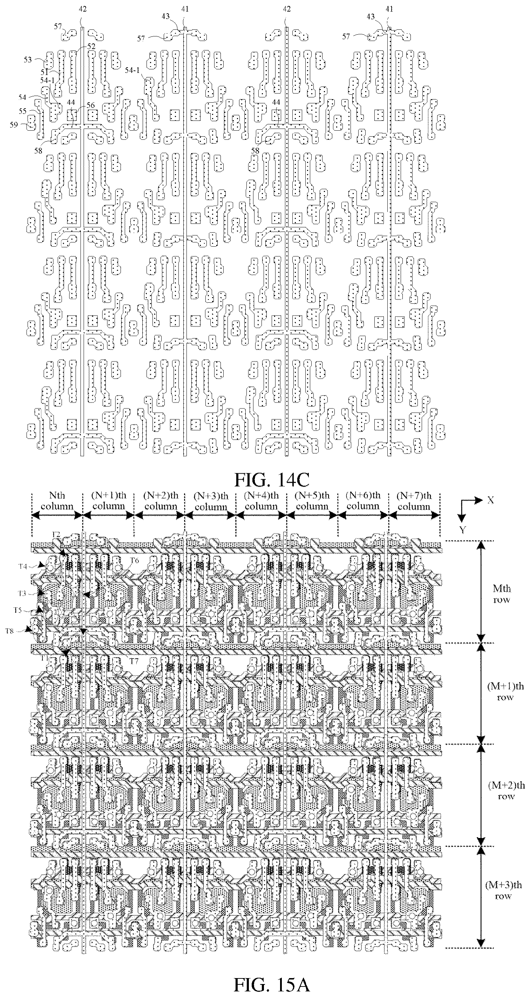

(7) Forming a pattern of a fourth conductive layer. In an exemplary implementation mode, forming the pattern of the fourth conductive layer may include: depositing a fourth conductive thin film on the base substrate on which the aforementioned pattern is formed, patterning the fourth conductive thin film through a patterning process to form a fourth conductive layer disposed on the sixth insulation layer, as shown in FIGs. 14A, 14B, and 14C, wherein FIG. 14B is a schematic diagram of a structure of four circuit units in FIG. 14A, and FIG. 14C is a schematic plan view of the fourth conductive layer in FIG. 14A. In an exemplary implementation mode, the fourth conductive layer may be referred to as a first source drain metal (SD1) layer.

In an exemplary implementation mode, the fourth conductive layer of each circuit unit at least includes: a first connection electrode 51, a second connection electrode 52, a third connection electrode 53, a fourth connection electrode 54, a fifth connection electrode 55, a sixth connection electrode 56, a seventh connection electrode 57, an eighth connection electrode 58, and a ninth connection electrode 59.

In an exemplary implementation mode, the first connection electrode 51 may be in a shape of a polyline with a main body portion extending along the second direction Y, a first end of the first connection electrode 51 is connected to the first region of the second active layer through the third via V3, and a second end of the first connection electrode 51, after extending along the second direction Y, is connected to the first plate 71 through the thirteenth via V13. In an exemplary implementation mode, since the first plate 71 simultaneously serves as the gate electrode of the third transistor T3, the first connection electrode 51 enables the first electrode of the second transistor T2, the gate electrode of the third transistor T3 and the first plate 71 to have a same potential to form a first node N1 of the pixel drive circuit.

In an exemplary implementation mode, the second connection electrode 52 may be in a shape of a strip with a main body portion extending along the second direction Y, a first end of the second connection electrode 52 is connected to the second region of the first active layer through the second via V2, and a second end of the second connection electrode 52 extends in the second direction Y to be connected to the second region of the third active layer (also the first region of the sixth active layer) through the fifth via V5, and the portion between the first end and the second end of the second connection electrode 52 is connected to the second region of the second active layer through the fourth via V4. In an exemplary implementation mode, the second connection electrode 52 enables the second electrode of the first transistor T1, the second electrode of the second transistor T2, the second electrode of the third transistor T3, and the first electrode of the sixth transistor T6 to have a same potential to form a third node N3 of the pixel drive circuit.

In an exemplary implementation mode, the third connection electrode 53 may be in a shape of a block (such as a rectangle) and the third connection electrode 53 is connected to the first region of the fourth active layer through the sixth via V6. In an exemplary implementation mode, the third connection electrode 53 may serve as the first electrode of the fourth transistor T4, and the third connection electrode 53 is configured to be connected to a data signal line to be formed subsequently.

In an exemplary implementation mode, the fourth connection electrode 54 may be in a shape of a polyline with a main body portion extending along the second direction Y, a first end of the fourth connection electrode 54 is connected to a first region of the fifth active layer through the seventh via V7, and a second end of the fourth connection electrode 54, after extending along the opposite direction of the second direction Y, is connected to the second plate 72 through the fourteenth via V14, thus achieving that a first electrode of the fifth transistor T5 in each circuit unit and the second plate 72 of the storage capacitor have a same potential.

In an exemplary implementation mode, the fourth connection electrode 54 may serve as the first electrode of the fifth transistor T5. The fourth connection electrode 54 in each circuit unit is provided with a power supply connection block 54-1, the power supply connection block 54-1 is configured to be connected to a power supply line to be formed subsequently in the current circuit unit.

In an exemplary implementation mode, positions of power supply connection blocks 54-1 in the first circuit unit, the second circuit unit, and the fourth circuit unit may be the same, and the power supply connection blocks 54-1 in the first circuit unit, the second circuit unit, and the fourth circuit unit may be in a shape of a block (such as a rectangle), and may be disposed between the first end of the fourth connection electrode 54 and the second end of the fourth connection electrode 54.

In an exemplary implementation mode, a position of a power supply connection block 54-1 in the third circuit unit may be different from positions of power supply connection blocks 54-1 in other circuit units. The power supply connection block 54-1 in the third circuit unit may be in a shape of a block (such as a rectangle), and may be disposed on a side of the second end of the fourth connection electrode 54 away from the first end of the fourth connection electrode 54.

In an exemplary implementation mode, the fifth connection electrode 55 may be in a shape of a polyline with a main body portion extending along the second direction Y, a first end of the fifth connection electrode 55 is connected to a first region of the third active layer through the eighth via V8, and a second end of the fifth connection electrode 55, after extending along the second direction Y, is connected to the second region of the eighth active layer through the twelfth via V12. In an exemplary implementation mode, since the first region of the third active layer serves as the second region of the fourth active layer and the second region of the fifth active layer at the same time, the fifth connection electrode 55 enables the first electrode of the third transistor T3, the second electrode of the fourth transistor T4, the second electrode of the fifth transistor T5, and the second electrode of the eighth transistor T8 to have a same potential to form a second node N2 of the pixel drive circuit.

In an exemplary implementation mode, the sixth connection electrode 56 may be in a shape of a block (such as a rectangle), and the sixth connection electrode 56 is connected to the second region of the sixth active layer (also the second region of the seventh active layer) through the ninth via V9. In an exemplary implementation mode, the sixth connection electrode 56 may serve as a second electrode of the sixth transistor T6 and a second electrode of the seventh transistor T7 simultaneously, and the sixth connection electrode 56 is configured to be connected to a eleven-numbered connection electrode to be formed subsequently.

In an exemplary implementation mode, the seventh connection electrode 57 may be in a shape of a strip, a first end of the seventh connection electrode 57 is connected to the first region of the first active layer through the first via V1, and a second end of the seventh connection electrode 57 is connected to the first initial connection block 31-1 through the fifteenth via V15. In an exemplary implementation mode, the seventh connection electrode 57 may serve as the first electrode of the first transistor T1, and since the first initial connection block 31-1 is connected to the first initial signal line 31, the seventh connection electrode 57 enables a first initial signal transmitted by the first initial signal line 31 to be written to the first electrode of the first transistor T1.

In an exemplary implementation mode, the eighth connection electrode 58 may be in a shape of a strip with a main body portion extending along the second direction Y, a first end of the eighth connection electrode 58 is connected to the first region of the seventh active layer through the tenth via V10, and a second end of the eighth connection electrode 58 is connected to the second initial connection block 32-1 through the sixteenth via V16. In an exemplary implementation mode, the eighth connection electrode 58 may serve as the first electrode of the seventh transistor T7, and since the second initial connection block 32-1 is connected to the second initial signal line 32, the eighth connection electrode 58 enables a second initial signal transmitted by the second initial signal line 32 to be written to the first electrode of the seventh transistor T7.

In the exemplary implementation mode, since the second initial signal line 32 is disposed on a side of the first scan signal line 21 away from the second plate 72 in the circuit unit, and the second initial connection block 32-1 is disposed on a side of the second initial signal line 32 away from the second plate 72, a second initial signal line 32 of the present circuit unit is connected to a first region of the seventh active layer of a circuit unit in a previous unit row through the eighth connection electrode 58, that is, a second initial signal line 32 in the present unit row writes a second initial signal to a first electrode of the seventh transistor T7 in the previous unit row.

In an exemplary implementation mode, the ninth connection electrode 59 may be in a shape of a strip with a main body portion extending along the second direction Y, a first end of the ninth connection electrode 59 is connected to a first region of the eighth active layer through the eleventh via V11, and a second end of the eighth connection electrode 58 is connected to the third initial connection block 33-1 through the seventeenth via V17. In an exemplary implementation mode, the ninth connection electrode 59 may serve as the first electrode of the eighth transistor T8, and since the third initial connection block 33-1 is connected to the third initial signal line 33, the ninth connection electrode 59 enables a third initial signal transmitted by the third initial signal line 33 to be written to the first electrode of the eighth transistor T8.

In the exemplary implementation mode, since eighth active layers in some adjacent circuit units in a unit row are of an interconnected integral structure, some adjacent circuit units share a third initial connection block 33-1, and thus some adjacent circuit units share a ninth connection electrode 59, it is possible to ensure that first electrodes of the eighth transistors T8 of adjacent circuit units has a same potential, which is beneficial to improving uniformity of a panel, avoiding poor display of the display substrate, and ensuring display effect of the display substrate.

In an exemplary implementation mode, the fourth conductive layer may also include a first initial connection line 41, a second initial connection line 42, a first initial connection strip 43, and a second initial connection strip 44.

In an exemplary implementation mode, the first initial connection line 41 may be in a shape of a straight line or a polyline with a main body portion extending along the second direction Y. In at least one circuit unit, the first initial connection line 41 may be disposed on a side of the second connection electrode 52 away from the first connection electrode 51. The first initial connection strip 43 may be in a shape of a straight line or a polyline with a main body portion extending along the first direction X, and may be disposed between the first initial connection line 41 and the seventh connection electrode 57. A first end of the first initial connection strip 43 is connected to the first initial connection line 41, and a second end of the first initial connection strip 43 is connected to the seventh connection electrode 57.

In an exemplary implementation mode, since the seventh connection electrode 57 is connected to the first initial signal line 31 through the first initial connection block, an interconnection between the first initial signal line 31 whose main body portion extends along the first direction X and the first initial connection line 41 whose main body portion extends along the second direction Y is achieved, so that the first initial signal line 31 and the first initial connection line 41 form a grid communication structure transmitting the first initial signal on the display substrate, not only a resistance of the first initial signal line is effectively reduced, a voltage drop of the first initial signal may be reduced, but also uniformity of the first initial signal in the display substrate may be effectively improved, display uniformity may be effectively improved, and display quality may be improved.

In an exemplary implementation mode, the second initial connection line 42 may be in a shape of a straight line or a polyline with a main body portion extending along the second direction Y. In at least one circuit unit, the second initial connection line 42 may be disposed on a side of the second connection electrode 52 away from the first connection electrode 51 in the circuit unit. The second initial connection strip 44 may be in a shape of a straight line or a polyline with a main body portion extending along the first direction X, and may be disposed between the second initial connection line 42 and the eighth connection electrode 58. A first end of the second initial connection strip 44 is connected to the second initial connection line 42, and a second end of the second initial connection strip 44 is connected to the eighth connection electrode 58.

In the exemplary implementation mode, since the eighth connection electrode 58 is connected to the second initial signal line 32 through the second initial connection block 32-1, a mutual connection between the second initial signal line 32 with a main body portion extending along the first direction X and the second initial connection line 42 with a main body portion extending along the second direction Y is achieved, so that the second initial signal line 32 and the second initial connection line 42 form a grid communication structure for transmitting a first initial signal on the display substrate, not only a resistance of the second initial signal line may be effectively reduced, a voltage drop of the second initial signal may be reduced, but also uniformity of the second initial signal in the display substrate may be effectively improved, display uniformity may be effectively improved, and display quality may be improved.

In the exemplary implementation mode, in the first direction X, the first initial connection line 41 and the second initial connection line 42 may be alternately disposed, that is, one second initial connection line 42 may be disposed between two adjacent first initial connection lines 41 in the first direction X, and one first initial connection line 41 may be disposed between two adjacent second initial connection lines 42 in the first direction X.

In an exemplary implementation mode, adjacent unit columns may share a first initial connection line 41 or a second initial connection line 42. For example, a plurality of circuit units in the N-th unit column and the (N+1)-th unit column may share one second initial connection line 42, and a plurality of circuit units in the (N+4)-th unit column and the (N+5)-th unit column may share one second initial connection line 42. For another example, a plurality of circuit units in the (N+2)-th unit column and the (N+3)-th unit column may share one first initial connection line 41, and a plurality of circuit units in the (N+6)-th unit column and the (N+7)-th unit column may share one first initial connection line 41.

In an exemplary implementation mode, in at least one unit row, fourth conductive layers of some adjacent circuit units may be mirror symmetric with respect to a column dividing line. For example, in the M-th unit row and the (M+2)-th unit row, fourth conductive layers of two circuit units of the N-th unit column and the (N+1)-th unit column may be mirror symmetric with respect to a column dividing line, and fourth conductive layers of two circuit units of the (N+4)-th unit column and the (N+5)-th unit column may be mirror symmetric with respect to a column dividing line. For another example, in the (M+1)-th unit row and the (M+3)-th unit row, fourth conductive layers of two circuit units of the (N+2)-th unit column and the (N+3)-th unit column may be mirror symmetric with respect to a column dividing line, and fourth conductive layers of two circuit units of the (N+6)-th unit column and the (N+7)-th unit column may be mirror symmetric with respect to a column dividing line.

In an exemplary implementation mode, in at least one unit column, shapes of fourth conductive layers of some circuit units may be substantially the same. For example, in the N-th unit column, the (N+1)-th unit column, the (N+4)-th unit column, and the (N+5)-th unit column, shapes of fourth conductive layers of two circuit units in the M-th unit row and the (M+2)-th unit row may be substantially the same. For another example, in the (N+2)-th unit column, the (N+3)-th unit column, the (N+6)-th unit column, and the (N+7)-th unit column, shapes of fourth conductive layers of two circuit units in the (M+1)-th unit row and the (M+3)-th unit row may be substantially the same.

In an exemplary implementation mode, except for the fourth conductive layer of the fourth connection electrode 54, fourth conductive layers of some adjacent unit columns may be mirror symmetric with respect to a column dividing line. For example, a fourth semiconductor layer in the N-th unit column and a fourth semiconductor layer in the (N+1)-th unit column may be mirror symmetric with respect to a column dividing line. For another example, a fourth conductive layer in the (N+2)-th unit column and a fourth conductive layer in the (N+3)-th unit column may be mirror symmetric with respect to a column dividing line. For another example, a fourth conductive layer in the (N+4)-th unit column and a fourth conductive layer in the (N+5)-th unit column may be mirror symmetric with respect to a column dividing line.

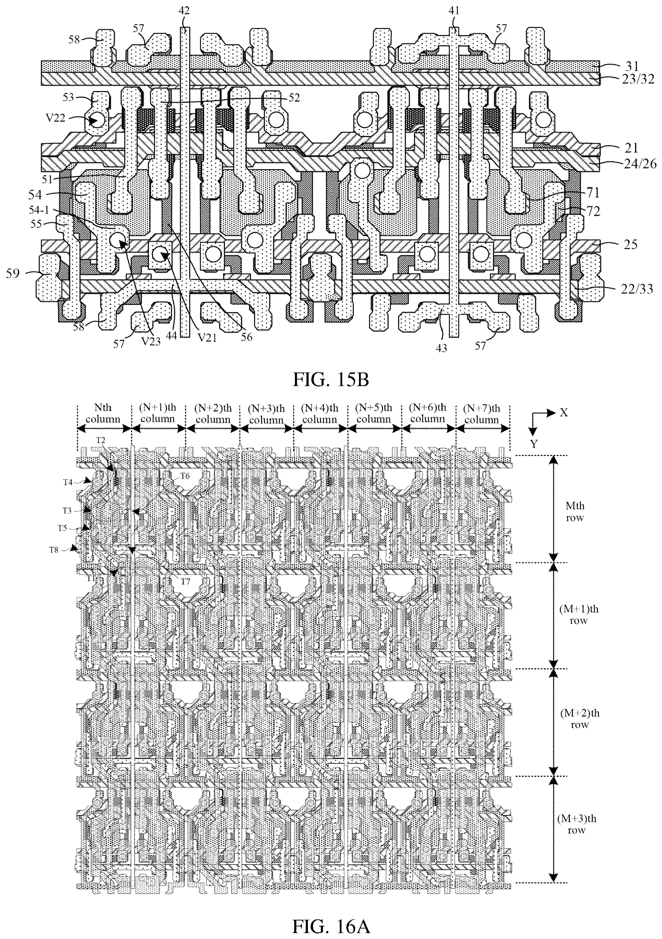

(8) Forming a pattern of a first planarization layer. In an exemplary implementation mode, forming the pattern of the first planarization layer may include: coating a first planarization thin film on the base substrate on which the above-mentioned patterns are formed, and patterning the first planarization thin film through a patterning process to form a first planarization layer covering the fourth conductive layer, wherein the first planarization layer is provided with a plurality of vias, as shown in FIG. 15A and FIG. 15B, and FIG. 15B is a schematic diagram of a structure of four circuit units in FIG. 15A.

In an exemplary implementation mode, a plurality of vias in each circuit unit at least includes a twenty-first via V21, a twenty-second via V22, and a twenty-third via V23.

In an exemplary implementation mode, an orthographic projection of the twenty-first via V21 on the base substrate is located within a range of an orthographic projection of the sixth connection electrode 56 on the base substrate, the first planarization layer within the twenty-first via V21 is etched away to expose a surface of the sixth connection electrode 56, and the twenty-first via V21 is configured such that an eleventh connection electrode to be formed subsequently is connected to the six connection electrode 56 through the twenty-first via V21.

In an exemplary implementation mode, an orthographic projection of the twenty-second via V22 on the base substrate is within a range of an orthographic projection of the third connection electrode 53 on the base substrate, the first planarization layer within the twenty-second via V22 is etched away to expose a surface of the third connection electrode 53, and the twenty-second via V22 is configured such that a data signal line to be formed subsequently is connected to the third connection electrode 53 through the twenty-second via V22.

In an exemplary implementation mode, an orthographic projection of the twenty-third via V23 on the base substrate is within a range of an orthographic projection of the power supply connection block 54-1 of the fourth connection electrode 54 on the base substrate, the first planarization layer within the twenty-third via V23 is etched away to expose a surface of the power supply connection block 54-1, and the twenty-third via V23 is configured such that a high-potential power supply line to be formed subsequently is connected to the power supply connection block 54-1 through the twenty-third via V23.

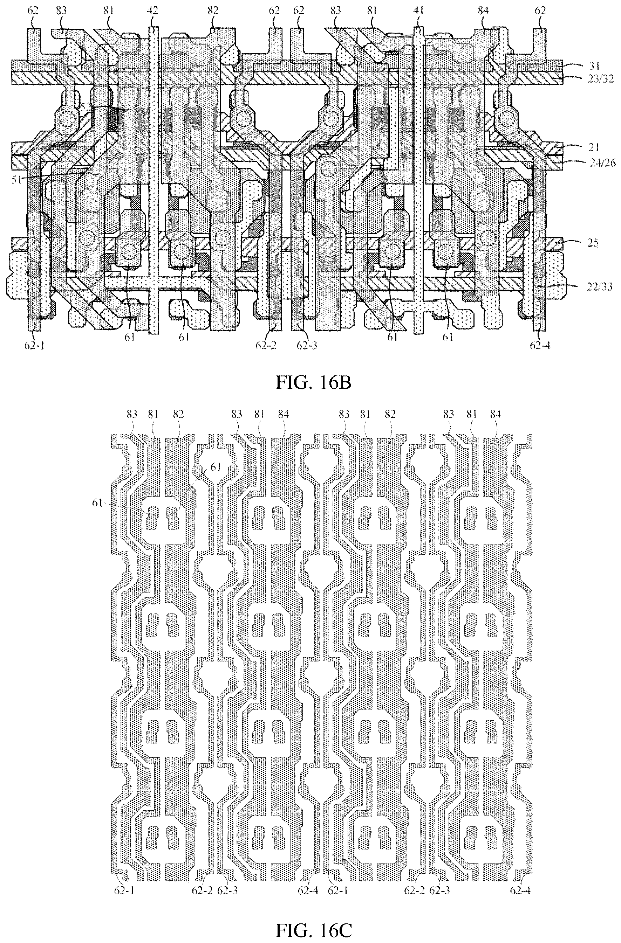

(9) Forming a pattern of a fifth conductive layer. In an exemplary implementation mode, forming the pattern of the fifth conductive layer may include: depositing a fifth conductive thin film on the base substrate on which the aforementioned patterns are formed, patterning the fifth conductive thin film through a patterning process to form a fifth conductive layer disposed on the first planarization layer, as shown in FIGs. 16A, 16B, and 16C, wherein FIG. 16B is a schematic diagram of a structure of four circuit units in FIG. 16A, and FIG. 16C is a schematic plan view of the fifth conductive layer in FIG. 16A. In an exemplary implementation mode, the fifth conductive layer may be referred to as a second source-drain metal (SD2) layer.

In an exemplary implementation mode, the fifth conductive layer of each circuit unit at least includes an eleventh connection electrode 61 and a data signal line 62.

In an exemplary implementation mode, the eleventh connection electrode 61 may be in a shape of a strip with a main body portion extending along the second direction Y, the eleventh connection electrode 61 is connected to the sixth connection electrode 56 through the twenty-first via V21, and the eleventh connection electrode 61 is configured to be connected to an anode connection electrode to be formed subsequently.

In an exemplary implementation mode, the data signal line 62 may be in a shape of a polyline with a main body portion extending along the second direction Y, and the data signal line 62 is connected to the third connection electrode 53 through the twenty-second via V22. Since the third connection electrode 53 is connected to the first region of the fourth active layer through a via , connection between the data signal line 62 and the first electrode of the fourth transistor T4 is achieved, and the data signal line 62 can write a data signal to the first electrode of the fourth transistor T4.

In an exemplary implementation mode, the fifth conductive layer of a first circuit unit may further include a first power supply line 81, the fifth conductive layer of a second circuit unit may further include a second power supply line 82, the fifth conductive layer of a third circuit unit may further include a third power supply line 83, the fifth conductive layer of a fourth circuit unit may further include a fourth power supply line 84, and the first power supply line 81, the second power supply line 82, the third power supply line 83, and the fourth power supply line 84 are all high-potential power supply lines.

In an exemplary implementation mode, the first power supply line 81 may be in a shape of a polyline with a main body portion extending along the second direction Y, and the first power supply line 81 is connected to the power supply connection block 54-1 of the first circuit unit through the twenty-third via V23 in the first circuit unit, that is, the first power supply line 81 is connected to a first pixel drive circuit in the first circuit unit.

In an exemplary implementation mode, the second power supply line 82 may be in a shape of a polyline with a main body portion extending along the second direction Y, and the second power supply line 82 is connected to the power supply connection block 54-1 of the second circuit unit through the twenty-third via V23 in the second circuit unit, that is, the second power supply line 82 is connected to a second pixel drive circuit in the second circuit unit.

In an exemplary implementation mode, the third power supply line 83 may be in a shape of a polyline with a main body portion extending along the second direction Y, and the third power supply line 83 is connected to the power supply connection block 54-1 of the third circuit unit through the twenty-third via V23 in the third circuit unit, that is, the third power supply line 83 is connected to a third pixel drive circuit in the third circuit unit.

In an exemplary implementation mode, the fourth power supply line 84 may be in a shape of a polyline with a main body portion extending along the second direction Y, and the fourth power supply line 84 is connected to the power supply connection block 54-1 of the fourth circuit unit through the twenty-third via V23 in the fourth circuit unit, that is, the fourth power supply line 84 is connected to the fourth pixel drive circuit in the fourth circuit unit.

In the exemplary implementation mode, since the power supply connection block 54-1 of each circuit unit is connected to the fourth connection electrode 54 of the circuit unit, and the fourth connection electrode 54 is respectively connected to the first region of the fifth active layer and the second plate 72 of the storage capacitor of the circuit unit, the first power supply line 81 writes a first power supply signal to the first electrode of the fifth transistor T5 and the second plate 72 of the storage capacitor in the first pixel drive circuit, the second power supply line 82 writes a second power supply signal to the first electrode of the fifth transistor T5 and the second plate 72 of the storage capacitor in the second pixel drive circuit, the third power supply line 83 writes a third power supply signal to the first electrode of the fifth transistor T5 and the second plate 72 of the storage capacitor in the third pixel drive circuit, and the fourth power supply line 84 writes a fourth power supply signal to the first electrode of the fifth transistor T5 and the second plate 72 of the storage capacitor in the fourth pixel drive circuit.

In an exemplary implementation mode, the first power supply line 81, the second power supply line 82, the third power supply line 83, and the fourth power supply line 84 may be polylines with unequal widths, which may not only facilitates a layout of a pixel structure, but also reduce a parasitic capacitance between a power supply line and a data signal line.

In an exemplary implementation mode, any one or more of the first power supply line 81, the second power supply line 82, the third power supply line 83, and the fourth power supply line 84 are disposed in at least one unit column. For example, four power supply lines may be disposed in different unit columns, respectively. For another example, two power supply lines of the four power supply lines may be disposed in a same unit column.

In the exemplary implementation mode, since a first circuit unit and a third circuit unit are disposed at an interval in one unit column, the first power supply line 81 and the third power supply line 83 may be disposed together in one unit column, the first power supply line 81 is connected to first pixel drive circuits of a plurality of first circuit units in the unit column, and the third power supply line 83 is connected to third pixel drive circuits of a plurality of third circuit units in the unit column.

In an exemplary implementation mode, the second power supply line 82 and the fourth power supply line 84 may be connected to a same signal source, that is, the second power supply line 82 and the fourth power supply line 84 have a same potential. Since a second circuit unit and a fourth circuit unit are disposed in one unit column, the second power supply line 82 may be separately disposed in one unit column, and the second power supply line 82 is connected to pixel drive circuits of a plurality of second circuit units and a plurality of fourth circuit units in the unit column, and the fourth power supply line 84 may be separately disposed in one unit column, and the second power supply line 82 is connected to pixel drive circuits of a plurality of second circuit units and a plurality of fourth circuit units in the unit column.

In an exemplary implementation mode, the third power supply line 83 may be disposed on a side of the data signal line 62 of the current circuit unit in the first direction X, and the first power supply line 81 may be disposed on a side of the third power supply line 83 of the present circuit unit in the first direction X. The second power supply line 82 may be disposed on a side of the data signal line 62 of the current circuit unit in a direction opposite to the first direction X, and the fourth power supply line 84 may be disposed on a side of the data signal line 62 of the current circuit unit in a direction opposite to the first direction X.

In an exemplary implementation mode, the first power supply line 81 and the third power supply line 83 may be disposed in the N-th unit column, the (N+2)-th unit column, the (N+4)-th unit column, and the (N+6)-th unit column, and a dual power supply line structure is formed in these unit columns. The second power supply line 82 may be disposed in the (N+1)-th unit column and the (N+5)-th unit column, a single power supply line structure is formed in these unit columns. The fourth power supply line 84 may be disposed in the (N+3)-th unit column and the (N+7)-th unit column, and a single power supply line structure is formed in these unit columns. Thus, along the first direction X, a unit column with the dual power supply line structure and a unit column with the single power supply line structure are alternately arranged.

In an exemplary implementation mode, an odd-numbered unit column in the display substrate is a unit column with a dual power supply line structure, and an even-numbered unit column in the display substrate is a unit column with a single power supply line structure. or, the even-numbered unit column in the display substrate is a unit column with a dual power supply line structure, and the odd-numbered unit column in the display substrate is a unit column with a single power supply line structure.

In an exemplary implementation mode, in a unit column with the dual power supply line structure, a plurality of first circuit units may be located in an odd-numbered unit row, a plurality of third circuit units may be located in an even-numbered unit row. The first power supply line 81 may be connected to pixel drive circuits of circuit units in all odd-numbered unit rows in the unit column, and the third power supply line 83 may be connected to pixel drive circuits of circuit units in all even-numbered unit rows in the unit column.

In an exemplary implementation mode, in a unit column with the dual power supply line structure, a plurality of first circuit units may be located in an even-numbered unit row, a plurality of third circuit units may be located in an odd-numbered unit row. The first power supply line 81 may be connected to pixel drive circuits of circuit units in all even-numbered unit rows in the unit column, and the third power supply line 83 may be connected to pixel drive circuits of circuit units in all odd-numbered unit rows in the unit column.

In an exemplary implementation mode, in a unit column with a single power supply line structure, the second power supply line 82 may be connected to pixel drive circuits of a plurality of second circuit units and pixel drive circuits of a plurality of fourth circuit units in the unit column, that is, the second power supply line 82 may be connected to pixel drive circuits of circuit units in all odd-numbered unit rows and all even-numbered unit rows in the unit column.

In an exemplary implementation mode, in a unit column with a single power supply line structure, the fourth power supply line 84 may be connected to pixel drive circuits of a plurality of second circuit units and pixel drive circuits of a plurality of fourth circuit units in the unit column, that is, the fourth power supply line 84 may be connected to pixel drive circuits of circuit units in all odd-numbered unit rows and all even-numbered unit rows in the unit column.

In an exemplary implementation mode, at least one of the first power supply line, the second power supply line, the third power supply line, and the fourth power supply line may extend to the bonding area or the bezel area, and power supply lines having a same potential may be connected together through a power supply trace in the bonding area or the bezel area.

In an exemplary implementation mode, an orthographic projection of at least one of the first power supply line 81, the second power supply line 82, the third power supply line 83, and the fourth power supply line 84 on the base substrate is at least partially overlapped with an orthographic projection of the first connection electrode 51 on the base substrate. Since the first connection electrode 51 serves as the first node N1 of the pixel drive circuit, a power supply line having a constant potential may effectively shield an influence of data voltage jumps and other signals on the first node N1 in the pixel drive circuit, an influence of the data voltage jumps and other signals on a potential of the first node N1 is avoided, and drive performance of the pixel drive circuit is improved.

In an exemplary implementation mode, an orthographic projection of at least one of the first power supply line 81, the second power supply line 82, the third power supply line 83, and the fourth power supply line 84 on the base substrate is at least partially overlapped with an orthographic projection of the second active layer on the base substrate, so that a power supply line may shield the second active layer, may block light emitted by a light emitting device and light reflected by a film layer from irradiating the second transistor T2 of oxide, may prevent the oxide transistor from characteristic drift due to illumination, thus improving electrical characteristics of the oxide transistor.

In an exemplary implementation mode, an orthographic projection of at least one of the first power supply line 81, the second power supply line 82, the third power supply line 83, and the fourth power supply line 84 on the base substrate is at least partially overlapped with an orthographic projection of the second connection electrode 52 on the base substrate.

In an exemplary implementation mode, in at least one unit row, eleventh connection electrodes 61 and data signal lines 62 of adjacent circuit units may be mirror symmetric with respect to a column dividing line. For example, eleventh connection electrodes 61 and data signal lines 62 of two circuit units of the N-th unit column and the (N+1)-th unit column may be mirror symmetric with respect to a column dividing line. For another example, eleventh connection electrodes 61 and data signal lines 62 of two circuit units of the (N+1)-th unit column and the (N+2)-th unit column are mirror symmetric with respect to a column dividing line.

In an exemplary implementation mode, in at least one unit column, shapes of fourth conductive layers of some circuit units may be substantially the same. For example, shapes of fourth conductive layers of two circuit units of the M-th unit row and the (M+2)-th unit row may be substantially the same. For another example, shapes of fourth conductive layers of two circuit units of the (M+1)-th unit row and the (M+3)-th unit row may be substantially the same.

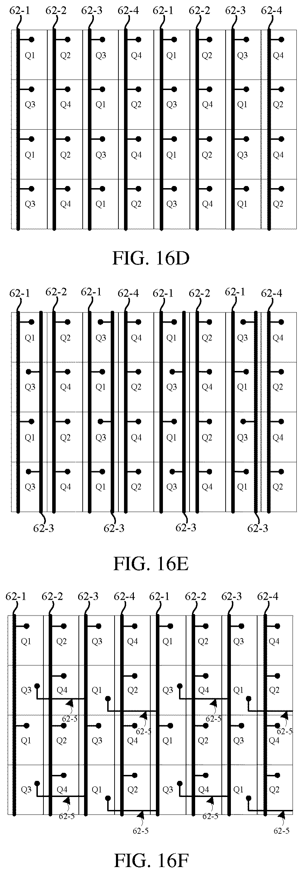

FIGs. 16D, 16E, and 16F are schematic diagrams showing connections of a data signal line according to an embodiment of the present disclosure. In an exemplary implementation mode, the data signal line 62 may include a first data signal line 62-1, a second data signal line 62-2, a third data signal line 62-3, and a fourth data signal line 62-4, each of which is connected to a first region of the fourth active layer through a third connection electrode, thereby enabling a data signal line to write a data signal to a first electrode of the fourth transistor T4. Any one or more of the first data signal line 62-1, the second data signal line 62-2, the third data signal line 62-3, and the fourth data signal line 62-4 may be disposed in at least one unit column.

In an exemplary implementation mode, each data signal line may be separately disposed in one unit column. For a unit column including the first circuit unit and the third circuit unit, the first data signal line 62-1 disposed in the unit column is connected not only with a fourth transistor T4 of the first pixel drive circuit in the unit column but also with a fourth transistor T4 of the third pixel drive circuit in the unit column, and the third data signal line 62-3 disposed in the unit column is connected not only with a fourth transistor T4 of the third pixel drive circuit in the unit column but also with a fourth transistor T4 of the first pixel drive circuit in the unit column, as shown in FIG. 16D.

In another exemplary implementation mode, the first data signal line 62-1 and the third data signal line 62-3 may be disposed together in one unit column. For a unit column including the first circuit unit and the third circuit unit, the first data signal line 62-1 disposed in the unit column is connected only with the fourth transistor T4 of the first pixel drive circuit in the unit column, and the third data signal line 62-3 disposed in the unit column is connected only with a fourth transistor T4 of the third pixel drive circuit in the unit column, as shown in FIG. 16E.

In yet another implementation mode, each data signal line may be separately disposed in one unit column. For a unit column including the first circuit unit and the third circuit unit, the first data signal line 62-1 is connected only to a fourth transistor T4 of the first pixel drive circuit in the unit column, and is connected to a fourth transistor T4 of the first pixel drive circuit in another unit column through a data transfer line 62-5. For another unit column including the first circuit unit and the third circuit unit, the third data signal line 62-3 is connected only to a fourth transistor T4 of the third pixel drive circuit in the unit column, and is connected to a fourth transistor T4 of the first pixel drive circuit in another unit column through a data transfer line 62-5.

In an exemplary implementation mode, since the first pixel drive circuit is connected to light emitting units of a same color (such as red), the first data signal line 62-1 is connected to pixel drive circuits of a same color sub-pixel. Since the third pixel drive circuit is connected to light emitting units of a same color (such as blue), the third data signal line 62-3 is connected to pixel drive circuits of a same color sub-pixel. Since the second pixel drive circuit and the fourth pixel drive circuit are connected to light emitting units of a same color (such as green), the second data signal line 62-2 and the fourth data signal line 62-4 are connected to pixel drive circuits of a same color sub-pixel. In the present disclosure, through connecting a single data signal line to pixel drive circuits of a same color sub-pixel, power consumption of a drive circuit can be saved when a solid color picture is displayed.

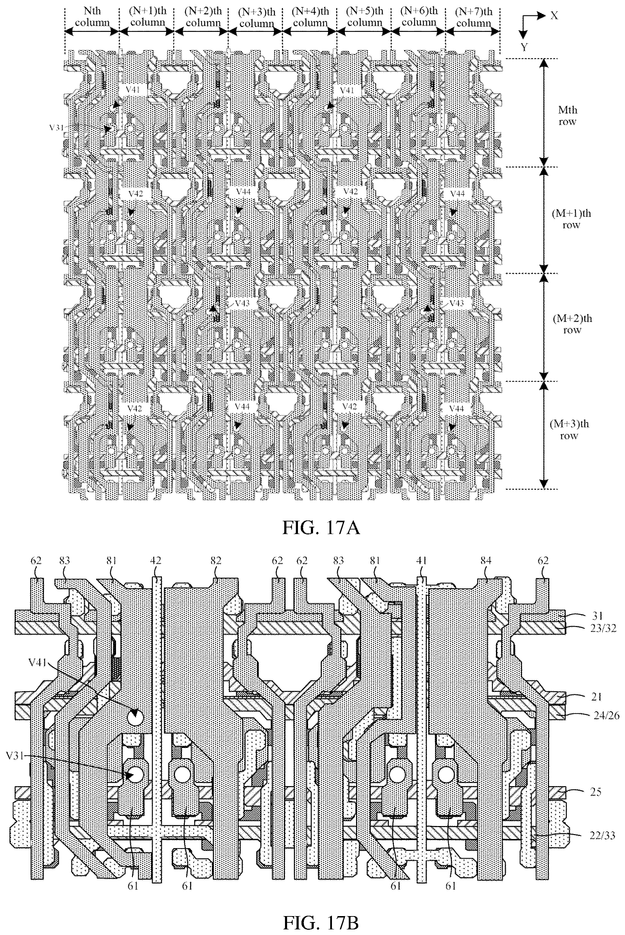

(10) Forming a pattern of a second planarization layer. In an exemplary implementation mode, forming the pattern of the second planarization layer may include: coating a second planarization thin film on the base substrate on which the above-mentioned patterns are formed, and patterning the second planarization thin film through a patterning process to form a second planarization layer covering the fifth conductive layer, wherein the second planarization layer is provided with a plurality of vias, as shown in FIG. 17A and FIG. 17B, and FIG. 17B is a schematic diagram of a structure of four circuit units in FIG. 17A.

In an exemplary implementation mode, the plurality of vias in each circuit unit at least includes a thirty-first via V31.

In an exemplary implementation mode, an orthographic projection of the thirty-first via V31 on the base substrate is within a range of an orthographic projection of the eleventh connection electrode 61 on the base substrate, the second planarization layer within the thirty-first via V31 is etched away to expose a surface of the eleventh connection electrode 61, and the thirty-first via V31 is configured such that an anode connection electrode to be formed subsequently is connected to the eleventh connection electrode 61 through the thirty-first via V31.

In an exemplary implementation mode, a forty-first via V41, a forty-second via V42, a forty-third via V43, or a forty-fourth via V44 may be further provided on the second planarization layer of at least one circuit unit.

In an exemplary implementation mode, in at least one circuit unit, an orthographic projection of the forty-first via V41 on the base substrate is within a range of an orthographic projection of the first power supply line 81 on the base substrate, the second planarization layer within the forty-first via V41 is etched away to expose a surface of the first power supply line 81, and the forty-first via V41 is configured such that a first connection line to be formed subsequently is connected to the first power supply line 81 through the forty-first via V41.

In an exemplary implementation mode, in at least one circuit unit, an orthographic projection of the forty-second via V42 on the base substrate is within a range of an orthographic projection of the second power supply line 82 on the base substrate, the second planarization layer within the forty-second via V42 is etched away to expose a surface of the second power supply line 82, and the forty-second via V42 is configured such that second connection line to be formed subsequently is connected to the second power supply line 82 through the forty-second via V42.

In an exemplary implementation mode, in at least one circuit unit, an orthographic projection of the forty-third via V43 on the base substrate is within a range of an orthographic projection of the third power supply line 83 on the base substrate, the second planarization layer within the forty-third via V43 is etched away to expose a surface of the third power supply line 83, and the forty-third via V43 is configured such that a third connection line to be formed subsequently is connected to the third power supply line 83 through the forty-third via V43.

In an exemplary implementation mode, in at least one circuit unit, an orthographic projection of the forty-fourth via V44 on the base substrate is within a range of an orthographic projection of the fourth power supply line 84 on the base substrate, the second planarization layer within the forty-fourth via V44 is etched away to expose a surface of the fourth power supply line 84, and the forty-fourth via V44 is configured such that a fourth connection line to be formed subsequently is connected to the fourth power supply line 84 through the forty-fourth via V44.

In an exemplary implementation mode, only the forty-first via V41 or only the forty-third via V43 may be disposed in a plurality of circuit units of at least one unit row. For example, only the forty-first via V41 may be disposed in a plurality of circuit units in the M-th unit row, and only the forty-third via V43 may be disposed in a plurality of circuit units in the (M+2)-th unit row.

In an exemplary implementation mode, the forty-second via V42 and the forty-fourth via V44 may be simultaneously disposed in a plurality of circuit units of at least one unit row. For example, the forty-second via V42 and the forty-fourth via V44 may be disposed simultaneously in a plurality of circuit units in the (M+1)-th unit row, and the forty-second via V42 and the forty-fourth via V44 may be disposed simultaneously in a plurality of circuit units in the (M+3)-th unit row.

In an exemplary implementation mode, only the forty-first via V41, the forty-second via V42, the forty-third via V43, or the forty-fourth via V44 may be disposed in the plurality of circuit units of at least one unit column. For example, only the forty-first via V41 may be disposed in the plurality of circuit units in the N-th unit column and the (N+4)-th unit column, only the forty-second via V42 may be disposed in the plurality of circuit units in the (N+1)-th unit column and the (N+5)-th unit column, only the forty-third via V43 may be disposed in the plurality of circuit units in the (N+2)-th unit column and the (N+6)-th unit column, and only the forty-fourth via V44 may be disposed in the plurality of circuit units in the (N+3)-th unit column and the (N+7)-th unit column.

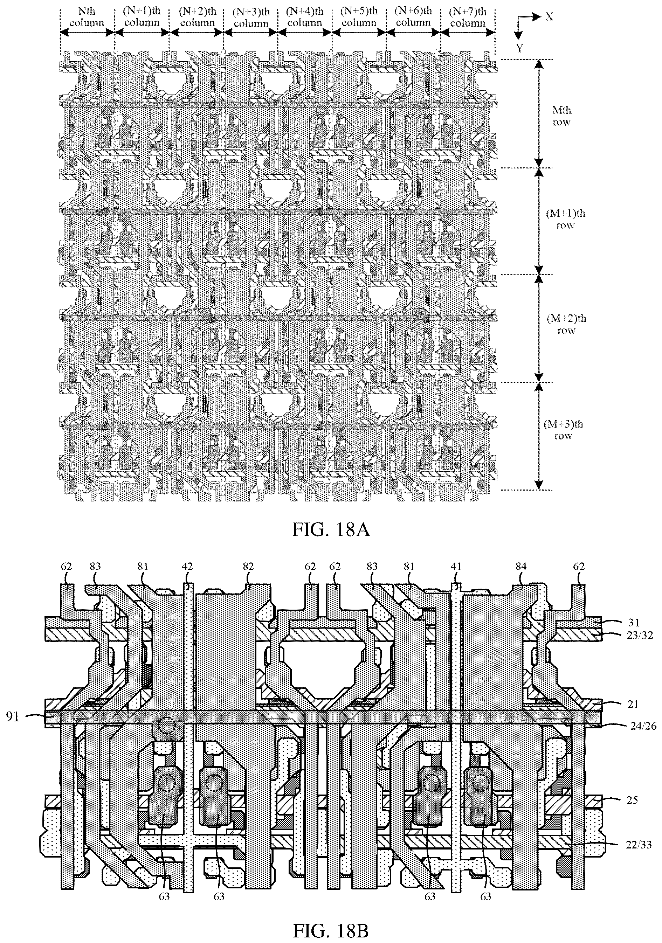

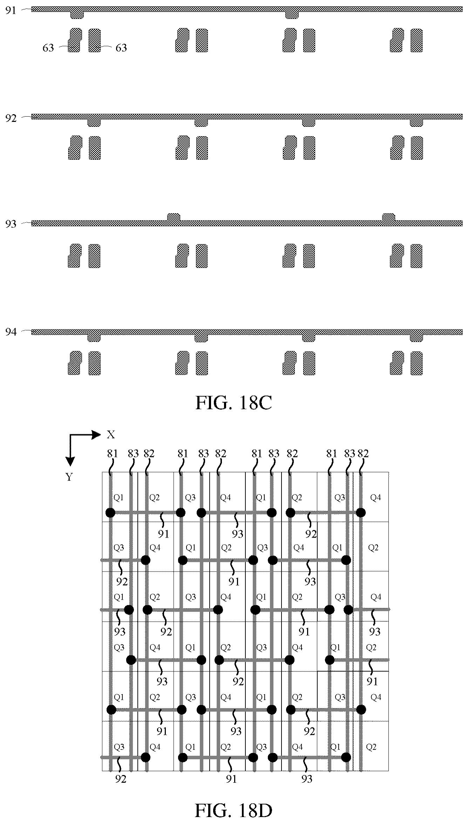

(11) Forming a pattern of a sixth conductive layer. In an exemplary implementation mode, forming the pattern of the sixth conductive layer may include: depositing a sixth conductive thin film on the base substrate on which the aforementioned patterns are formed, patterning the sixth conductive thin film through a patterning process to form a sixth conductive layer disposed on the second planarization layer, as shown in FIGs. 18A, 18B, and 18C, wherein FIG. 18B is a schematic diagram of a structure of four circuit units in FIG. 18A, and FIG. 18C is a schematic plan view of the sixth conductive layer in FIG. 18A. In an exemplary implementation mode, the sixth conductive layer may be referred to as a third source-drain metal (SD3) layer.

In an exemplary implementation mode, the pattern of the sixth conductive layer of each circuit unit at least includes an anode connection electrode 63.

In an exemplary implementation mode, the anode connection electrode 63 may be in a shape of a block (e.g., a rectangle), the anode connection electrode 63 is connected to the eleven-numbered connection electrode 61 through the thirty-first via V31, and the anode connection electrode 63 is configured to be connected to an anode to be formed subsequently. Since the eleven-numbered connection electrode 61 is connected to the sixth connection electrode 56 through a via, and the sixth connection electrode 56 is connected to the second region of the sixth active layer and the second region of the seventh active layer through a via, connection between the anode to be formed subsequently, and the second electrode of the sixth transistor T6 and the second electrode of the seventh transistor T7 may be achieved, and the pixel drive circuit may drive a light emitting device to emit light.

In an exemplary implementation mode, the sixth conductive layer of at least one circuit unit may further be provided with a first connection line 91, a second connection line 92, a third connection line 93, or a fourth connection line 94.

In an exemplary implementation mode, in at least one circuit unit, the first connection line 91 may be in a shape of a straight line or a polyline extending along the first direction X, and the first connection line 91 is connected to the first power supply line 81 through the forty-first via V41, thus achieving a mutual connection of the first connection line 91 with a main body portion extending along the first direction X and the first power supply line 81 with a main body portion extending along the second direction Y, so that the first power supply line 81 and the first connection line 91 constitute a grid communication structure for transmitting a first power supply signal on the display substrate, which may not only effectively reduce a resistance of the first power supply line, reduce a voltage drop of the first power supply signal, but also effectively improve uniformity of the first power supply signal in the display substrate, effectively improve uniformity of display, and improve display quality.

In an exemplary implementation mode, in at least one circuit unit, the second connection line 92 may be in a shape of a straight line or a polyline extending along the first direction X, and the second connection line 92 is connected to the second power supply line 82 through the forty-second via V42, thus achieving a mutual connection of the second connection line 92 with a main body portion extending along the first direction X and the second power supply line 82 with a main body portion extending along the second direction Y, so that the second power supply line 82 and the second connection line 92 constitute a grid communication structure for transmitting a first power supply signal on the display substrate, which may not only effectively reduce a resistance of the second power supply line, reduce a voltage drop of the second power supply signal, but also effectively improve uniformity of the second power supply signal in the display substrate, effectively improve uniformity of display, and improve display quality.

In an exemplary implementation mode, in at least one circuit unit, the third connection line 93 may be in a shape of a straight line or a polyline extending along the first direction X, and the third connection line 93 is connected to the third power supply line 83 through the forty-third via V43, thus achieving a mutual connection of the third connection line 93 with a main body portion extending along the first direction X and the third power supply line 83 with a main body portion extending along the second direction Y, so that the third power supply line 83 and the third connection line 93 constitute a grid communication structure for transmitting a first power supply signal on the display substrate, which may not only effectively reduce a resistance of the third power supply line, reduce a voltage drop of the third power supply signal, but also effectively improve uniformity of the third power supply signal in the display substrate, effectively improve uniformity of display, and improve display quality.

In an exemplary implementation mode, in at least one circuit unit, the fourth connection line 94 may be in a shape of a straight line or a polyline extending along the first direction X, and the fourth connection line 94 is connected to the fourth power supply line 84 through the forty-fourth via V44, thus achieving a mutual connection of the fourth connection line 94 with a main body portion extending along the first direction X and the fourth power supply line 84 with a main body portion extending along the second direction Y, so that the fourth power supply line 84 and the fourth connection line 94 constitute a grid communication structure for transmitting a fourth power signal on the display substrate, which may not only effectively reduce a resistance of the fourth power supply line, reduce a voltage drop of the fourth power supply signal, but also effectively improve uniformity of the fourth power supply signal in the display substrate, effectively improve uniformity of display, and improve display quality.

In an exemplary implementation mode, in at least one unit row, the second connection line 92 is not only connected to a plurality of second power supply lines 82 through a plurality of forty-second vias V42, but also connected to a plurality of fourth power supply lines 84 through a plurality of forty-fourth vias V44, so that the second power supply line 82 and the fourth power supply line 84 are connected to each other through the second connection line 92, and the second power supply line 82 and the fourth power supply line 84 have a same potential.

In an exemplary implementation mode, in at least one unit row, the fourth connection line 94 is not only connected to a plurality of fourth power supply lines 84 through a plurality of forty-fourth vias V44, but also connected to a plurality of second power supply lines 82 through a plurality of forty-second vias V42, so that the second power supply line 82 and the fourth power supply line 84 are connected to each other through the fourth connection line 94, and the second power supply line 82 and the fourth power supply line 84 have a same potential.

In an exemplary implementation mode, any one or more of the first connection line 91, the second connection line 92, the third connection line 93, or the fourth connection line 94 are disposed in at least one unit row. For example, four connection lines may be disposed in different unit rows, respectively. For another example, two, three, or four of the four connection lines may be disposed in a same unit row.

In an exemplary implementation mode, only one connection line may be disposed in one unit row. For example, only the first connection line 91 may be disposed in the M-th unit row. For another example, only the third connection line 93 may be disposed in the (M+2)-th unit row. For another example, only the second connection line 92 may be disposed in the (M+1)-th unit row, and only the fourth connection line 94 may be disposed in the (M+3)-th unit row.

In an exemplary implementation mode, since a power supply line is disposed in the second source-drain metal (SD2) layer and a connection line is disposed in the third source-drain metal (SD3) layer, the power supply line and the connection line may be connected to only one planarization layer via, thereby minimizing occupied space and facilitating achievement of high-resolution display.

In an exemplary implementation mode, at least one of the first connection line to the fourth connection line may extend to the bezel area, and connection lines with a same potential are connected together through a power supply trace in the bezel area.

In the exemplary implementation mode, although the present embodiment has been described by taking the first connection line to the fourth connection line all disposed in the sixth conductive layer as an example for description, the first connection line to the fourth connection line may be disposed in any one conductive layer or a plurality of conductive layers in the drive circuit layer. For example, one or more of the first connection line to fourth connection line may be disposed in the fifth conductive layer, and the first power supply line to fourth power supply line may be disposed in the sixth conductive layer, which is not limited here in the present disclosure.

In some possible exemplary implementation modes, one or more of the first connection line to fourth connection line may be disposed in the first conductive layer. For another example, one or more of the first connection line to the fourth connection line may be disposed in the second conductive layer. For another example, one or more of the first connection line to the fourth connection line may be disposed in the third conductive layer. Since the plurality of signal lines in these conductive layers have a line shape extending along the first direction X, it facilitates the arrangement of one or more connection lines.

In the exemplary implementation mode, although the present embodiment has been described by taking the first connection line to the fourth connection line all continuously disposed in the display area as an example for description, one or more of the first connection line to the fourth connection line may be disposed at intervals.

FIG. 18D is a schematic diagram showing connection of a connection line according to an embodiment of the present disclosure. In an exemplary implementation mode, the power supply line may include a first power supply line 81, a second power supply line 82, and a third power supply line 83, and the connection line may include a first connection line 91, a second connection line 92, and a third connection line 93. The first connection line 91 is connected to the first power supply line 81, the first power supply line 81 is connected to the first pixel drive circuit, the second connection line 92 is connected to the second power supply line 82, the second power supply line 82 is connected to the second pixel drive circuit and the fourth pixel drive circuit, respectively, the third connection line 93 is connected to the third power supply line 83, and the third power supply line 83 is connected to the third pixel drive circuit.

In an exemplary implementation mode, in at least one unit row, the first connection line 91, the second connection line 92, and the third connection line 93 may be periodically arranged in the first direction X. First connection lines 91, second connection lines 92, and third connection lines 93 in adjacent unit rows are arranged in a misaligned manner to form a misaligned stepped structure.

In an exemplary implementation mode, in each unit row, the first connection line 91 is respectively connected to two adjacent first power supply lines 81 in the first direction X, the second connection line 92 is respectively connected to two adjacent second power supply lines 82 in the first direction X, and the third connection line 93 is respectively connected to two adjacent third power supply lines 83 in the first direction X.

In an exemplary implementation mode, the first power supply line 81, the second power supply line 82, and the third power supply line 83 may extend to the bonding area or the Bezel area, and power supply lines with a same potential are connected together through the power supply trace in the bonding area or the Bezel area, so that connection lines with a same potential in the display area form a mesh structure.

In an exemplary implementation mode, the first connection line 91, the second connection line 92, and the third connection line 93 may be disposed in a same conductive layer, or may be disposed in different conductive layers.

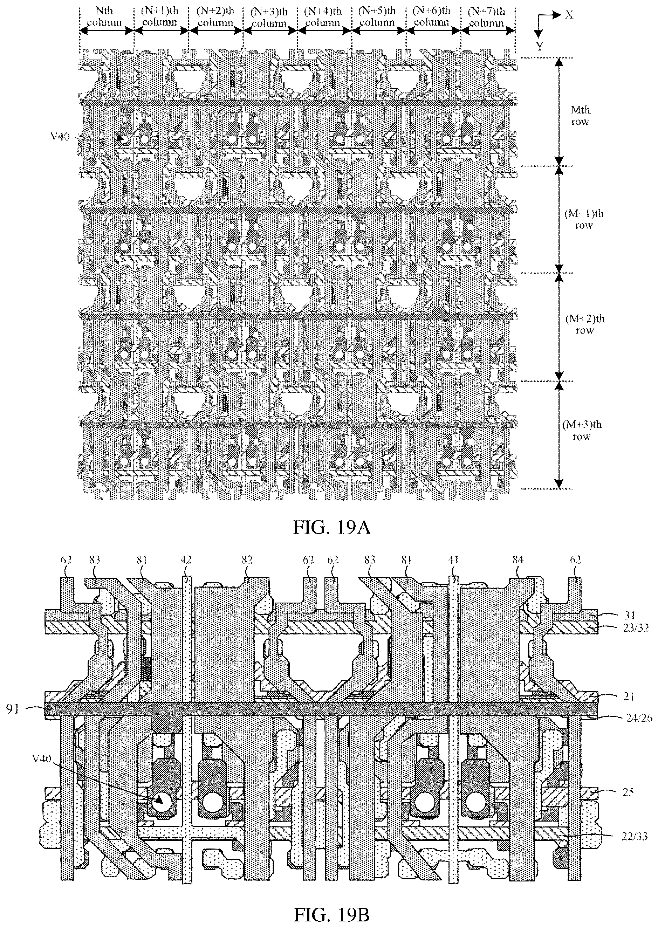

(12) Forming a pattern of a third planarization layer. In an exemplary implementation mode, forming the pattern of the third planarization layer may include: coating a third planarization thin film on the base substrate on which the above-mentioned patterns are formed, and patterning the third planarization thin film through a patterning process to form a third planarization layer covering the sixth conductive layer, wherein the third planarization layer is provided with a plurality of anode vias, as shown in FIG. 19A and FIG. 19B, and FIG. 19B is a schematic diagram of a structure of four circuit units in FIG. 19A.

In an exemplary implementation mode, an orthographic projection of the anode via V40 of each circuit unit on the base substrate is within a range of an orthographic projection of the anode connection electrode 63 on the base substrate, the third planarization layer within the anode via V40 is removed to expose a surface of the anode connection electrode 63, and the anode via V40 is configured such that an anode to be formed subsequently is connected to the anode connection electrode 63 through the anode via V40.

So far, a drive circuit layer has been manufactured on the base substrate. In a plane parallel to the display substrate, the drive circuit layer may include a plurality of circuit units, each of which may include a pixel drive circuit, and a first scan signal line, a second scan signal line, a third scan signal line, a fourth scan signal line, a light emitting signal line, a data signal line, a power supply line, a first initial signal line, a second initial signal line, and a third initial signal line connected to the pixel drive circuit. In a plane perpendicular to the display substrate, the drive circuit layer may include a first insulation layer, a first semiconductor layer, a second insulation layer, a first conductive layer, a third insulation layer, a second conductive layer, a fourth insulation layer, a second semiconductor layer, a fifth insulation layer, a third conductive layer, a sixth insulation layer, a fourth conductive layer, a first planarization layer, a fifth conductive layer, a second planarization layer, a sixth conductive layer, and a third planarization layer which are disposed sequentially on the base substrate. The first semiconductor layer may at least include active layers of a first transistor, a third transistor to an eighth transistor. The first conductive layer may at least include a first scan signal line, a second scan signal line, a third scan signal line, a light emitting signal line and a first plate of a storage capacitor. The second conductive layer may at least include a shield line, a first initial signal line, and a second plate of the storage capacitor, the second semiconductor layer may at least include an active layer of a second transistor. The third conductive layer may at least include a fourth scan signal line, a second initial signal line, and a third initial signal line. The fourth conductive layer may at least include a plurality of connection electrodes. The fifth conductive layer may at least include a data signal line and a power supply line. The sixth conductive layer may at least include an anode connection electrode and a connection line. Wherein the power supply line may include a first power supply line, a second power supply line, a third power supply line, and a fourth power supply line, and the connection line may include a first connection line, a second connection line, a third connection line, and a fourth connection line.

In an exemplary implementation mode, the base substrate may be a flexible base substrate, or a rigid base substrate. The rigid base substrate may include, but is not limited to, one or more of glass and quartz. The flexible base substrate may be made of, but is not limited to, one or more of polyethylene terephthalate, ethylene terephthalate, polyether ether ketone, polystyrene, polycarbonate, polyarylate, polyarylester, polyimide, polyvinyl chloride, polyethylene, and textile fiber. In an exemplary implementation mode, the flexible base substrate may include a first flexible material layer, a first inorganic material layer, a semiconductor layer, a second flexible material layer, and a second inorganic material layer which are stacked. Materials of the first flexible material layer and the second flexible material layer may be Polyimide (PI), Polyethylene Terephthalate (PET), or a surface-treated polymer soft film, etc., and materials of the first inorganic material layer and the second inorganic material layer may be Silicon Nitride (SiNx), Silicon Oxide (SiOx), or the like, for improving water and oxygen resistance of the base substrate. The first inorganic material layer and the second inorganic material layer may also be referred to as barrier layers, and a material of the semiconductor layer may be amorphous silicon (a-si).

In an exemplary implementation mode, the first conductive layer, the second conductive layer, the third conductive layer, the fourth conductive layer, the fifth conductive layer, and the sixth conductive layer may be made of a metal material, such as any one or more of Argentum (Ag), Copper (Cu), Aluminum (Al), and Molybdenum (Mo), or an alloy material of the above metals, such as an Aluminum Neodymium alloy (AlNd) or a Molybdenum Niobium alloy (MoNb), and may be of a single-layer structure or a multi-layer composite structure, such as Mo/Cu/Mo. The first insulation layer, the second insulation layer, the third insulation layer, the fourth insulation layer, the fifth insulation layer, and the sixth insulation layer may be made of any one or more of Silicon Oxide (SiOx), Silicon Nitride (SiNx), and Silicon OxyNitride (SiON), and may be a single layer, a plurality of layers, or a composite layer. The first planarization layer, the second planarization layer, and the third planarization layer may be made of an organic material, such as a resin.

In an exemplary implementation mode, after preparation of the drive circuit layer is completed, a light emitting structure layer is prepared on the drive circuit layer, and a preparation process of the light emitting structure layer may include following operations.

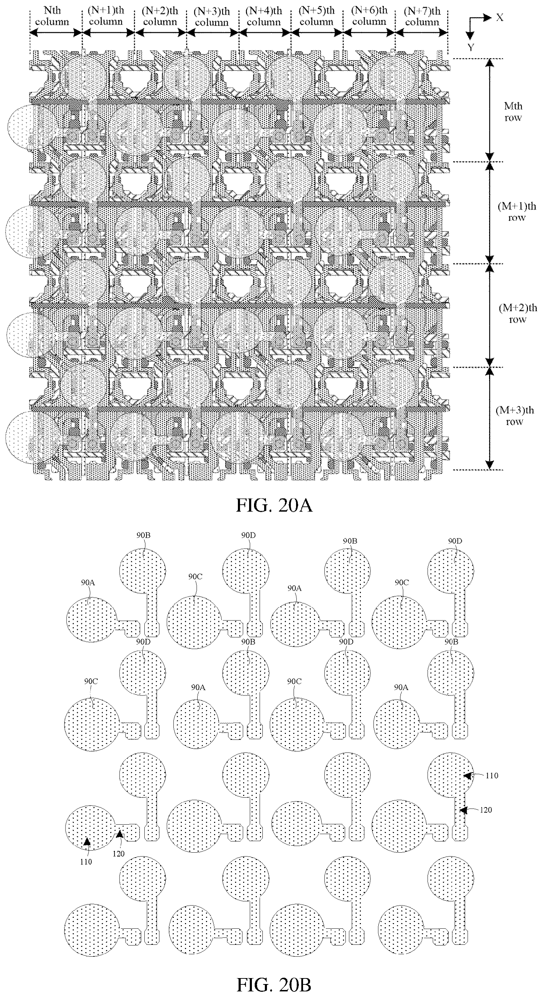

(13) Forming a pattern of an anode conductive layer. In an exemplary implementation mode, forming the pattern of the anode conductive layer may include: depositing an anode conductive thin film on the base substrate on which the aforementioned patterns are formed, and patterning the anode conductive thin film using a patterning process to form an anode conductive layer arranged on the third planarization layer, as shown in FIG. 20A and FIG. 20B, and FIG. 20B is a schematic plan view of the anode conductive layer in FIG. 20A.

In an exemplary implementation mode, the anode conductive layer may be of a single-layer structure, such as Indium Tin Oxide (ITO) or Indium Zinc Oxide (IZO), or may be of a multi-layer composite structure, such as ITO/Ag/ITO.

In an exemplary implementation mode, the anode conductive layer may include a first anode 90A located in a red light emitting unit, a second anode 90B located in a first green light emitting unit, a third anode 90C located in a blue light emitting unit, and a fourth anode 90D located in a second green light emitting unit, and the first anode 90A, the second anode 90B, the third anode 90C, and the fourth anode 90D may be connected to anode connection electrodes 63 of circuit units where these anodes are located through the anode vias V40, respectively.

In an exemplary implementation mode, at least one of the first anode 90A, the second anode 90B, the third anode 90C, and the fourth anode 90D may include a main body portion 110 and a connection portion 120 connected to each other, the main body portion 110 may be in a shape of a circle or an oval, the connection portion 120 may be in a shape of a strip, a first end of the connection portion 120 is directly connected to the main body portion 110, and a second end of the connection portion 120 is connected to an anode connection electrode 63 through an anode via V40 after extending toward a direction away from the main body portion 110.

In an exemplary implementation mode, the first anode 90A of the red light emitting unit is connected to the first pixel drive circuit of the first circuit unit, the second anode 90B of the first green light emitting unit is connected to the second pixel drive circuit of the second circuit unit, the third anode 90C of the blue light emitting unit is connected to the third pixel drive circuit of the third circuit unit, and the fourth anode 90D of the second green light emitting unit is connected to the fourth pixel drive circuit of the fourth circuit unit.

In an exemplary implementation mode, an orthographic projection of a main body portion 110 of the first anode 90A in the red light emitting unit on the base substrate is at least partially overlapped with an orthographic projection of a connected first pixel drive circuit on the base substrate. For example, a main body portion 110 of a first anode 90A in an odd-numbered light emitting row is at least partially overlapped with a first pixel drive circuit of the N-th unit column in the M-th unit row (or (M+2)-th unit row), a first end of a connection portion 120 of the first anode 90 A is directly connected to the main body portion 110, and a second end of the connection portion 120 is connected to the first pixel drive circuit of the N-th unit column. A main body portion 110 of a first anode 90A in another odd-numbered light emitting row is at least partially overlapped with a first pixel drive circuit of the (N+4)-th unit column in the M-th unit row (or (M+2)-th unit row), a first end of a connection portion 120 of the first anode 90 A is directly connected to the main body portion 110, and a second end of the connection portion 120 is connected to the first pixel drive circuit of the (N+4)-th unit column. For another example, a main body portion 110 of a first anode 90A in an even-numbered light emitting row is at least partially overlapped with a first pixel drive circuit of the (N+2)-th unit column in the (M+1)-th unit row (or the (M+3)-th unit row), a first end of a connection portion 120 of the first anode 90 A is directly connected to the main body portion 110, and a second end of the connection portion 120 is connected to the first pixel drive circuit of the (N+2)-th unit column. For example, a main body portion 110 of a first anode 90A in another even-numbered light emitting row is at least partially overlapped with a first pixel drive circuit of the (N+6)-th unit column in the (M+1)-th unit row (or the (M+3)-th unit row), a first end of a connection portion 120 of the first anode 90 A is directly connected to the main body portion 110, and a second end of the connection portion 120 is connected to the first pixel drive circuit of the (N+6)-th unit column.

In an exemplary implementation mode, an orthographic projection of a main body portion 110 of the second anode 90B in the first green light emitting unit on the base substrate is at least partially overlapped with an orthographic projection of a connected second pixel drive circuit on the base substrate. For example, a main body portion 110 of a second anode 90B in an odd-numbered light emitting row is at least partially overlapped with a second pixel drive circuit of the (N+1)-th unit column in the M-th unit row (or (M+2)-th unit row), a first end of a connection portion 120 of the second anode 90B is directly connected to the main body portion 110, and a second end of the connection portion 120 is connected to the second pixel drive circuit of the (N+1)-th unit column. A main body portion 110 of a second anode 90B in another odd-numbered light emitting row is at least partially overlapped with a second pixel drive circuit of the (N+5)-th unit column in the M-th unit row (or (M+2)-th unit row), a first end of a connection portion 120 of the second anode 90B is directly connected to the main body portion 110, and a second end of the connection portion 120 is connected to the second pixel drive circuit of the (N+5)-th unit column. For another example, a main body portion 110 of a second anode 90B in an even-numbered light emitting row is at least partially overlapped with a second pixel drive circuit of the (N+4)-th unit column in the (M+1)-th unit row (or the (M+3)-th unit row), a first end of a connection portion 120 of the second anode 90B is directly connected to the main body portion 110, and a second end of the connection portion 120 is connected to the second pixel drive circuit of the (N+4)-th unit column. A main body portion 110 of a second anode 90B in another even-numbered light emitting row is at least partially overlapped with a second pixel drive circuit of the (N+7)-th unit column in the (M+1)-th unit row (or (M+3)-th unit row), a first end of a connection portion 120 of the second anode 90B is directly connected to the main body portion 110, and a second end of the connection portion 120 is connected to the second pixel drive circuit of the (N+7)-th unit column.

In an exemplary implementation mode, an orthographic projection of a main body portion 110 of the third anode 90C in the blue light emitting unit on the base substrate is at least partially overlapped with an orthographic projection of a connected third pixel drive circuit on the base substrate. For example, a main body portion 110 of a third anode 90C in an odd-numbered light emitting row is at least partially overlapped with a third pixel drive circuit of the (N+2)-th unit column in the M-th unit row (or (M+2)-th unit row), a first end of a connection portion 120 of the third anode 90C is directly connected to the main body portion 110, and a second end of the connection portion 120 is connected to the third pixel drive circuit of the (N+3)-th unit column. A main body portion 110 of a third anode 90C in another odd-numbered light emitting row is at least partially overlapped with a third pixel drive circuit of the (N+6)-th unit column in the M-th unit row (or (M+2)-th unit row), a first end of a connection portion 120 of the third anode 90C is directly connected to the main body portion 110, and a second end of the connection portion 120 is connected to the third pixel drive circuit of the (N+6)-th unit column. For another example, a main body portion 110 of a third anode 90C in an even-numbered light emitting row is at least partially overlapped with a third pixel drive circuit of the N-th unit column in the (M+1)-th unit row (or the (M+3)-th unit row), a first end of a connection portion 120 of the third anode 90C is directly connected to the main body portion 110, and a second end of the connection portion 120 is connected to the third pixel drive circuit of the N-th unit column. A main body portion 110 of a third anode 90C in another odd-numbered light emitting row is at least partially overlapped with a third pixel drive circuit of the (N+4)-th unit column in the (M+1)-th unit row (or (M+3)-th unit row), a first end of a connection portion 120 of the third anode 90C is directly connected to the main body portion 110, and a second end of the connection portion 120 is connected to the third pixel drive circuit of the (N+4)-th unit column.

In an exemplary implementation mode, an orthographic projection of a main body portion 110 of the fourth anode 90D in the second green light emitting unit on the base substrate is at least partially overlapped with an orthographic projection of a connected fourth pixel drive circuit on the base substrate. For example, a main body portion 110 of a fourth anode 90D in an odd-numbered light emitting row is at least partially overlapped with a fourth pixel drive circuit of the (N+3)-th unit column in the M-th unit row (or (M+2)-th unit row), a first end of a connection portion 120 of the fourth anode 90D is directly connected to the main body portion 110, and a second end of the connection portion 120 is connected to the fourth pixel drive circuit of the (N+3)-th unit column. A main body portion 110 of a fourth anode 90D in another odd-numbered light emitting row is at least partially overlapped with a fourth pixel drive circuit of the (N+7)-th unit column in the M-th unit row (or (M+2)-th unit row), a first end of a connection portion 120 of the fourth anode 90D is directly connected to the main body portion 110, and a second end of the connection portion 120 is connected to the fourth pixel drive circuit of the (N+7)-th unit column. For another example, a main body portion 110 of a fourth anode 90D in an even-numbered light emitting row is at least partially overlapped with a fourth pixel drive circuit of the (N+1)-th unit column in the (M+1)-th unit row (or the (M+3)-th unit row), a first end of a connection portion 120 of the fourth anode 90D is directly connected to the main body portion 110, and a second end of the connection portion 120 is connected to the fourth pixel drive circuit of the (N+1)-th unit column. A main body portion 110 of a fourth anode 90D in another odd-numbered light emitting row is at least partially overlapped with a fourth pixel drive circuit of the (N+5)-th unit column in the (M+1)-th unit row (or (M+3)-th unit row), a first end of a connection portion 120 of the fourth anode 90D is directly connected to the main body portion 110, and a second end of the connection portion 120 is connected to the fourth pixel drive circuit of the (N+5)-th unit column.

In an exemplary implementation mode, a subsequent preparation process may include: forming a pattern of a pixel definition layer, wherein the pixel definition layer is provided with a plurality of pixel openings, and the plurality of pixel openings may expose surfaces of the first anode, the second anode, the third anode, and the fourth anode, respectively. Subsequently, an organic light emitting layer is formed using an evaporation process and an inkjet printing process, and then a cathode is formed on the organic light emitting layer. The light emitting structure layer has been prepared. Subsequently, an encapsulation structure layer is formed, and the encapsulation structure layer may include a first encapsulation layer, a second encapsulation layer, and a third encapsulation layer that are stacked. The first encapsulation layer and the third encapsulation layer may be made of an inorganic material, the second encapsulation layer may be made of an organic material, and the second encapsulation layer is disposed between the first encapsulation layer and the third encapsulation layer, which may ensure that external water vapor cannot enter the light emitting structure layer.

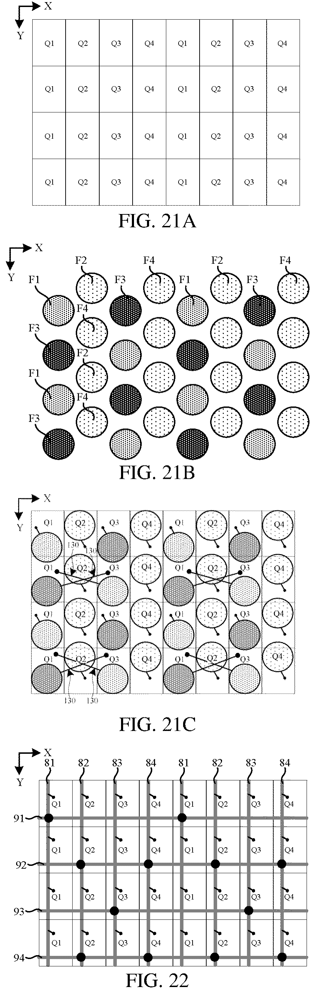

FIG. 21A is a schematic diagram of another arrangement of circuit units according to an exemplary embodiment of the present disclosure, FIG. 21B is a schematic diagram of another arrangement of light emitting units according to an exemplary embodiment of the present disclosure, and FIG. 21C is a schematic diagram of another connection between a circuit unit and a light emitting unit according to an exemplary embodiment of the present disclosure. As shown in FIGs. 21A, 21B, and 21C, on a plane parallel to the display substrate, the drive structure layer may include a plurality of circuit units, the light emitting structure layer may include a plurality of light emitting units, the plurality of circuit units may include a first circuit unit Q1, a second circuit unit Q2, a third circuit unit Q3, and a fourth circuit unit Q4, and the plurality of light emitting units may include a first light emitting unit F1, a second light emitting unit F2, a third light emitting unit F3, and a fourth light emitting unit F4.

In an exemplary implementation mode, in each unit row, the first circuit unit Q1, the second circuit unit Q2, the third circuit unit Q3, and the fourth circuit unit Q4 may be periodically arranged in the first direction X, that is, arrangement modes of circuit units of an odd-numbered unit row and an even-numbered unit row are the same, and a same circuit unit is disposed in each unit column. For example, a plurality of first circuit units Q1 are disposed in a first unit column, a plurality of second circuit units Q2 are disposed in a second unit column, a plurality of third circuit units Q3 are disposed in a third unit column, and a plurality of fourth circuit units Q4 are disposed in a fourth unit column.

In an exemplary implementation mode, in a light emitting row, the first light emitting unit F1, the second light emitting unit F2, the third light emitting unit F3, and the fourth light emitting unit F4 may be periodically arranged in the first direction X, and corresponding light emitting units of an odd-numbered light emitting row and an even-numbered light emitting row are staggered. In a light emitting column, the first light emitting unit F1 and the third light emitting unit F3 are alternately disposed in the second direction Y, and in another light emitting column, the second light emitting unit F2 and the fourth light emitting unit F4 are alternately disposed in the second direction Y.

In an exemplary implementation mode, a first light emitting device of the first light emitting unit F1 is connected to a first pixel drive circuit of the first circuit unit Q1. In a light emitting row (e.g. an odd-numbered light emitting row), a position where the first light emitting device is orthographically projected on the base substrate substantially corresponds to a position where a connected first pixel drive circuit is orthographically projected on the base substrate. In another light emitting row (e.g. an even-numbered light emitting row), the position where the first light emitting device is orthographically projected on the base substrate does not correspond to the position where the connected first pixel drive circuit is orthographically projected on the base substrate, the position where the first light emitting device is orthographically projected on the base substrate substantially corresponds to a position where a third pixel drive circuit of the third circuit unit Q3 is orthographically projected on the base substrate. The first light emitting device is connected to the first pixel drive circuit of the first circuit unit Q1 through an anode transfer line 130.

In an exemplary implementation mode, a third light emitting device of the third light emitting unit F3 is connected to the third pixel drive circuit of the third circuit unit Q3. In a light emitting row (e.g. an odd-numbered light emitting row), a position where the third light emitting device is orthographically projected on the base substrate substantially corresponds to a position where a connected third pixel drive circuit is orthographically projected on the base substrate. In another light emitting row (e.g. an even-numbered light emitting row), the position where the third light emitting device is orthographically projected on the base substrate does not correspond to the position where the connected third pixel drive circuit is orthographically projected on the base substrate, the position where the third light emitting device is orthographically projected on the base substrate substantially corresponds to a position where the first pixel drive circuit of the first circuit unit Q1 is orthographically projected on the base substrate. The third light emitting device is connected to the third pixel drive circuit of the third circuit unit Q3 through an anode transfer line 130.

In an exemplary implementation mode, a second light emitting device of the second light emitting unit F2 is connected to a second pixel drive circuit of the second circuit unit Q2 or a fourth pixel drive circuit of the fourth circuit unit Q4. In a light emitting row (e.g. an odd-numbered light emitting row), a position where the second light emitting device is orthographically projected on the base substrate substantially corresponds to a position where a connected second pixel drive circuit is orthographically projected on the base substrate. In another light emitting row (e.g. an even-numbered light emitting row), the position where the second light emitting device is orthographically projected on the base substrate substantially corresponds to a position where a connected fourth pixel drive circuit is orthographically projected on the base substrate.

In an exemplary implementation mode, a fourth light emitting device of the fourth light emitting unit F4 is connected to the second pixel drive circuit of the second circuit unit Q2 or the fourth pixel drive circuit of the fourth circuit unit Q4. In one light emitting row (e.g. an odd-numbered light emitting row), the position where the fourth light emitting device is orthographically projected on the base substrate substantially corresponds to the position where the connected fourth pixel drive circuit is orthographically projected on the base substrate. In another light emitting row (e.g. an even-numbered light emitting row), the position where the fourth light emitting device is orthographically projected on the base substrate substantially corresponds to the position where the connected second pixel drive circuit is orthographically projected on the base substrate.

FIG. 22 is a schematic diagram of another connection of a power supply line and a connection line in a display substrate according to an exemplary embodiment of the present disclosure. As shown in FIG. 22, in an exemplary embodiment of the present disclosure, the power supply line may include a first power supply line 81, a second power supply line 82, a third power supply line 83, and a fourth power supply line 84, and the connection line may include a first connection line 91, a second connection line 92, a third connection line 93, and a fourth connection line 94.

In an exemplary implementation mode, any one or more of the first power supply line 81, the second power supply line 82, the third power supply line 83, and the fourth power supply line 84 may be disposed in at least one unit column.

In an exemplary implementation mode, the first power supply line 81, the second power supply line 82, the third power supply line 83, and the fourth power supply line 84 may be in a shape of a straight line or a polyline with a main body portion extending along the second direction Y, and the first connection line 91, the second connection line 92, the third connection line 93, and the fourth connection line 94 may be in a shape of a straight line or a polyline with a main body portion extending along the first direction X.

In an exemplary implementation mode, the first power supply line 81 may be separately disposed in a unit column including the first circuit unit Q1, the second power supply line 82 may be separately disposed in a unit column including the second circuit unit Q2, the third power supply line 83 may be separately disposed in a unit column including the third circuit unit Q3, and the fourth power supply line 84 may be separately disposed in a unit column including the fourth circuit unit Q4, respectively forming a unit column with a single power supply line structure.

In an exemplary implementation mode, the first power supply line 81 is respectively connected to first pixel drive circuits of a plurality of first circuit units Q1 in a unit column where the first power supply line 81 is located, the second power supply line 82 is respectively connected to second pixel drive circuits of a plurality of second circuit units Q2 in a unit column where the second power supply line 82 is located, the third power supply line 83 is respectively connected to third pixel drive circuits of a plurality of third circuit units Q3 in a unit column where the third power supply line 83 is located, and the fourth power supply line 84 is respectively connected to fourth pixel drive circuits of a plurality of fourth circuit units Q4 in a unit column where the fourth power supply line 84 is located.

In an exemplary implementation mode, any one or more of the first connection line 91, the second connection line 92, the third connection line 93, and the fourth connection line 94 may be disposed in at least one unit row.

In an exemplary implementation mode, the first connection line 91 may be disposed in one unit row and connected to a plurality of first power supply lines 81, respectively, to achieve a mutual connection of the first connection line 91 whose main body portion extends along the first direction X and the first power supply line 81 whose main body portion extends along the second direction Y to constitute a grid communication structure. The second connection line 92 may be disposed in another unit row and connected to a plurality of second power supply lines 82 and a plurality of fourth power supply lines 84, respectively, to achieve a mutual connection of the second connection line 92 whose main body portion extends along the first direction X and the second power supply lines 82 and the fourth power supply lines 84 whose main body portions extend along the second direction Y to constitute a grid communication structure. The third connection line 93 may be disposed in yet another unit row and connected to a plurality of third power supply lines 83, respectively, to achieve a mutual connection of the third connection line 93 whose main body portion extends along the first direction X and the first power supply line 83 whose main body portion extends along the second direction Y to constitute a grid communication structure. The fourth connection line 94 may be disposed in still another unit row and connected to the plurality of second power supply lines 82 and the plurality of fourth power supply lines 84, respectively, to achieve a mutual connection of the fourth connection line 94 whose main body portion extends along the first direction X and the second power supply line 82 and the fourth power supply line 84 whose main body portions extend along the second direction Y to constitute a grid communication structure.

In an exemplary implementation mode, potentials of the first power supply line 81, the second power supply line 82, and the third power supply line 83 may be different, and potentials of the second power supply line 82 and the fourth power supply line 84 may be the same.

In an exemplary implementation mode, the first power supply line 81, the second power supply line 82, the third power supply line 83, and the fourth power supply line 84 may be disposed in a same conductive layer, or may be disposed in different conductive layers.

**In** an exemplary implementation mode, the first connection line 91, the second connection line 92, the third connection line 93, and the fourth connection line 94 may be disposed in a same conductive layer, or may be disposed in different conductive layers.

**In** an exemplary implementation mode, the plurality of conductive layers may at least include a first source-drain metal layer, a second source-drain metal layer, and a third source-drain metal layer disposed sequentially along a direction away from the base substrate, the first power supply line 81, the second power supply line 82, the third power supply line 83, and the fourth power supply line 84 may be disposed in the second source-drain metal layer, and the first connection line 91, the second connection line 92, the third connection line 93, and the fourth connection line 94 may be disposed in the third source-drain metal layer.

In an exemplary implementation mode, taking thirty-two circuit units (four unit rows and eight unit columns) as an example, a preparation process of the display substrate according to the present embodiment may include following operations.

(21) Patterns of a first semiconductor layer, a first conductive layer, a second conductive layer, a second semiconductor layer, a third conductive layer, and a sixth insulation layer are sequentially formed, and a processing process and a formed structure are substantially the same as those of steps (1) to (6) of the aforementioned embodiments.

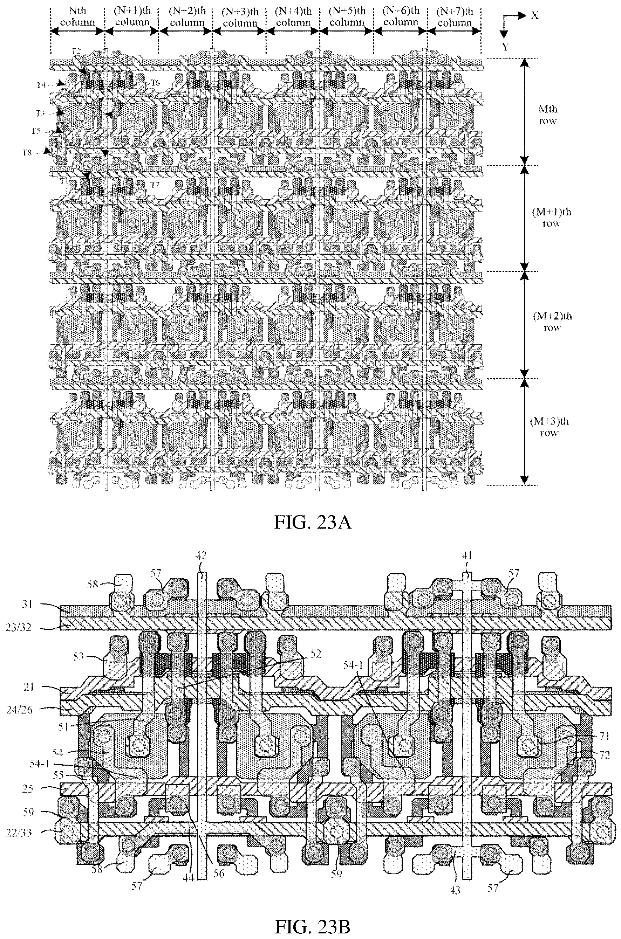

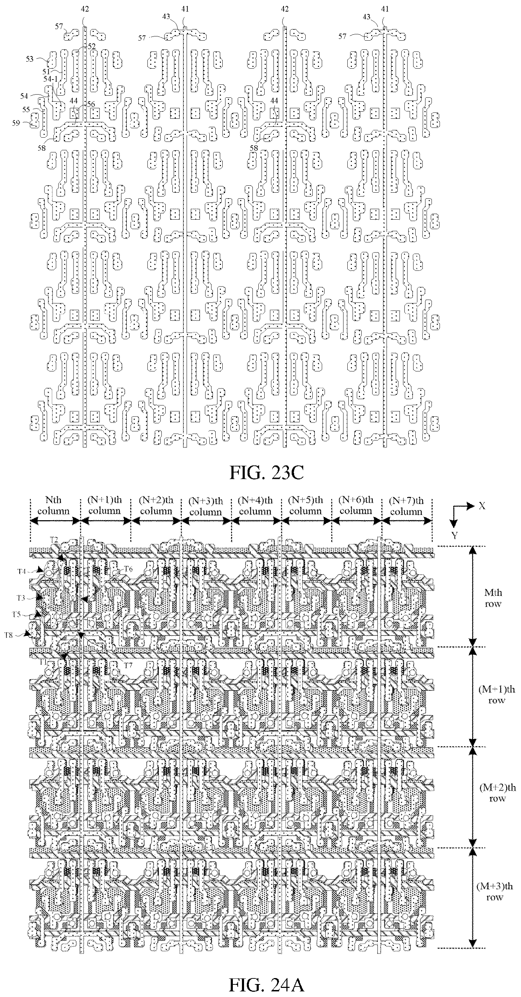

(22) Forming a pattern of a fourth conductive layer. In an exemplary implementation mode, forming the pattern of the fourth conductive layer may include: depositing a fourth conductive thin film on the base substrate on which the aforementioned pattern is formed, patterning the fourth conductive thin film through a patterning process to form a fourth conductive layer disposed on the sixth insulation layer, as shown in FIGs. 23A, 23B, and 23C, wherein FIG. 23B is a schematic diagram of a structure of four circuit units in FIG. 23A, and FIG. 23C is a schematic plan view of the fourth conductive layer in FIG. 23A.

In an exemplary implementation mode, the fourth conductive layer of each circuit unit at least includes: a first connection electrode 51, a second connection electrode 52, a third connection electrode 53, a fourth connection electrode 54, a fifth connection electrode 55, a sixth connection electrode 56, a seventh connection electrode 57, an eighth connection electrode 58 and a ninth connection electrode 59. Positions and shapes of the above connection electrodes are substantially the same as those of the aforementioned embodiments, except that positions and shapes of power supply connection blocks 54-1 in the first circuit unit, the second circuit unit, the third circuit unit, and the fourth circuit unit may be substantially the same, and all of them are disposed between first ends and second ends of fourth connection electrodes 54.

In an exemplary implementation mode, the fourth conductive layer may further include a first initial connection line 41, a second initial connection line 42, a first initial connection strip 43, and a second initial connection strip 44, and positions and shapes of the above connection electrodes are substantially the same as those of the aforementioned embodiments.

In an exemplary implementation mode, fourth conductive layers of some adjacent unit columns may be mirror symmetric with respect to a column dividing line. For example, a fourth semiconductor layer in the N-th unit column and a fourth semiconductor layer in the (N+1)-th unit column may be mirror symmetric with respect to a column dividing line. For another example, a fourth conductive layer in the (N+2)-th unit column and a fourth conductive layer in the (N+3)-th unit column may be mirror symmetric with respect to a column dividing line. For another example, a fourth conductive layer in the (N+4)-th unit column and a fourth conductive layer in the (N+5)-th unit column may be mirror symmetric with respect to a column dividing line.

In an exemplary implementation mode, shapes of fourth conductive layers in a plurality of unit rows may be substantially the same.

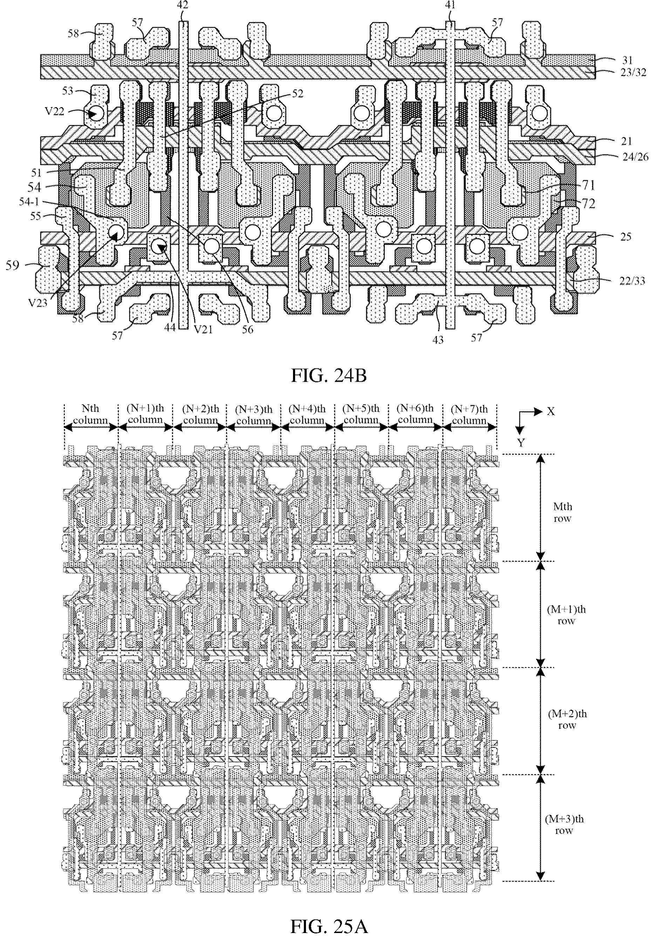

(23) forming a pattern of a first planarization layer, a processing process and a formed via structure are substantially the same as those in step (8) of the aforementioned embodiment, a plurality of vias in each circuit unit at least include a twenty-first via V21, a twenty-second via V22, and a twenty-third via V23, and a via structure is substantially the same as that in the aforementioned embodiment, as shown in FIGs. 24A and 24B, and FIG. 24B is a schematic diagram of a structure of four circuit units in FIG. 24A.

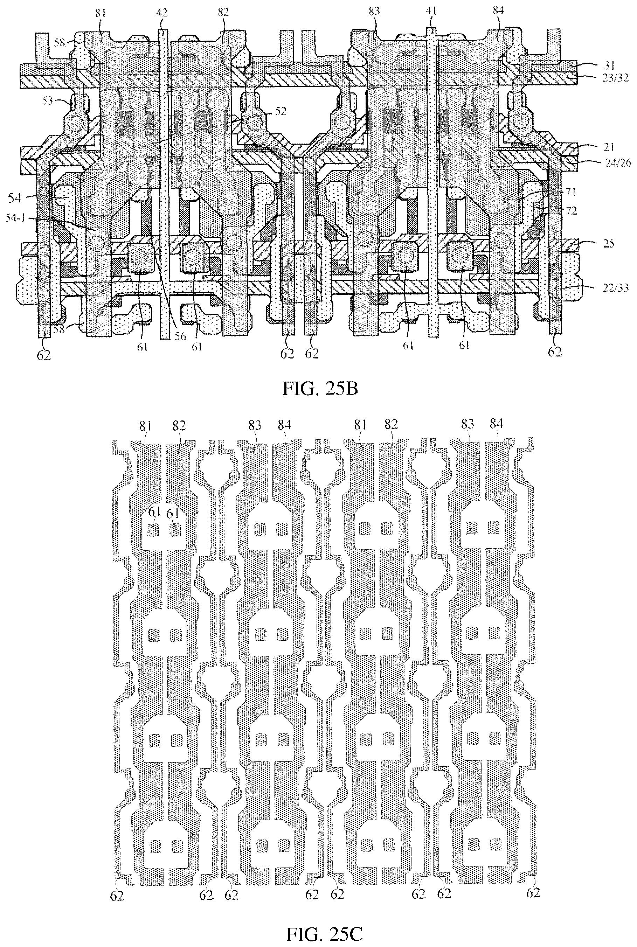

(24) Forming a pattern of a fifth conductive layer. In an exemplary implementation mode, forming the fifth conductive layer may include: depositing a fifth conductive thin film on the base substrate on which the aforementioned patterns are formed, and patterning the fifth conductive thin film using a patterning process to form a fifth conductive layer disposed on the first planarization layer, as shown in FIGs. 25A, 25B and 25C, wherein FIG. 25B is a schematic diagram of a structure of four circuit units in FIG. 25A, and FIG. 25C is a schematic plan view of the fifth conductive layer in FIG. 25A.

In an exemplary implementation mode, the fifth conductive layer of each circuit unit at least includes an eleventh connection electrode 61 and a data signal line 62, and structures of the eleventh connection electrode 61 and the data signal line 62 are substantially the same as those of the aforementioned embodiment.

In an exemplary implementation mode, the fifth conductive layer may further include a first power supply line 81, a second power supply line 82, a third power supply line 83, and a fourth power supply line 84, and each power supply line may be in a shape of a polyline with a main body portion extending along the second direction Y, and are respectively connected to the power supply connection blocks 54-1 through twenty-third vias V23 of corresponding circuit units, thus achieving that a power supply line writes a power supply signal to a first electrode of a fifth transistor T5 and a second plate 72 of a storage capacitor in the corresponding circuit unit.

In an exemplary implementation mode, the first power supply line 81, the second power supply line 82, the third power supply line 83, and the fourth power supply line 84 may be polylines with unequal widths, which may not only facilitates a layout of a pixel structure, but also reduce a parasitic capacitance between a power supply line and a data signal line.

In an exemplary implementation mode, any one or more of the first power supply line 81, the second power supply line 82, the third power supply line 83, and the fourth power supply line 84 are disposed in at least one unit column. For example, four power supply lines may be disposed in different unit columns, respectively. For another example, two power supply lines of the four power supply lines may be disposed in a same unit column.

In the exemplary embodiment, since same first circuit units are disposed in one unit column, the first power supply line 81 may be separately disposed in one unit column, and the first power supply line 81 is connected to pixel drive circuits of all the first circuit units in the unit column. Since same second circuit units are disposed in one unit column, the second power supply line 82 may be separately disposed in one unit column, and the second power supply line 82 is connected to pixel drive circuits of all the second circuit units in the unit column. Since same third circuit units are disposed in one unit column, the third power supply line 83 may be separately disposed in one unit column, and the third power supply line 83 is connected to pixel drive circuits of all the third circuit units in the unit column. Since same fourth circuit units are disposed in one unit column, the fourth power supply line 84 may be separately disposed in one unit column, and the fourth power supply line 84 is connected to pixel drive circuits of all the fourth circuit units in the unit column.

In an exemplary implementation mode, the first power supply line 81 may be disposed in the N-th unit column and the (N+4)-th unit column, the second power supply line 82 may be disposed in the (N+1)-th unit column and the (N+5)-th unit column, the third power supply line 83 may be disposed in the (N+2)-th unit column and the (N+6)-th unit column, and the fourth power supply line 84 may be disposed in the (N+3)-th unit column and the (N+7)-th unit column. In the above unit columns, a single power supply line structure is formed. As described above, the first power supply line 81, the second power supply line 82, the third power supply line 83, and the fourth power supply line 84 are periodically arranged along the first direction X.

In an exemplary implementation mode, an orthographic projection of at least one of the first power supply line 81, the second power supply line 82, the third power supply line 83, and the fourth power supply line 84 on the base substrate is at least partially overlapped with an orthographic projection of the first connection electrode 51 on the base substrate, and a power supply line with a constant potential can effectively block from the influence of the data voltage jump and other signals on the first node N1 in the pixel drive circuit, avoid the influence of the data voltage jump and other signals on the potential of the first node N1, and improve the driving performance of the pixel drive circuit.

In an exemplary implementation mode, an orthographic projection of at least one of the first power supply line 81, the second power supply line 82, the third power supply line 83, and the fourth power supply line 84 on the base substrate is at least partially overlapped with an orthographic projection of the second active layer on the base substrate, so that a power supply line may shield the second active layer, may block light emitted by a light emitting device and light reflected by a film layer from irradiating the second transistor T2 of oxide, may prevent the oxide transistor from characteristic drift due to illumination, thus improving electrical characteristics of the oxide transistor.

In an exemplary implementation mode, an orthographic projection of at least one of the first power supply line 81, the second power supply line 82, the third power supply line 83, and the fourth power supply line 84 on the base substrate is at least partially overlapped with an orthographic projection of the second connection electrode 52 on the base substrate.

In an exemplary implementation mode, fifth conductive layers of adjacent unit columns may be mirror symmetric with respect to a column dividing line. For example, a fourth semiconductor layer in the N-th unit column and a fourth semiconductor layer in the (N+1)-th unit column may be mirror symmetric with respect to a column dividing line. For another example, the fourth conductive layer in the (N+1)-th unit column and a fourth conductive layer in the (N+2)-th unit column may be mirror symmetric with respect to a column dividing line. For another example, the fourth conductive layer in the (N+2)-th unit column and a fourth conductive layer in the (N+3)-th unit column may be mirror symmetric with respect to a column dividing line.

In an exemplary implementation mode, shapes of fourth conductive layers in a plurality of unit rows may be substantially the same.

(25) Forming a pattern of a second planarization layer, a processing process and a formed via structure are substantially the same as those in step (10) of the aforementioned embodiment, a plurality of vias in each circuit unit at least include a thirty-first via V31, and the second planarization layer of at least one circuit unit may be further provided with a forty-first via V41, a forty-second via V42, a forty-third via V43, or a forty-fourth via V44, and the above via structure is substantially the same as that of the aforementioned embodiment.

In an exemplary implementation mode, only the forty-first via V41 or only the forty-third via V43 may be disposed in a plurality of circuit units in at least one unit row, the forty-second via V42 and the forty-fourth via V44 may be disposed in a plurality of circuit units in at least another unit row, and only the forty-first via V41, the forty-second via V42, the forty-third via V43, or the forty-fourth via V44 may be disposed in a plurality of circuit units in at least one unit column.

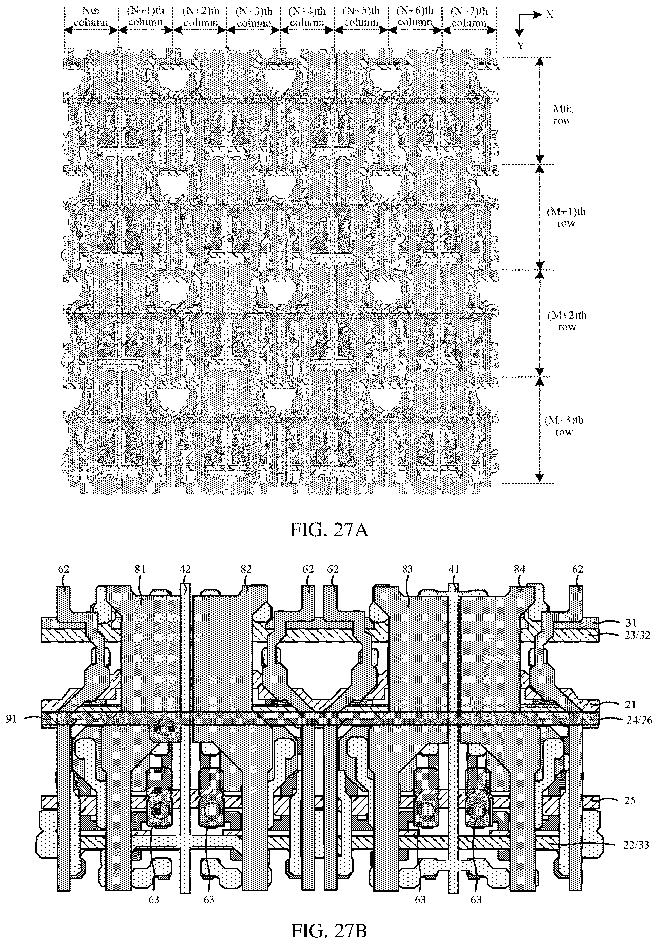

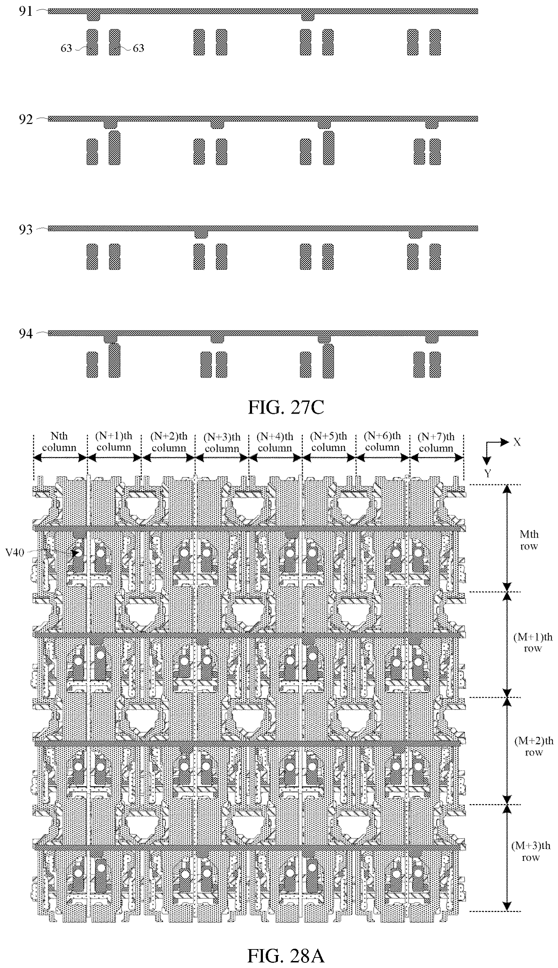

(26) Forming a pattern of a sixth conductive layer. In an exemplary implementation mode, forming the pattern of the sixth conductive layer may include: depositing a sixth conductive thin film on the base substrate on which the aforementioned patterns are formed, patterning the sixth conductive thin film using a patterning process to form a sixth conductive layer disposed on the second planarization layer, as shown in FIGs. 27A, 27B, and 27C, wherein FIG. 27B is a schematic diagram of a structure of four circuit units in FIG. 27A, and FIG. 27C is a schematic plan view of the sixth conductive layer in FIG. 27A.

In an exemplary implementation mode, the sixth conductive layer of each circuit unit at least includes an anode connection electrode 63, and a shape and position of the anode connection electrode 63 are basically the same as those of the aforementioned embodiment, except that a length of the anode connection electrode 63 in some circuit units is larger than that of the anode connection electrode 63 in other circuit units, and the length is a dimension of the anode connection electrode 63 in the second direction Y.

In an exemplary implementation mode, the sixth conductive layer of at least one circuit unit may be further provided with a first connection line 91, a second connection line 92, a third connection line 93, or a fourth connection line 94. Positions, shapes and connection structures of the above connection lines are substantially the same as those of the aforementioned embodiments. The first power supply line 81 and the first connection line 91 constitute a grid communication structure for transmitting a first power supply signal on the display substrate, the second power supply line 82 and the second connection line 92 constitute a grid communication structure for transmitting a second power supply signal on the display substrate, the third power supply line 83 and the third connection line 93 constitute a grid communication structure for transmitting a third power supply signal on the display substrate, and the fourth power supply line 84 and the fourth connection line 94 constitute a grid communication structure for transmitting a fourth power supply signal on the display substrate.

In an exemplary implementation mode, in at least one unit row, the second connection line 92 is further connected to the plurality of fourth power supply lines 84 through the plurality of forty-fourth vias V44, and the fourth connection line 94 is further connected to the plurality of second power supply lines 82 through the plurality of forty-second vias V42, so that the second power supply line 82 and the fourth power supply line 84 have a same potential.

In an exemplary implementation mode, only one connection line may be disposed in one unit row, or two connection lines may be disposed in one unit row. For example, the first connection line 91 and the third connection line 93 may be disposed in the M-th unit row. For another example, the first connection line 91 and the third connection line 93 may be disposed in the (M+2)-th unit row.

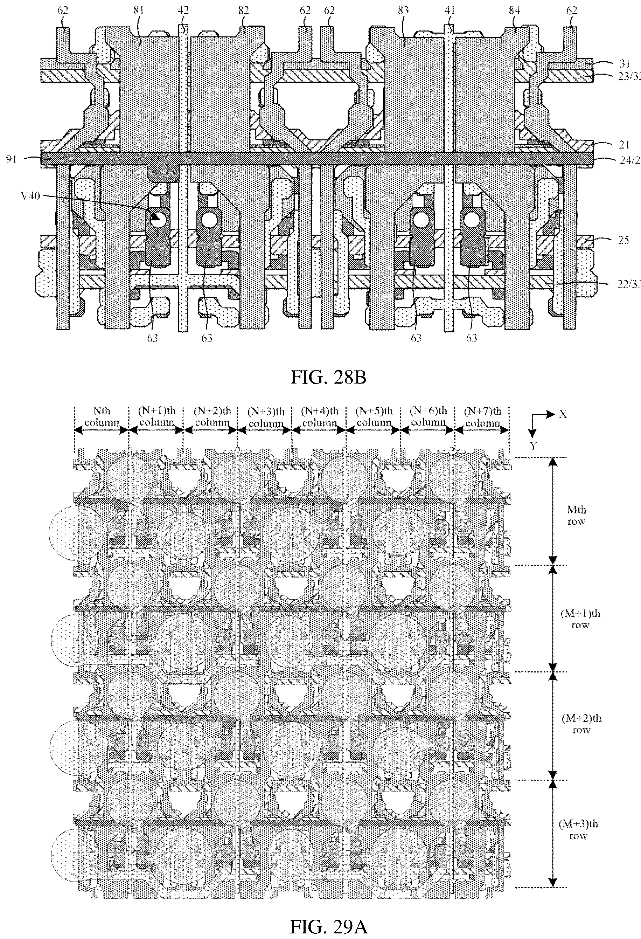

(27) Forming a pattern of a third planarization layer, a processing process and a formed via structure are substantially the same as those in step (12) of the aforementioned embodiment, and a plurality of anode vias V40 are provided on the third planarization layer, as shown in FIGs. 28A and 28B, and FIG. 28B is a schematic diagram of a structure of four circuit units in FIG. 28A.

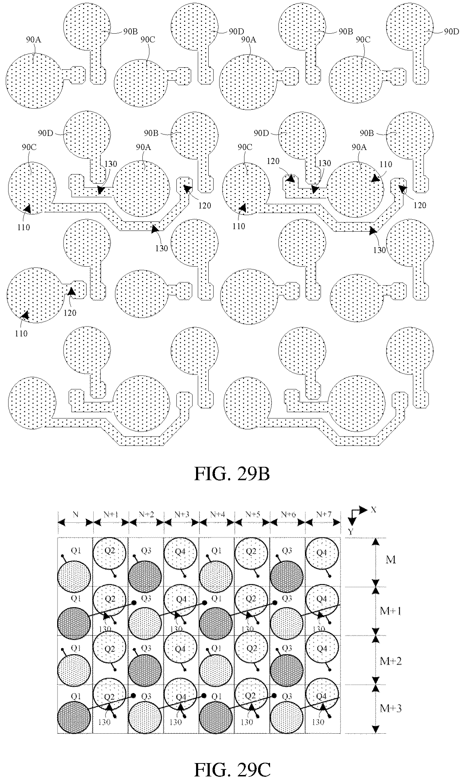

(28) Forming a pattern of an anode conductive layer. In an exemplary implementation mode, forming the pattern of the anode conductive layer may include: depositing an anode conductive thin film on the base substrate on which the aforementioned patterns are formed, and patterning the anode conductive thin film using a patterning process to form an anode conductive layer arranged on the third planarization layer, as shown in FIG. 29A and FIG. 29B, and FIG. 29B is a schematic plan view of the sixth conductive layer in FIG. 29A.

In an exemplary implementation mode, the anode conductive layer may include a first anode 90A located in a red light emitting unit, a second anode 90B located in a first green light emitting unit, a third anode 90C located in a blue light emitting unit, and a fourth anode 90D located in a second green light emitting unit, and the first anode 90A, the second anode 90B, the third anode 90C, and the fourth anode 90D may be connected to anode connection electrodes 63 of circuit units where these anodes are located through an anode vias V40, respectively.

In an exemplary implementation mode, at least one of the first anode 90A, the second anode 90B, the third anode 90C, and the fourth anode 90D may include a main body portion 110 and a connection portion 120, the main body portion 110 may be in a shape of a circle or an oval, the connection portion 120 may be in a shape of a strip, a first end of the connection portion 120 is directly connected to the main body portion 110, or a first end of the connection portion 120 is connected to the main body portion 110 through an anode transfer line 130, and a second end of the connection portion 120 is connected to an anode connection electrode 63 through an anode via V40.

In an exemplary implementation mode, the first anode 90A of the red light emitting unit is connected to the first pixel drive circuit of the first circuit unit.

In an exemplary implementation mode, in a light emitting row (e.g., an odd-numbered light emitting row), orthographic projections of main body portions 110 of at least some first anodes 90A on the base substrate are at least partially overlapped with orthographic projections of connected first pixel drive circuits on the base substrate. For example, a main body portion 110 of a first anode 90A in an odd-numbered light emitting row is at least partially overlapped with a first pixel drive circuit of the N-th unit column in the M-th unit row (or (M+2)-th unit row), a first end of a connection portion 120 of the first anode 90 A is directly connected to the main body portion 110, and a second end of the connection portion 120 is connected to the first pixel drive circuit of the N-th unit column. For another example, the main body portion 110 of the first anode 90A in an odd-numbered light emitting row is at least partially overlapped with a first pixel drive circuit of the (N+4)-th unit column in the M-th unit row (or (M+2)-th unit row), a first end of a connection portion 120 of the first anode 90A is directly connected to the main body portion 110, and a second end of the connection portion 120 is connected to the first pixel drive circuit of the (N+4)-th unit column.

In an exemplary implementation mode, in another light emitting row (e.g., an even-numbered light emitting row), orthographic projections of main body portions 110 of at least some first anodes 90A on the base substrate are not overlapped with orthographic projections of connected first pixel drive circuits on the base substrate. For another example, a main body portion 110 of a first anode 90A in an even-numbered light emitting row is not overlapped with a first pixel drive circuit of the N-th unit column in the (M+1)-th unit row (or the (M+3)-th unit row), a first end of a connection portion 120 of the first anode 90A is connected to the main body portion 110 through an anode transfer line 130, and a second end of the connection portion 120 is connected to the first pixel drive circuit of the N-th unit column. A first end of the anode transfer line 130 is connected to a main body portion 110, and a second end of the anode transfer line 130 is connected to the first end of the connection portion 120 after the anode transfer line 130 extends from the (N+2)-th unit column to the N-th unit column. For another example, a main body portion 110 of a first anode 90A in an even-numbered light emitting row is not overlapped with a first pixel drive circuit of the (N+4)-th unit column in the (M+1)-th unit row (or the (M+3)-th unit row), a first end of a connection portion 120 of the first anode 90A is connected to a main body portion 110 through an anode transfer line 130, and a second end of the connection portion 120 is connected to the first pixel drive circuit of the (N+4)-th unit column. A first end of the anode transfer line 130 is connected to a main body portion 110, and a second end of the anode transfer line 130 is connected to the first end of the connection portion 120 after the anode transfer line 130 extends from the (N+6)-th unit column to the (N+4)-th unit column.

In an exemplary implementation mode, orthographic projections of main body portions 110 of at least some first anodes 90A on the base substrate are at least partially overlapped with orthographic projections of the third pixel drive circuits of the third circuit units on the base substrate.

In an exemplary implementation mode, an orthographic projection of the anode transfer line 130 to which the first anode 90A is connected on the base substrate is at least partially overlapped with an orthographic projection of the second pixel drive circuit of the second circuit unit.

In an exemplary implementation mode, the third anode 90C of the blue light emitting unit is connected to the third pixel drive circuit of the third circuit unit.

In an exemplary implementation mode, in one light emitting row (e.g., odd-numbered light emitting row), orthographic projections of main body portions 110 of at least some third anodes 90C on the base substrate are at least partially overlapped with orthographic projections of connected third pixel drive circuits on the base substrate. For example, a main body portion 110 of a third anode 90C in an odd-numbered light emitting row is at least partially overlapped with a third pixel drive circuit of the (N+2)-th unit column in the M-th unit row (or (M+2)-th unit row), a first end of a connection portion 120 of the third anode 90C is directly connected to the main body portion 110, and a second end of the connection portion 120 is connected to the third pixel drive circuit of the (N+3)-th unit column. For another example, a main body portion 110 of a third anode 90C in an odd-numbered light emitting row is at least partially overlapped with a third pixel drive circuit of the (N+6)-th unit column in the M-th unit row (or (M+2)-th unit row), a first end of a connection portion 120 of the third anode 90C is directly connected to the main body portion 110, and a second end of the connection portion 120 is connected to the third pixel drive circuit of the (N+6)-th unit column.

In an exemplary implementation mode, in another light emitting row (e.g., an even-numbered light emitting row), orthographic projections of main body portions 110 of at least some third anodes 90C on the base substrate are not overlapped with orthographic projections of connected third pixel drive circuits on the base substrate. For example, a main body portion 110 of a third anode 90C in an odd-numbered light emitting row is not overlapped with a third pixel drive circuit of the (N+2)-th unit column in the (M+1)-th unit row (or (M+3)-th unit row), a first end of a connection portion 120 of the third anode 90C is connected to the main body portion 110 through an anode transfer line 130, and a second end of the connection portion 120 is connected to the third pixel drive circuit of the (N+2)-th unit column. A first end of the anode transfer line 130 is connected to the main body portion 110, and a second end of the anode transfer line 130 is connected to the first end of the connection portion 120 after the anode transfer line 130 extends from the N-th unit column to the (N+2)-th unit column. For another example, a main body portion 110 of a third anode 90C in an even-numbered light emitting row is not overlapped with a third pixel drive circuit of the (N+6)-th unit column in the (M+1)-th unit row (or the (M+3)-th unit row), a first end of a connection portion 120 of the third anode 90C is connected to the main body portion 110 through an anode transfer line 130, and a second end of the connection portion 120 is connected to the third pixel drive circuit of the (N+6)-th unit column. A first end of the anode transfer line 130 is connected to the main body portion 110, and a second end of the anode transfer line 130 is connected to the first end of the connection portion 120 after the anode transfer line 130 extends from the (N+4)-th unit column to the (N+6)-th unit column.

In an exemplary implementation mode, an orthographic projection of the main body portion 110 of the third anode 90C on the base substrate is at least partially overlapped with an orthographic projection of the first pixel drive circuit of the first circuit unit on the base substrate.

In an exemplary implementation mode, an orthographic projection of the anode transfer line 130 to which the third anode 90C is connected on the base substrate is at least partially overlapped with an orthographic projection of the fourth pixel drive circuit of the fourth circuit unit.

In an exemplary implementation mode, the second anode 90B of the first green light emitting unit is connected to the second pixel drive circuit of the second circuit unit or the fourth pixel drive circuit of the fourth circuit unit.

In an exemplary implementation mode, in one light emitting row (e.g., odd-numbered light emitting row), orthographic projections of main body portions 110 of at least some second anodes 90B on the base substrate are at least partially overlapped with orthographic projections of connected second pixel drive circuits on the base substrate. For example, a main body portion 110 of a second anode 90B in an odd-numbered light emitting row is at least partially overlapped with a second pixel drive circuit of the (N+1)-th unit column in the M-th unit row (or (M+2)-th unit row), a first end of a connection portion 120 of the second anode 90B is directly connected to the main body portion 110, and a second end of the connection portion 120 is connected to the second pixel drive circuit of the (N+1)-th unit column. For another example, a main body portion 110 of a second anode 90B in another odd-numbered light emitting row is at least partially overlapped with a second pixel drive circuit of the (N+5)-th unit column in the M-th unit row (or (M+2)-th unit row), a first end of a connection portion 120 of the second anode 90B is directly connected to the main body portion 110, and a second end of the connection portion 120 is connected to the second pixel drive circuit of the (N+5)-th unit column.

In an exemplary implementation mode, in another light emitting row (e.g., even-numbered light emitting row), orthographic projections of main body portions 110 of at least some second anodes 90B on the base substrate are at least partially overlapped with orthographic projections of connected fourth pixel drive circuits on the base substrate. For example, a main body portion 110 of a second anode 90B in an even-numbered light emitting row is at least partially overlapped with a fourth pixel drive circuit of the (N+4)-th unit column in the (M+1)-th unit row (or the (M+3)-th unit row), a first end of a connection portion 120 of the second anode 90B is directly connected to the main body portion 110, and a second end of the connection portion 120 is connected to the fourth pixel drive circuit of the (N+4)-th unit column. For another example, a main body portion 110 of a second anode 90B in an even-numbered light emitting row is at least partially overlapped with a fourth pixel drive circuit of the (N+7)-th unit column in the (M+1)-th unit row (or the (M+3)-th unit row), a first end of a connection portion 120 of the second anode 90B is directly connected to the main body portion 110, and a second end of the connection portion 120 is connected to the fourth pixel drive circuit of the (N+7)-th unit column.

In an exemplary implementation mode, the fourth anode 90D of the second green light emitting unit is connected to the second pixel drive circuit of the second circuit unit or the fourth pixel drive circuit of the fourth circuit unit.

In an exemplary implementation mode, in a light emitting row (e.g., odd-numbered light emitting row), orthographic projections of main body portions 110 of at least some fourth anodes 90D on the base substrate are at least partially overlapped with orthographic projections of connected fourth pixel drive circuits on the base substrate. For example, a main body portion 110 of a fourth anode 90D in an odd-numbered light emitting row is at least partially overlapped with a fourth pixel drive circuit of the (N+3)-th unit column in the M-th unit row (or (M+2)-th unit row), a first end of a connection portion 120 of the fourth anode 90D is directly connected to the main body portion 110, and a second end of the connection portion 120 is connected to the fourth pixel drive circuit of the (N+3)-th unit column. For another example, a main body portion 110 of a fourth anode 90D in an odd-numbered light emitting row is at least partially overlapped with a fourth pixel drive circuit of the (N+7)-th unit column in the M-th unit row (or (M+2)-th unit row), a first end of a connection portion 120 of the fourth anode 90D is directly connected to the main body portion 110, and a second end of the connection portion 120 is connected to the fourth pixel drive circuit of the (N+7)-th unit column.

In an exemplary implementation mode, in a light emitting row (e.g., even-numbered light emitting row), orthographic projections of main body portions 110 of at least some fourth anodes 90D on the base substrate are at least partially overlapped with orthographic projections of connected second pixel drive circuits on the base substrate. For example, a main body portion 110 of a fourth anode 90D in an even-numbered light emitting row is at least partially overlapped with a second pixel drive circuit of the (N+1)-th unit column in the (M+1)-th unit row (or the (M+3)-th unit row), a first end of a connection portion 120 of the fourth anode 90D is directly connected to the main body portion 110, and a second end of the connection portion 120 is connected to the second pixel drive circuit of the (N+1)-th unit column. For another example, a main body portion 110 of a fourth anode 90D in an even-numbered light emitting row is at least partially overlapped with a second pixel drive circuit of the (N+5)-th unit column in the (M+1)-th unit row (or (M+3)-th unit row), a first end of a connection portion 120 of the fourth anode 90D is directly connected to the main body portion 110, and a second end of the connection portion 120 is connected to the second pixel drive circuit of the (N+5)-th unit column.

FIG. 29C is a schematic diagram showing connection of an anode transfer line according to an embodiment of the present disclosure. As shown in FIG. 29C, a connection structure of an anode and a pixel drive circuit of the present embodiment is substantially the same as the structure shown in FIGs. 29A and 29B, except that the anode transfer line extend toward a same direction.

In an exemplary implementation mode, for a first anode located in the (M+1)-th unit row and the (N+2)-th unit column, a main body portion of the first anode is not overlapped with the first pixel drive circuit. A first end of an anode transfer line 130 is connected to the main body portion of the first anode, and after the anode transfer line 130 extends from the (N+2)-th unit column to the (N+4)-th unit column, a second end of the anode transfer line 130 is connected to a connection portion of a first anode, and the connection portion of the first anode is connected to a first pixel drive circuit of the (M+1)-th unit row and the (N+4)-th unit column.

In an exemplary implementation mode, for a third anode located in the (M+1)-th unit row and the N-th unit column, a main body portion of the third anode is not overlapped with a third pixel drive circuit. A first end of an anode transfer line 130 is connected to the main body portion of the third anode, and after the anode transfer line 130 extends from the N-th unit column to the (N+2)-th unit column, a second end of the anode transfer line 130 is connected to a connection portion of a third anode, and the connection portion of the third anode is connected to a third pixel drive circuit of the (M+1)-th unit row and the (N+2)-th unit column.

By arranging a plurality of anode transfer lines all extending in a same direction, crossing of anode transfer lines and increasing of a distance between anode transfer lines can be avoid, difficulty of layout arrangement can be reduced, and the process quality can be improved.

In an exemplary implementation mode, although the present embodiment has been described by taking an anode transfer line disposed in an anode conductive layer as an example for description, the anode transfer line may be disposed in any one conductive layer or a plurality of conductive layers in the display substrate, which is not limited here in the present disclosure.

In a possible exemplary implementation mode, the anode transfer line may be disposed in the sixth conductive layer, and the anode transfer line and the anode connection electrode are disposed in a same layer and formed synchronously through a same patterning process. For the first circuit unit of the (M+1)-th unit row and the N-th unit column, the anode connection electrode of the circuit unit may be connected to the eleventh connection electrode of the third circuit unit of the (M+1)-th unit row and the (N+2)-th unit column through the anode transfer line. For the third circuit unit in the (M+1)-th unit row and the (N+2)-th unit column, the anode connection electrode of the circuit unit may be connected to the eleventh connection electrode of the first circuit unit in the (M+1)-th unit row and the N-th unit column through the anode transfer line.

In another possible exemplary implementation mode, the anode transfer line may be disposed in the fifth conductive layer, and the anode transfer line and the eleventh connection electrode are disposed in a same layer and formed synchronously through a same patterning process. For the first circuit unit of the (M+1)-th unit row and the N-th unit column, the eleven-numbered connection electrode of the circuit unit may be connected to the sixth connection electrode of the third circuit unit of the (M+1)-th unit row and the (N+2)-th unit column through the anode transfer line. For the third circuit unit in the (M+1)-th unit row and the (N+2)-th unit column, the eleven-numbered connection electrode of the circuit unit may be connected to the sixth connection electrode of the first circuit unit in the (M+1)-th unit row and the N-th unit column through the anode transfer line.

In an exemplary implementation mode, a subsequent preparation process may include: forming a pattern of a pixel definition layer, wherein the pixel definition layer is provided with a plurality of pixel openings, and the plurality of pixel openings may expose surfaces of the first anode, the second anode, the third anode, and the fourth anode, respectively. Subsequently, an organic light emitting layer is formed using an evaporation process and inkjet printing process, and then a cathode is formed on the organic light emitting layer. The light emitting structure layer has been prepared. Subsequently, an encapsulation structure layer is formed, and the encapsulation structure layer may include a first encapsulation layer, a second encapsulation layer, and a third encapsulation layer that are stacked. The first encapsulation layer and the third encapsulation layer may be made of an inorganic material, the second encapsulation layer may be made of an organic material, and the second encapsulation layer is disposed between the first encapsulation layer and the third encapsulation layer, which may ensure that external water vapor cannot enter the light emitting structure layer.

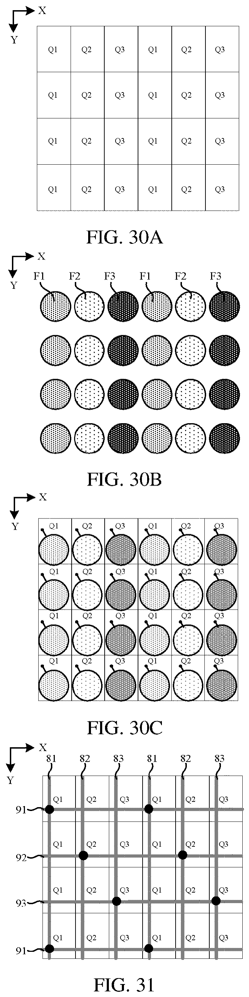

FIG. 30A is a schematic diagram of another arrangement of circuit units according to an exemplary embodiment of the present disclosure, FIG. 30B is a schematic diagram of another arrangement of light emitting units according to an exemplary embodiment of the present disclosure, and FIG. 30C is a schematic diagram of another connection between a circuit unit and a light emitting unit according to an exemplary embodiment of the present disclosure. As shown in FIGs. 30A, 30B, and 30C, on a plane parallel to the display substrate, the drive structure layer may include a plurality of circuit units, the light emitting structure layer may include a plurality of light emitting units, the plurality of circuit units may include a first circuit unit Q1, a second circuit unit Q2, and a third circuit unit Q3, and the plurality of light emitting units may include a first light emitting unit F1, a second light emitting unit F2, and a third light emitting unit F3.

In an exemplary implementation mode, in each unit row, the first circuit unit Q1, the second circuit unit Q2, and the third circuit unit Q3 may be periodically arranged in the first direction X, that is, arrangement modes of circuit units of an odd-numbered unit row and an even-numbered unit row are the same. In each unit column, same circuit units are disposed. For example, a plurality of first circuit units Q1 are disposed in a first unit column, a plurality of second circuit units Q2 are disposed in a second unit column, and a plurality of third circuit units Q3 are disposed in a third unit column.

In an exemplary implementation mode, in each light emitting row, the first light emitting unit F1, the second light emitting unit F2, and the third light emitting unit F3 may be periodically arranged in the first direction X, that is, arrangement modes of light emitting units of an odd-numbered unit row and an even-numbered unit row are the same. In each light emitting column, same light emitting units are disposed. For example, a plurality of first light emitting units F1 are disposed in a first light emitting column, a plurality of second light emitting units F2 are disposed in a second light emitting column, and a plurality of third light emitting units F3 are disposed in a third light emitting column.

In an exemplary implementation mode, a first light emitting device of the first light emitting unit F1 is connected to a first pixel drive circuit of the first circuit unit Q1. In each light emitting row, a position where the first light emitting device is orthographically projected on the base substrate substantially corresponds to a position where a connected first pixel drive circuit is orthographically projected on the base substrate.

In an exemplary implementation mode, a second light emitting device of the second light emitting unit F2 is connected to a second pixel drive circuit of the second circuit unit Q2. In each light emitting row, a position where the second light emitting device is orthographically projected on the base substrate substantially corresponds to a position where a connected second pixel drive circuit is orthographically projected on the base substrate.

In an exemplary implementation mode, a third light emitting device of the third light emitting unit F3 is connected to a third pixel drive circuit of the third circuit unit Q3. In each light emitting row, a position where the third light emitting device is orthographically projected on the base substrate substantially corresponds to a position where a connected third pixel drive circuit is orthographically projected on the base substrate.

FIG. 31 is a schematic diagram of another connection of a power supply line and a connection line in a display substrate according to an exemplary embodiment of the present disclosure. As shown in FIG. 31, in an exemplary embodiment of the present disclosure, the power supply line may include a first power supply line 81, a second power supply line 82, and a third power supply line 83, and the connection line may include a first connection line 91, a second connection line 92, and a third connection line 93.

In an exemplary implementation mode, the first power supply line 81, the second power supply line 82, and the third power supply line 83 may be in a shape of a straight line or a polyline with a main body portion extending along the second direction Y, and the first connection line 91, the second connection line 92, and the third connection line 93 may be in a shape of a straight line or a polyline with a main body portion extending along the first direction X.

In an exemplary implementation mode, any one or more of the first power supply line 81, the second power supply line 82, and the third power supply line 83 may be disposed in at least one unit column.

In an exemplary implementation mode, the first power supply line 81 may be separately disposed in a unit column including the first circuit unit Q1, and the first power supply line 81 may be respectively connected to first pixel drive circuits of a plurality of first circuit units Q1 in the unit column where the first power supply line 81. The second power supply line 82 may be separately disposed in a unit column including the second circuit unit Q2, and the second power supply line 82 may be respectively connected to second pixel drive circuits of a plurality of second circuit units Q2 in the unit column where the second power supply line 82 is located. The third power supply line 83 may be separately disposed in a unit column including the third circuit unit Q3, and the third power supply line 83 may be respectively connected to third pixel drive circuits of a plurality of third circuit units Q3 in the unit column where the third power supply line 83 is located. Unit columns with a single power supply line structure are formed, respectively.

In an exemplary implementation mode, any one or more of the first connection line 91, the second connection line 92, and the third connection line 93 may be disposed in at least one unit row.

In an exemplary implementation mode, the first connection line 91 may be disposed in one unit row and connected to a plurality of first power supply lines 81, respectively, to achieve a mutual connection of the first connection line 91 whose main body portion extends along the first direction X and the first power supply line 81 whose main body portion extends along the second direction Y to constitute a grid communication structure. The second connection line 92 may be disposed in another unit row and connected to a plurality of second power supply lines 82, respectively, to achieve a mutual connection of the second connection line 92 whose main body portion extends along the first direction X and the second power supply line 82 whose main body portion extends along the second direction Y to constitute a grid communication structure. The third connection line 93 may be disposed in yet another unit row and connected to a plurality of third power supply lines 83, respectively, to achieve a mutual connection of the third connection line 93 whose main body portion extends along the first direction X and the first power supply line 83 whose main body portion extends along the second direction Y to constitute a grid communication structure.

In an exemplary implementation mode, potentials of the first power supply line 81, the second power supply line 82, and the third power supply line 83 may be different.

In an exemplary implementation mode, the first power supply line 81, the second power supply line 82, and the third power supply line 83 may be disposed in a same conductive layer, or may be disposed in different conductive layers.

In an exemplary implementation mode, the first connection line 91, the second connection line 92, and the third connection line 93 may be disposed in a same conductive layer, or may be disposed in different conductive layers.

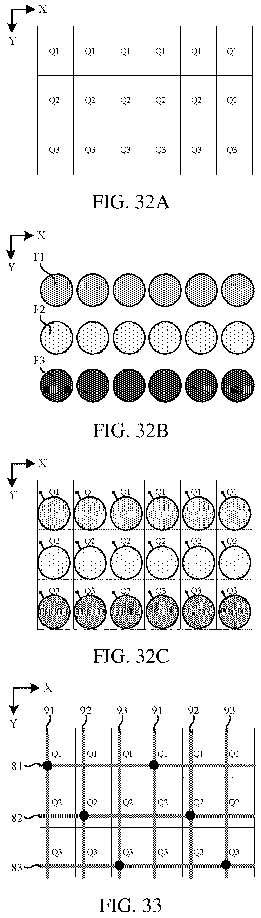

FIG. 32A is a schematic diagram of yet another arrangement of circuit units according to an exemplary embodiment of the present disclosure, FIG. 32B is a schematic diagram of yet another arrangement of light emitting units according to an exemplary embodiment of the present disclosure, and FIG. 32C is a schematic diagram of yet another connection between a circuit unit and a light emitting unit according to an exemplary embodiment of the present disclosure. As shown in FIGs. 32A, 32B, and 32C, on a plane parallel to the display substrate, the drive structure layer may include a plurality of circuit units, the light emitting structure layer may include a plurality of light emitting units, the plurality of circuit units may include a first circuit unit Q1, a second circuit unit Q2, and a third circuit unit Q3, and the plurality of light emitting units may include a first light emitting unit F1, a second light emitting unit F2, and a third light emitting unit F3.

In an exemplary implementation mode, in each unit column, the first circuit unit Q1, the second circuit unit Q2, and the third circuit unit Q3 may be periodically arranged in the second direction Y, that is, arrangement modes of circuit units of an odd-numbered unit column and an even-numbered unit column are the same. In each unit row, same circuit units are disposed. For example, a plurality of first circuit units Q1 are disposed in a first unit row, a plurality of second circuit units Q2 are disposed in a second unit row, and a plurality of third circuit units Q3 are disposed in a third unit row.

In an exemplary implementation mode, in each light emitting column, the first light emitting unit F1, the second light emitting unit F2, and the third light emitting unit F3 may be periodically arranged in the second direction Y, that is, arrangement modes of light emitting units of an odd-numbered unit column and an even-numbered unit column are the same. In each light emitting row, same light emitting units are disposed. For example, a plurality of first light emitting units F1 are disposed in a first light emitting row, a plurality of second light emitting units F2 are disposed in a second light emitting row, and a plurality of third light emitting units F3 are disposed in a third light emitting row.

In an exemplary implementation mode, a first light emitting device of the first light emitting unit F1 is connected to a first pixel drive circuit of the first circuit unit Q1. In each light emitting column, a position where the first light emitting device is orthographically projected on the base substrate substantially corresponds to a position where a connected first pixel drive circuit is orthographically projected on the base substrate.

In an exemplary implementation mode, a second light emitting device of the second light emitting unit F2 is connected to a second pixel drive circuit of the second circuit unit Q2. In each light emitting column, a position where the second light emitting device is orthographically projected on the base substrate substantially corresponds to a position where a connected second pixel drive circuit is orthographically projected on the base substrate.

In an exemplary implementation mode, a third light emitting device of the third light emitting unit F3 is connected to a third pixel drive circuit of the third circuit unit Q3. In each light emitting column, a position where the third light emitting device is orthographically projected on the base substrate substantially corresponds to a position where a connected third pixel drive circuit is orthographically projected on the base substrate.

FIG. 33 is a schematic diagram of yet another connection of a power supply line and a connection line in a display substrate according to an exemplary embodiment of the present disclosure. As shown in FIG. 33, in an exemplary embodiment of the present disclosure, the power supply line may include a first power supply line 81, a second power supply line 82, and a third power supply line 83, and the connection line may include a first connection line 91, a second connection line 92, and a third connection line 93.

In an exemplary implementation mode, the first power supply line 81, the second power supply line 82, and the third power supply line 83 may be in a shape of a straight line or a polyline with a main body portion extending along the first direction X, and the first connection line 91, the second connection line 92, and the third connection line 93 may be in a shape of a straight line or a polyline with a main body portion extending along the second direction Y.

In an exemplary implementation mode, any one or more of the first power supply line 81, the second power supply line 82, and the third power supply line 83 may be disposed in at least one unit row.

In an exemplary implementation mode, the first power supply line 81 may be separately disposed in a unit row including the first circuit unit Q1, and the first power supply line 81 may be respectively connected to first pixel drive circuits of a plurality of first circuit units Q1 in the unit row where the first power supply line 81. The second power supply line 82 may be separately disposed in a unit row including the second circuit unit Q2, and the second power supply line 82 may be respectively connected to second pixel drive circuits of a plurality of second circuit units Q2 in the unit row where the second power supply line 82 is located. The third power supply line 83 may be separately disposed in a unit row including the third circuit unit Q3, and the third power supply line 83 may be respectively connected to third pixel drive circuits of a plurality of third circuit units Q3 in the unit row where the third power supply line 83 is located. Unit rows with a single power supply line structure are formed, respectively.

In an exemplary implementation mode, any one or more of the first connection line 91, the second connection line 92, and the third connection line 93 may be disposed in at least one unit column.

In an exemplary implementation mode, the first connection line 91 may be disposed in a unit column, and may be connected to the plurality of first power supply lines 81, respectively, to constitute a grid communication structure. The second connection line 92 may be disposed in another unit column, and may be connected to the plurality of second power supply lines 82, respectively, to form a grid communication structure. The third connection line 93 may be disposed in yet another unit column, and may be connected to the plurality of third power supply lines 83, respectively, to form a grid communication structure.

In an exemplary implementation mode, potentials of the first power supply line 81, the second power supply line 82, and the third power supply line 83 may be different.

In an exemplary implementation mode, the first power supply line 81, the second power supply line 82, and the third power supply line 83 may be disposed in a same conductive layer, or may be disposed in different conductive layers.

In an exemplary implementation mode, the first connection line 91, the second connection line 92, and the third connection line 93 may be disposed in a same conductive layer, or may be disposed in different conductive layers.

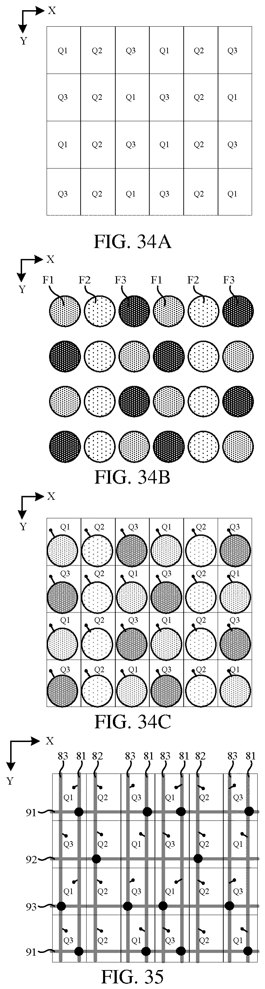

FIG. 34A is a schematic diagram of still another arrangement of circuit units according to an exemplary embodiment of the present disclosure, FIG. 34B is a schematic diagram of still another arrangement of light emitting units according to an exemplary embodiment of the present disclosure, and FIG. 34C is a schematic diagram of still another connection of a circuit unit and a light emitting unit according to an exemplary embodiment of the present disclosure. As shown in FIGs. 34A, 34B, and 34C, on a plane parallel to the display substrate, the drive structure layer may include a plurality of circuit units, the light emitting structure layer may include a plurality of light emitting units, the plurality of circuit units may include a first circuit unit Q1, a second circuit unit Q2, and a third circuit unit Q3, and the plurality of light emitting units may include a first light emitting unit F1, a second light emitting unit F2, and a third light emitting unit F3.

In an exemplary implementation mode, in a unit row, the first circuit unit Q1, the second circuit unit Q2, and the third circuit unit Q3 may be periodically arranged in the first direction X, that is, corresponding circuit units of an odd-numbered unit row and an even-numbered unit row are staggered. In one unit column, the first circuit unit Q1 and the third circuit unit Q3 are alternately disposed in the second direction Y, and in another unit column, second circuit units Q2 are sequentially disposed in the second direction Y.

In an exemplary implementation mode, in a light emitting row, the first light emitting unit F1, the second light emitting unit F2, and the third light emitting unit F3 may be periodically arranged in the first direction X, and corresponding light emitting units of an odd-numbered light emitting row and an even-numbered light emitting row are staggered. In a light emitting column, the first light emitting unit F1 and the third light emitting unit F3 are alternately disposed in the second direction Y, and in another light emitting column, the second light emitting units F2 are sequentially disposed in the second direction Y.

In an exemplary implementation mode, the first light emitting device of the first light emitting unit F1 is connected to the first pixel drive circuit of the first circuit unit Q1, and a position of an orthographic projection of the first light emitting device on the base substrate corresponds to a position of an orthographic projection of the first pixel drive circuit on the base substrate. The second light emitting device of the second light emitting unit F2 is connected to the second pixel drive circuit of the second circuit unit Q2, and a position of an orthographic projection of the second light emitting device on the base substrate corresponds to a position of an orthographic projection of the second pixel drive circuit on the base substrate. The third light emitting device of the third light emitting unit F3 is connected to the third pixel drive circuit of the third circuit unit Q3, and a position of an orthographic projection of the third light emitting device on the base substrate corresponds to a position of an orthographic projection of the third pixel drive circuit on the base substrate.

FIG. 35 is a schematic diagram of still another connection of a power supply line and a connection line in a display substrate according to an exemplary embodiment of the present disclosure. As shown in FIG. 35, in an exemplary embodiment of the present disclosure, the power supply line may include a first power supply line 81, a second power supply line 82, and a third power supply line 83, and the connection line may include a first connection line 91, a second connection line 92, and a third connection line 93.

In an exemplary implementation mode, the first power supply line 81, the second power supply line 82, and the third power supply line 83 may be in a shape of a straight line or a polyline with a main body portion extending along the second direction Y, and the first connection line 91, the second connection line 92, and the third connection line 93 may be in a shape of a straight line or a polyline with a main body portion extending along the first direction X.

In an exemplary implementation mode, any one or more of the first power supply line 81, the second power supply line 82, and the third power supply line 83 may be disposed in at least one unit column.

In an exemplary implementation mode, the first power supply line 81 and the third power supply line 83 may be disposed together in one unit column including the first circuit unit Q1 and the third circuit unit Q3 to form a unit column with a dual power supply line structure. The second power supply line 82 may be separately disposed in one unit column including the second circuit unit Q2 to form a unit column with a single power supply line structure.

In an exemplary implementation mode, the first power supply line 81 is respectively connected to first pixel drive circuits of a plurality of first circuit units Q1 in a unit column where the first power supply line 81 is located, the second power supply line 82 is respectively connected to second pixel drive circuits of a plurality of second circuit units Q2 in a unit column where the second power supply line 82 is located, and the third power supply line 83 is respectively connected to third pixel drive circuits of a plurality of third circuit units Q3 in a unit column where the third power supply line 83 is located.

In an exemplary implementation mode, any one or more of the first connection line 91, the second connection line 92, and the third connection line 93 may be disposed in at least one unit row.

In an exemplary implementation mode, the first connection line 91 may be disposed in one unit row and connected to a plurality of first power supply lines 81, respectively, to achieve a mutual connection of the first connection line 91 whose main body portion extends along the first direction X and the first power supply line 81 whose main body portion extends along the second direction Y to constitute a grid communication structure. The second connection line 92 may be disposed in another unit row and connected to a plurality of second power supply lines 82, respectively, to achieve a mutual connection of the second connection line 92 whose main body portion extends along the first direction X and the second power supply line 82 whose main body portion extends along the second direction Y to constitute a grid communication structure. The third connection line 93 may be disposed in yet another unit row and connected to a plurality of third power supply lines 83, respectively, to achieve a mutual connection of the third connection line 93 whose main body portion extends along the first direction X and the third power supply line 83 whose main body portion extends along the second direction Y to constitute a grid communication structure.

In an exemplary implementation mode, potentials of the first power supply line 81, the second power supply line 82, and the third power supply line 83 may be different.

In an exemplary implementation mode, the first power supply line 81, the second power supply line 82, and the third power supply line 83 may be disposed in a same conductive layer, or may be disposed in different conductive layers.

In an exemplary implementation mode, the first connection line 91, the second connection line 92, and the third connection line 93 may be disposed in a same conductive layer, or may be disposed in different conductive layers.

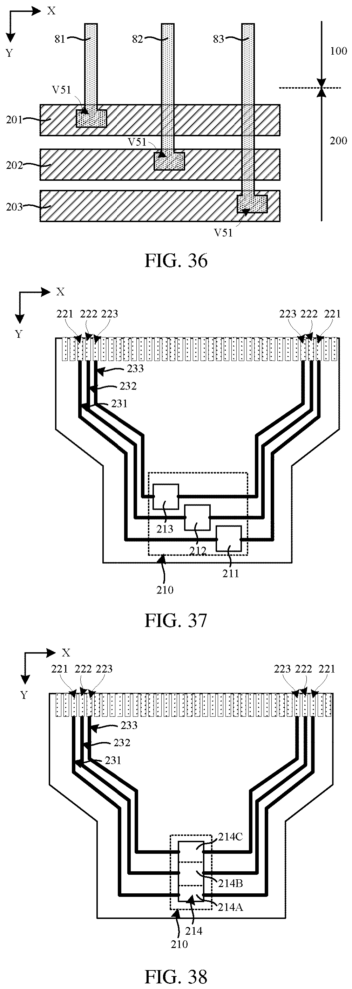

FIG. 36 is a schematic diagram of a power supply trace in a bonding area according to an exemplary embodiment of the present disclosure, which illustrates a structure of a power supply trace in a region A in FIG. 2. As shown in FIG. 36, the display substrate may include a display area 100 and a bonding area 200 located on a side of the display area 100. The display area 100 may at least include a plurality of circuit units and a plurality of power supply lines, the plurality of circuit units may at least include a first circuit unit provided with a first pixel drive circuit, a second circuit unit provided with a second pixel drive circuit, and a third circuit unit provided with a third pixel drive circuit, and the plurality of power supply lines may at least include a first power supply line 81, a second power supply line 82, and a third power supply line 83. The first power supply line 81 is connected to the first pixel drive circuit, the second power supply line 82 is connected to the second pixel drive circuit, and the third power supply line 83 is connected to the third pixel drive circuit. The bonding area 200 may at least include a fan-out region connected to the display area 100, the fan-out region may at least include a plurality of high-potential power supply lead lines, and the plurality of high-potential power supply lead lines may at least include a first high-potential power supply lead line 201, a second high-potential power supply lead line 202, and a third high-potential power supply lead line 203. After extending to the fan-out region of the bonding area 200, the plurality of power supply lines of the display area 100 are connected to the plurality of high-potential power supply leads lines correspondingly, that is, the first power supply line 81 is connected to the first high-potential power supply lead line 201, the second power supply line 82 is connected to the second high-potential power supply lead line 202, and the third power supply line 83 is connected to the third high-potential power supply lead line 203.

In an exemplary implementation mode, the first power supply line 81, the second power supply line 82, and the third power supply line 83 may be in a shape of a line extending in a direction of the bonding area 200, and may be sequentially disposed in a direction of an edge of the display area. The first high-potential power supply lead line 201, the second high-potential power supply lead line 202, and the third high-potential power supply lead line 203 may be in a shape of a line extending along the direction of the edge of the display area, and may be sequentially arranged along a direction away from the display area 100. In an exemplary implementation mode, the edge of the display area refers to an edge of the display area 100 close to the bonding area 200.

In an exemplary implementation mode, the plurality of power supply lines and the plurality of high-potential power supply lead lines may be disposed in different conductive layers. After the first power supply line 81 extends from the display area 100 to a position where the first high-potential power supply lead line 201 is located in the bonding area 200, the first power supply line 81 is connected to the first high-potential power supply lead line 201 through a first power supply via V51. After the second power supply line 82 extends from the display area 100 to a position where the second high-potential power supply lead line 202 is located in the bonding area 200, the second power supply line 82 is connected to the second high-potential power supply lead line 202 through a first power supply via V51. After the third power supply line 83 extends from the display area 100 to a position where the third high-potential power supply lead line 203 is located in the bonding area 200, the third power supply line 83 is connected to the third high-potential power supply lead line 203 through a first power supply via V51.

In an exemplary implementation mode, in a direction perpendicular to the display substrate, the fan-out region in the bonding area 200 may include a plurality of insulation layers and a plurality of conductive layers formed synchronously with the display area 100, and the first high-potential power supply lead line 201, the second high-potential power supply lead line 202, and the third high-potential power supply lead line 203 may be disposed in a same conductive layer, or may be disposed in different conductive layers.

In an exemplary implementation mode, when the first power supply line 81, the second power supply line 82, and the third power supply line 83 are disposed in the fifth conductive layer, the first high-potential power supply lead line 201, the second high-potential power supply lead line 202, and the third high-potential power supply lead line 203 may be disposed together in one of the first conductive layer to the fourth conductive layer.

In another exemplary implementation mode, when the first power supply line 81, the second power supply line 82, and the third power supply line 83 are disposed in the fifth conductive layer, the first high-potential power supply lead line 201, the second high-potential power supply lead line 202, and the third high-potential power supply lead line 203 may be disposed in three conductive layers among the first conductive layer to fourth conductive layer, respectively.

In yet another exemplary implementation mode, when the first power supply line 81, the second power supply line 82, and the third power supply line 83 are disposed in the fifth conductive layer, the first high-potential power supply lead line 201 and the third high-potential power supply lead line 203 may be disposed together in one of the first conductive layer to fourth conductive layer, and the second high-potential power supply lead line 202 may be separately disposed in the other of the first conductive layer to fourth conductive layer. Or, the first high-potential power supply lead line 201 and the second high-potential power supply lead line 202 may be disposed together in one of the first to fourth conductive layers, and the third high-potential power supply lead line 203 may be separately disposed in the other of the first to fourth conductive layers. Or, the first high-potential power supply lead line 201 may be disposed separately in one of the first to fourth conductive layers, and the second high-potential power supply lead line 202 and the third high-potential power supply lead line 203 may be disposed together in the other of the first to fourth conductive layers.

FIG. 37 is a schematic diagram of a power supply trace in a flexible printed circuit according to an exemplary embodiment of the present disclosure. In an exemplary implementation mode, the bonding area 200 further includes a bonding pin region located on a side of the fan-out region away from the display area 100, and the bonding pin region may at least include a plurality of bonding pads configured to be bonded to an external flexible printed circuit (FPC), and the flexible printed circuit may provide a plurality of power supply signals to the plurality of high-potential power lead lines of the bonding area 200. As shown in FIG. 37, the flexible printed circuit may at least include a control circuit 210, a plurality of circuit board pads, and a plurality of power supply transmission lines, and the control circuit 210 is connected to the plurality of circuit board pads through the plurality of power supply transmission lines.

In an exemplary implementation mode, the control circuit 210 may at least include a first control circuit 211, a second control circuit 212, and a third control circuit 213, the plurality of circuit board pads may at least include a first pad 221, a second pad 222, and a third pad 223, and the plurality of power supply transmission lines may at least include a first transmission line 231, a second transmission line 232, and a third transmission line 232. A first end of the first transmission line 231 is connected to the first control circuit 211, and a second end of the first transmission line 231 is connected to the first pad 221 after extending to a circuit board pad region. A first end of the second transmission line 232 is connected to the second control circuit 212, and a second end of the second transmission line 232 is connected to the second pad 222 after extending to the circuit board pad region. A first end of the third transmission line 232 is connected to the third control circuit 213, and a second end of the third transmission line 232 is connected to the third pad 223 after extending to the circuit board pad region.

In an exemplary implementation mode, a management integrated circuit (PMIC) may be adopted for the control circuit. The first control circuit 211 may provide a first power supply signal, the second control circuit 212 may provide a second power supply signal, and the third control circuit 213 may provide a third power supply signal.

In an exemplary implementation mode, after the flexible printed circuit is bonded and connected to the bonding pin region of the display substrate, the first control circuit 211, the second control circuit 212, and the third control circuit 213 may respectively provide the first power supply signal, the second power supply signal, and the third power supply signal to the corresponding power supply line in the display area through a corresponding transmission line and pad in the flexible printed circuit, a corresponding bonding pad and power supply trace in the bonding area.

In an exemplary implementation mode, a plurality of first pads 221, second pads 222, and third pads 223, and a plurality of first transmission lines 231, second transmission lines 232, and third transmission lines 232 may be employed in the flexible printed circuit in order to improve reliability of signal transmission.

FIG. 38 is a schematic diagram of a power supply trace in another flexible printed circuit according to an exemplary embodiment of the present disclosure. As shown in FIG. 38, a main structure of the flexible printed circuit of the present embodiment is substantially the same as that shown in FIG. 37, except that a management integrated circuit 214 may be employed for the control circuit 210.

In an exemplary implementation mode, the management integrated circuit 214 may at least include three signal channels: a first signal channel 214A may provide a first power supply signal, a second signal channel 214B may provide a second power supply signal, and a third signal channel 214C may provide a third power supply signal.

In an exemplary implementation mode, the first end of the first transmission line 231 is connected to the first signal channel 214A of the management integrated circuit 214, and the second end of the first transmission line 231 is connected to the first pad 221 after extending to the circuit board pad region. The first end of the second transmission line 232 is connected to the second signal channel 214B of the management integrated circuit 214, and the second end of the second transmission line 232 is connected to the second pad 222 after extending to the circuit board pad region. The first end of the third transmission line 232 is connected to the third signal channel 214C of the management integrated circuit 214, and the second end of the third transmission line 232 is connected to the third pad 223 after extending to the circuit board pad region.

In an exemplary implementation mode, after the flexible printed circuit is bonded and connected to the bonding pin region of the display substrate, the first signal channel 214A, the second signal channel 214B, and the third signal channel 214C of the management integrated circuit 214 may respectively provide the first power supply signal, the second power supply signal, and the third power supply signal to the corresponding power supply line in the display area through the corresponding transmission line and pad in the flexible printed circuit, the corresponding bonding pad and power supply trace in the bonding area.

In an exemplary implementation mode, a plurality of first pads 221, second pads 222, and third pads 223, and a plurality of first transmission lines 231, second transmission lines 232, and third transmission lines 232 may be employed in the flexible printed circuit in order to improve reliability of signal transmission.

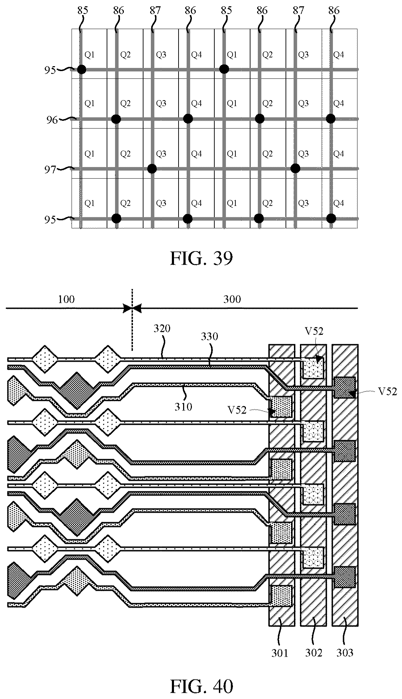

FIG. 39 is a schematic diagram of connection of a low-potential power supply line and a low-potential connection line in a display substrate according to an exemplary embodiment of the present disclosure. As shown in FIG. 39, the drive structure layer may further include a plurality of low-potential power supply lines and a plurality of low-potential connection lines, the plurality of low-potential power supply lines may at least include a fifth power supply line 85, a sixth power supply line 86, and a seventh power supply line 87, and the plurality of low-potential connection lines may at least include a fifth connection line 95, a sixth connection line 96, and a seventh connection line 97.

In an exemplary implementation mode, the fifth power supply line 85, the sixth power supply line 86, and the seventh power supply line 87 may be in a shape of a straight line or a polyline with a main body portion extending along the second direction Y, and the fifth connection line 95, the sixth connection line 96, and the seventh connection line 97 may be in a shape of a straight line or a polyline with a main body portion extending along the first direction X.

In an exemplary implementation mode, any one or more of the fifth power supply line 85, the sixth power supply line 86, and the seventh power supply line 87 may be disposed in at least one unit column.

In an exemplary implementation mode, the fifth power supply line 85, the sixth power supply line 86, and the seventh power supply line 87 may be separately disposed in one unit column to form a unit column with a single power supply line structure.

In an exemplary implementation mode, the fifth power supply line 85, the sixth power supply line 86, and the seventh power supply line 87 have different potentials. The fifth power supply line 85 is respectively connected to cathodes of a plurality of first light emitting devices in a unit column where the fifth power supply line 85 is located, the sixth power supply line 86 is respectively connected to cathodes of a plurality of second light emitting devices and a plurality of fourth light emitting devices in a unit column where the sixth power supply line 86 is located, and the seventh power supply line 87 is respectively connected to cathodes of a plurality of third light emitting devices in a unit column where the seventh power supply line 87 is located.

In an exemplary implementation mode, any one or more of the fifth connection line 95, the sixth connection line 96, and the seventh connection line 97 may be disposed in at least one unit row.

In an exemplary implementation mode, the fifth connection line 95 may be disposed in one unit row and connected to a plurality of fifth power supply lines 85, respectively, to achieve a mutual connection of the fifth connection line 95 whose main body portion extends along the first direction X and the fifth power supply line 85 whose main body portion extends along the second direction Y to constitute a grid communication structure for transmitting the first low-potential power supply signal.

In an exemplary implementation mode, the sixth connection line 96 may be disposed in another unit row and connected to a plurality of sixth power supply lines 86, respectively, to achieve a mutual connection of the sixth connection line 96 whose main body portion extends along the first direction X and the sixth power supply line 86 whose main body portion extends along the second direction Y to constitute a grid communication structure for transmitting the second low-potential power supply signal.

In an exemplary implementation mode, the seventh connection line 97 may be disposed in one unit row and connected to a plurality of seventh power supply lines 87, respectively, to achieve a mutual connection of the seventh connection line 97 whose main body portion extends along the first direction X and the seventh power supply line 87 whose main body portion extends along the second direction Y to constitute a grid communication structure for transmitting the third low-potential power supply signal.

In an exemplary implementation mode, in the direction perpendicular to the base substrate, the drive structure layer may include a plurality of conductive layers, and the fifth power supply line 85, the sixth power supply line 86, and the seventh power supply line 87 may be disposed in a same conductive layer, or may be disposed in different conductive layers. The fifth connection line 95, the sixth connection line 96, and the seventh connection line 97 may be disposed in a same conductive layer, or may be disposed in different conductive layers.

FIG. 40 is a schematic diagram of a power supply trace in a bezel area according to an exemplary embodiment of the present disclosure, which illustrates a structure of a power supply trace in a B region in FIG. 2. As illustrated in FIG. 40, the display substrate may include a display area 100 and a bezel area 300 located on at least a side of the display area 100, the display area 100 may at least include a plurality of light emitting units and a plurality of cathode lines. The plurality of light emitting units may at least include a first light emitting unit provided with a first light emitting device, a second light emitting unit provided with a second light emitting device, and a third light emitting unit provided with a third light emitting device. The plurality of cathode lines may at least include a first cathode line 310, a second cathode line 320, and a third cathode line 330. The first cathode line 310 may serve as a cathode of the first light emitting device, the second cathode line 320 may serve as a cathode of the second light emitting device, and the third cathode line 310 may serve as a cathode of the third light emitting device. The bezel area 300 may at least include a plurality of low-potential power supply lead lines, and the plurality of low-potential power supply lead lines may at least include a first low-potential power supply lead line 301, a second low-potential power supply lead line 302, and a third low-potential power supply lead line 303. After the plurality of cathode lines of the display area 100 extend to the bezel area 300, the plurality of cathode lines are connected to the plurality of low-potential power supply lead lines correspondingly, that is, the first cathode line 310 is connected to the first low-potential power supply lead line 301, the second cathode line 320 is connected to the second low-potential power supply lead line 302, and the third cathode line 330 is connected to the third low-potential power supply lead line 303.

In an exemplary implementation mode, during preparing a cathode in the light emitting structure layer, cathodes of the first light emitting device, the second light emitting device, and the third light emitting device may be separated using a patterned evaporation process to form three strip-shaped cathode lines extending along the first direction, or three strip-shaped cathode lines extending along the second direction, that is, the first cathode line 310 as the cathode of the first light emitting device, the second cathode line 320 as the cathode of the second light emitting device, and the third cathode line 330 as the cathode of the third light emitting device may be formed.

In an exemplary implementation mode, the first low-potential power supply lead line 301, the second low-potential power supply lead line 302, and the third low-potential power supply lead line 303 may be in a shape of a line extending along the direction of the edge of the display area, and may be sequentially arranged along a direction away from the display area 100. In an exemplary implementation mode, the edge of the display area refers to an edge of the display area 100 close to the bezel area 300.

In an exemplary implementation mode, the plurality of cathode lines and the plurality of low-potential power supply lead lines may be disposed in different conductive layers. After the first cathode line 310 extends from the display area 100 to a position where the first low-potential power supply lead line 301 is located in the bezel area 300, the first cathode line 310 is connected to the first low-potential power supply lead line 301 through a second power supply via V52. After the second cathode line 320 extends from the display area 100 to a position where the second low-potential power supply lead line 302 is located in the bezel area 300, the second cathode line 320 is connected to the second low-potential power supply lead line 302 through a second power supply via V52. After the third cathode line 330 extends from the display area 100 to a position where the third low-potential power supply lead line 303 is located in the bezel area 300, the third cathode line 330 is connected to the third low-potential power supply lead line 303 through a second power supply via V52.

In an exemplary implementation mode, in a direction perpendicular to the display substrate, the bezel area may include a plurality of insulation layers and a plurality of conductive layers formed synchronously with the display area 100, and the first low-potential power supply lead line 301, the second low-potential power supply lead line 302, and the third low-potential power supply lead line 303 may be disposed in a same conductive layer, or may be disposed in different conductive layers.

In an exemplary implementation mode, the first low-potential power supply lead line 301, the second low-potential power supply lead line 302, and the third low-potential power supply lead line 303 may be disposed together in the anode conductive layer of the light emitting structure layer. The pixel definition layer of the bezel area is provided with a second power supply via during a pixel definition layer is formed, and the first cathode line 310, the second cathode line 320, and the third cathode line 330 are respectively connected to the first low-potential power supply lead line 301, the second low-potential power supply lead line 302, and the third low-potential power supply lead line 303 through the second power supply via, respectively, during the cathode layer is formed.

The inventors of the present application have found that light emitting efficiencies of a red light emitting device, a blue light emitting device, and a green light emitting device are very different. When the red light emitting device, the blue light emitting device, and the green light emitting device reach same brightness under a same cross-voltage $\triangle U$ between a high-potential power supply line VDD and a low-potential power supply line VSS, the red light emitting device, the blue light emitting device, and the green light emitting device have different saturation region margin voltages, and saturation region margin voltages of the red light emitting device or the green light emitting device are greater than a saturation region margin voltage of the blue light emitting device. The saturation region margin voltage refers to a voltage difference between a saturation region boundary of a pixel and a normal working region. For example, the saturation region margin voltage of the blue light emitting device is about $10\%\triangle U$ to $15\%\triangle U$, the saturation region margin voltage of the red light emitting device is about $17\%\triangle U$ to $23\%\triangle U$, and the saturation region margin voltage of the green light emitting device is about $25\%\triangle U$ to $30\%\triangle U$. Therefore, a same cross-voltage $\triangle U$ is used for the red light emitting device, the blue light emitting device and the green light emitting device will increase power consumption.

In the display substrate provided by the exemplary embodiment of the present disclosure, high-potential power supply lines VDD of the red light emitting device, the blue light emitting device and the green light emitting device are independently designed. A first power supply line provides a first power supply signal for a first pixel drive circuit connected to the red light emitting device, a second power supply line provides a second power supply signal for a second pixel drive circuit connected to the green light emitting device, and a third power supply line provides a third power supply signal for a third pixel drive circuit connected to the blue light emitting device. Under that condition of ensuring normal drive of the pixel drive circuit, when the red light emitting device, the blue light emitting device and the green light emitting device reach same brightness, the saturation region margin voltages of three light emitting devices can be substantially the same, and power consumption can be effectively reduced. For example, by adjusting voltages of the first power supply line, the second power supply line, and the third power supply line, the saturation region margin voltages of the red light emitting device, the blue light emitting device, and the green light emitting device are 10%△U to 15%△U, therefore, for the red light emitting device, the saturation region margin voltage can be reduced by about 7%, for the green light emitting device, the saturation region margin voltage can be reduced by about 15%, and corresponding power consumption can be reduced by about 5% to 7%.

In the exemplary embodiment of the present disclosure, by setting a first connection line, a second connection line and a third connection line, the first connection line is connected to the first power supply line, the second connection line is connected to the second power supply line, and the third connection line is connected to the third power supply line, and grid communication structure for transmitting the first high potential power supply signal, the second high potential power supply signal and the third high potential power supply signal are respectively formed on the display substrate, thereby not only effectively reducing the resistance of the high potential power supply line, but also effectively improving the uniformity of the high potential power supply signal in the display substrate, and improving the display quality and the display quality.

In the present disclosure, the low-potential power supply lines VSS of the red light emitting device, the blue light emitting device and the green light emitting device are independently designed, and the first cathode line is the cathode of the first light emitting device, the second cathode line is the cathode of the second light emitting device, and the third cathode line is the cathode of the third light emitting device, so that when the red light emitting device, the blue light emitting device and the green light emitting device reach the same brightness, the saturation region margin voltages of the three light emitting devices are basically the same, and power consumption is effectively reduced.

In the exemplary embodiment of the present disclosure, by providing a plurality of low-potential power supply lines and a plurality of low-potential connection lines, grid communication structures for transmitting a first low-potential power supply signal, a second low-potential power supply signal and a third low-potential power supply signal are respectively formed on the display substrate, which not only can effectively reduce resistance of the low-potential power supply line and reduce voltage drop of the low-potential power supply signal, but also can effectively improve uniformity of the low-potential power supply signal in the display substrate, effectively improve uniformity of display, and improve the display quality.

In the present disclosure, by disposing the power supply line in the second source-drain metal layer and the connection line in the third source-drain metal layer, the power supply line and the connection line may be connected to only one planarization layer via, thereby minimizing occupied space, facilitating achievement of high-resolution display, and a resolution (PPI) of an LTPO display substrate may be effectively increased. In the present disclosure, by disposing the data signal line in the second source-drain metal layer, a distance between the data signal line and the corresponding signal line is increased, and a parasitic capacitance between the data signal line and the corresponding signal line is reduced, thereby effectively reducing a capacitance load of the data signal line. In the present disclosure, on the one hand, the power supply line can may block light emitted by a light emitting device and light reflected by a film layer from irradiating an oxide transistor, may prevent the oxide transistor from characteristic drift due to illumination, thus improving electrical characteristics of the oxide transistor; on the other hand, the power supply line can effectively shield an influence of data voltage jump and other signals on the first node in the pixel drive circuit, avoid an influence of the data voltage jump and other signals on a potential of the first node, effectively avoid deterioration of cross talk. The manufacturing process in the present disclosure may be compatible well with an existing manufacturing process, is simple in process implementation mode, is easy to implement, and has a high production efficiency, a low production cost, and a high yield.

The aforementioned structure shown in the present disclosure and the preparation process thereof are merely exemplary description. In an exemplary implementation mode, corresponding structures may be changed and patterning processes may be added or reduced according to actual needs, which is not limited here in the present disclosure.

In an exemplary implementation mode, the display substrate of the present disclosure may be applied to other display apparatuses having a pixel drive circuit, such as quantum dot display, which is not limited here in the present disclosure.

The present disclosure also provides a preparation method for a display substrate, for preparing the display substrate according to the foregoing embodiments. In an exemplary implementation mode, the display substrate includes a display area and a bonding area disposed on at least one side of the display area, and the preparation method may include following acts.

A drive structure layer is formed on a base substrate of the display area, wherein the drive structure layer includes a plurality of circuit units forming a plurality of unit rows and a plurality of unit columns, the plurality of circuit units at least include a first circuit unit provided with a first pixel drive circuit, a second circuit unit provided with a second pixel drive circuit, and a third circuit unit provided with a third pixel drive circuit; the drive structure layer further includes at least one connection line extending at least partially along a first direction, and a first power supply line, a second power supply line, and a third power supply line extending at least partially along a second direction, the first direction intersects with the second direction, the first power supply line, the second power supply line, and the third power supply line have different potentials; the first power supply line is connected to the first pixel drive circuit, the second power supply line is connected to the second pixel drive circuit, and the third power supply line is connected to the third pixel drive circuit; and the at least one connection line is connected to the first power supply line, the second power supply line, or the third power supply line to form a grid communication structure for transmitting a power supply signal on the display substrate;

A light emitting structure layer is formed on the drive structure layer, wherein the light emitting structure layer includes a plurality of light emitting units, the plurality of light emitting units at least include a first light emitting unit provided with a first light emitting device, a second light emitting unit provided with a second light emitting device, and a third light emitting unit provided with a third light emitting device, the first light emitting device, the second light emitting device, and the third light emitting device emit light of different colors; the first light emitting device is connected to the first pixel drive circuit, the second light emitting device is connected to the second pixel drive circuit, and the third light emitting device is connected to the third pixel drive circuit.

A display apparatus which includes the aforementioned display substrate is also provided in the present disclosure. The display apparatus may be any product or component with a display function, such as a mobile phone, a tablet computer, a television, a display, a laptop computer, a digital photo frame, and a navigator, which is not limited in the embodiments of the present invention.

Although implementation modes disclosed in the present disclosure are as above, it should be noted that the above implementation modes are exemplary only rather than restrictive. Therefore, the present disclosure is not limited to what is specifically shown and described here. Various modifications, substitutions, or omissions may be made in forms and details of implementation modes without departing from the scope of the present disclosure.

**Claims**

1. A display substrate comprising a display area and a bonding area disposed on at least one side of the display area, wherein the display area comprises a drive structure layer disposed on a base substrate and a light emitting structure layer disposed on a side of the drive structure layer away from the base substrate, the drive structure layer comprises a plurality of circuit units forming a plurality of unit rows and a plurality of unit columns, a circuit unit at least comprises a pixel drive circuit, the light emitting structure layer comprises a plurality of light emitting units, a light emitting unit at least comprises a light emitting device; the plurality of circuit units at least comprise a first circuit unit provided with a first pixel drive circuit, a second circuit unit provided with a second pixel drive circuit, and a third circuit unit provided with a third pixel drive circuit, the plurality of light emitting units at least comprise a first light emitting unit provided with a first light emitting device, a second light emitting unit provided with a second light emitting device, and a third light emitting unit provided with a third light emitting device, the first light emitting device, the second light emitting device, and the third light emitting device emit light of different colors; the first light emitting device is connected to the first pixel drive circuit, the second light emitting device is connected to the second pixel drive circuit, and the third light emitting device is connected to the third pixel drive circuit; the drive structure layer further comprises at least one connection line extending at least partially along a first direction, and a first power supply line, a second power supply line, and a third power supply line extending at least partially along a second direction, the first direction intersects with the second direction, the first power supply line, the second power supply line, and the third power supply line have different potentials; the first power supply line is connected to the first pixel drive circuit, the second power supply line is connected to the second pixel drive circuit, and the third power supply line is connected to the third pixel drive circuit; and the at least one connection line is connected to the first power supply line, the second power supply line, or the third power supply line to form a grid communication structure for transmitting a power supply signal on the display substrate.

2. The display substrate according to claim 1, wherein the first power supply line and the third power supply line are disposed in a same unit column, or the first power supply line and the third power supply line are disposed in different unit columns.

3. The display substrate according to claim 1, wherein the drive structure layer comprises a plurality of conductive layers in a direction perpendicular to the base substrate, and any one or more of the first power supply line, the second power supply line, and the third power supply line are disposed in at least one of the conductive layers.

4. The display substrate according to claim 1, wherein the at least one connection line comprises any one or more of a first connection line, a second connection line, and a third connection line; the first connection line is connected to the first power supply line to form a grid communication structure for transmitting a first power supply signal on the display substrate; the second connection line is connected to the second power supply line to form a grid communication structure for transmitting a second power supply signal on the display substrate; and the third connection line is connected to the third power supply line to form a grid communication structure for transmitting a third power supply signal on the display substrate.

5. The display substrate according to claim 4, wherein any one or more the first connection line, the second connection line, and the third connection line are disposed in at least one of the unit rows.

6. The display substrate according to claim 4, wherein the drive structure layer comprises a plurality of conductive layers in a direction perpendicular to the base substrate, and any one or more of the first connection line, the second connection line, and the third connection line are disposed in at least one of the conductive layers.

7. The display substrate according to claim 4, wherein the drive structure layer comprises a plurality of conductive layers in a direction perpendicular to the base substrate, and the first power supply line and the first connection line are disposed in different conductive layers; or, the second power supply line and the second connection line are disposed in different conductive layers; or, the third power supply line and the third connection line are disposed in different conductive layers.

8. The display substrate according to claim 4, wherein the plurality of circuit units further comprises a fourth circuit unit provided with a fourth pixel drive circuit, the plurality of light emitting units further comprises a fourth light emitting unit provided with a fourth light emitting device, the fourth light emitting unit and the second light emitting device emit light of a same color, and the drive structure layer further comprises a fourth power supply line and a fourth connection line, the fourth power supply line is connected to the fourth pixel drive circuit, and the fourth connection line is connected to the fourth power supply line to form a grid communication structure for transmitting a fourth power supply signal on the display substrate.

9. The display substrate according to claim 8, wherein the second connection line is further connected to the fourth power supply line, and the fourth connection line is further connected to the second power supply line.

10. The display substrate according to claim 1, wherein the drive structure layer further comprises a first data signal line, a second data signal line, and a third data signal line, the first data signal line is connected to the first pixel drive circuit, the second data signal line is connected to the second pixel drive circuit, and the third data signal line is connected to the third pixel drive circuit; any one or more of the first data signal line, the second data signal line, and the third data signal line are disposed in at least one of the unit columns.

11. The display substrate according to claim 1, wherein the drive structure layer further comprises a fifth power supply line, a sixth power supply line, and a seventh power supply line, the fifth power supply line is connected to a cathode of the first light emitting device, the sixth power supply line is connected to a cathode of the second light emitting device, and the seventh power supply line is connected to a cathode of the third light emitting device.

12. The display substrate according to any one of claims 1 to 11, wherein in a direction perpendicular to the base substrate, the display substrate comprises a plurality of conductive layers, an anode transfer line is disposed in any one or more of the conductive layers, the first power supply line and the third power supply line are disposed in different unit columns, the first pixel drive circuit is connected to the first light emitting device through the anode transfer line, and/or the third pixel drive circuit is connected to the third light emitting device through the anode transfer line.

13. The display substrate according to claim 12, wherein the first light emitting device at least comprises a first anode, the first anode at least comprises a main body portion and a connection portion, orthographic projections of main body portions of at least some first anodes on a base substrate plane are not overlapped with an orthographic projection of the first pixel drive circuit on the base substrate plane, a first end of the anode transfer line is connected to the main body portion of the first anode, a second end of the anode transfer line is connected to the connection portion of the first anode, and the connection portion of the first anode is connected to the first pixel drive circuit; and/or the third light emitting device at least comprises a third anode, the third anode at least comprises a main body portion and a connection portion, orthographic projections of main body portions of at least some third anodes on the base substrate plane are not overlapped with an orthographic projection of the third pixel drive circuit on the base substrate plane, a first end of the anode transfer line is connected to the main body portion of the third anode, a second end of the anode transfer line is connected to the connection portion of the third anode, and the connection portion of the third anode is connected to the third pixel drive circuit.

14. The display substrate of claim 13, wherein orthographic projections of main body portions of at least some first anodes on the base substrate plane are at least partially overlapped with the orthographic projection of the third pixel drive circuit on the base substrate plane; and/or orthographic projections of main body portions of at least some third anodes on the base substrate plane are at least partially overlapped with the orthographic projection of the first pixel drive circuit on the base substrate plane.

15. The display substrate of claim 13, wherein an orthographic projection of the anode transfer line on the base substrate plane is at least partially overlapped with an orthographic projection of the second pixel drive circuit on the base substrate plane; and/or the orthographic projection of the anode transfer line on the base substrate plane is at least partially overlapped with an orthographic projection of the fourth pixel drive circuit on the base substrate plane.

16. The display substrate according to any one of claims 1 to 11, wherein the first power supply line and the third power supply line are disposed in a same unit column; the first light emitting device at least comprises a first anode, the first anode at least comprises a main body portion and a connection portion, a first end of the connection portion of the first anode is connected to the main body portion of the first anode, a second end of the connection portion of the first anode is connected to the first pixel drive circuit, and orthographic projections of main body portions of at least some first anodes on the base substrate plane are at least partially overlapped with an orthographic projection of the first pixel drive circuit on the base substrate plane; and/or the third light emitting device at least comprises a third anode, the third anode at least comprises a main body portion and a connection portion, a first end of the connection portion of the third anode is connected to the main body portion of the third anode, a second end of the connection portion of the third anode is connected to the third pixel drive circuit, and orthographic projections of main body portions of at least some third anodes on the base substrate plane are at least partially overlapped with an orthographic projection of the third pixel drive circuit on the base substrate plane.

17. The display substrate according to any one of claims 1 to 11, wherein the bonding area at least comprises a first high-potential power supply lead line, a second high-potential power supply lead line, and a third high-potential power supply lead line, the first power supply line is connected to the first high-potential power supply lead line, the second power supply line is connected to the second high-potential power supply lead line, and the third power supply line is connected to the third high-potential power supply lead line.

18. The display substrate according to claim 17, wherein the display substrate further comprises a flexible printed circuit bonded to the bonding area, the flexible printed circuit at least comprises a control circuit, a plurality of circuit board pads, and a plurality of power supply transmission lines, the control circuit at least comprises a first control circuit configured to provide a first power supply signal, a second control circuit configured to provide a second power supply signal, and a third control circuit configured to provide a third power supply signal, the plurality of circuit board pads at least comprise a first pad, a second pad, and a third pad, and the plurality of power supply transmission lines at least comprise a first transmission line, a second transmission line, and a third transmission line; the first control circuit is connected to the first high-potential power supply lead line of the bonding area through the first transmission line and the first pad, the second control circuit is connected to the second high-potential power supply lead line of the bonding area through the second transmission line and the second pad, and the third control circuit is connected to the third high-potential power supply lead line of the bonding area through the third transmission line and the third pad.

19. The display substrate according to claim 17, wherein the display substrate further comprises a flexible printed circuit bonded to the bonding area, the flexible printed circuit at least comprises a control circuit, a plurality of circuit board pads, and a plurality of power supply transmission lines, the control circuit at least comprises a management integrated circuit, the management integrated circuit at least comprises a first signal channel configured to provide a first power supply signal, a second signal channel configured to provide a second power supply signal, and a third signal channel configured to provide a third power supply signal, the plurality of circuit board pads at least comprise a first pad, a second pad, and a third pad, and the plurality of power supply transmission lines at least comprise a first transmission line, a second transmission line, and a third transmission line; the first signal channel is connected to the first high-potential power supply lead line of the bonding area through the first transmission line and the first pad, the second signal channel is connected to the second high-potential power supply lead line of the bonding area through the second transmission line and the second pad, and the third signal channel is connected to the third high-potential power supply lead line of the bonding area through the third transmission line and the third pad.

20. A display apparatus, comprising the display substrate according to any one of claims 1 to 19.

21. A preparation method for a display substrate, the display substrate comprising a display area and a bonding area disposed on at least one side of the display area, the preparation method comprising:

forming a drive structure layer on a base substrate of the display area, wherein the drive structure layer comprises a plurality of circuit units forming a plurality of unit rows and a plurality of unit columns, the plurality of circuit units at least comprise a first circuit unit provided with a first pixel drive circuit, a second circuit unit provided with a second pixel drive circuit, and a third circuit unit provided with a third pixel drive circuit; the drive structure layer further comprises at least one connection line extending at least partially along a first direction, and a first power supply line, a second power supply line, and a third power supply line extending at least partially along a second direction, the first direction intersects with the second direction, the first power supply line, the second power supply line, and the third power supply line have different potentials; the first power supply line is connected to the first pixel drive circuit, the second power supply line is connected to the second pixel drive circuit, and the third power supply line is connected to the third pixel drive circuit; and the at least one connection line is connected to the first power supply line, the second power supply line, or the third power supply line to form a grid communication structure for transmitting a power supply signal on the display substrate; and
forming a light emitting structure layer on the drive structure layer, wherein the light emitting structure layer comprises a plurality of light emitting units, the plurality of light emitting units at least comprise a first light emitting unit provided with a first light emitting device, a second light emitting unit provided with a second light emitting device, and a third light emitting unit provided with a third light emitting device, the first light emitting device, the second light emitting device, and the third light emitting device emit light of different colors; the first light emitting device is connected to the first pixel drive circuit, the second light emitting device is connected to the second pixel drive circuit, and the third light emitting device is connected to the third pixel drive circuit.

FIG.1

FIG. 2

FIG. 3

FIG. 4

FIG. 5

FIG. 6A

FIG. 6B

FIG. 6C

FIG. 7

FIG. 8A

FIG. 8B

FIG. 9A

FIG. 9B

23

21

71

25

22

FIG. 9C

| Nth column | (N+1)th column | (N+2)th column | (N+3)th column | (N+4)th column | (N+5)th column | (N+6)th column | (N+7)th column |

X

Y

T4

T6

T3

T5

T8

t1

T7

Mth row

(M+1)th row

(M+2)th row

(M+3)th row

FIG. 10A

FIG. 10B

FIG. 10C

FIG. 11A

FIG. 11B

FIG. 11C

FIG. 12A

FIG. 12B

FIG. 12C

FIG. 13A

FIG. 13B

FIG. 14A

FIG. 14B

FIG. 14C

FIG. 15A

FIG. 15B

FIG. 16A

FIG. 16B

FIG. 16C

FIG. 16D

FIG. 16E

FIG. 16F

FIG. 17A

FIG. 17B

FIG. 18A

FIG. 18B

FIG. 18C

FIG. 18D

FIG. 19A

FIG. 19B

Nth column | (N+1)th column | (N+2)th column | (N+3)th column | (N+4)th column | (N+5)th column | (N+6)th column | (N+7)th column

X
Y

Mth row

(M+1)th row

(M+2)th row

(M+3)th row

FIG. 20A

90B    90D    90B    90D

90A    90C    90A    90C

90D    90B    90D    90B

90C    90A    90C    90A

110
120

110  120

FIG. 20B

FIG. 21A

FIG. 21B

FIG. 21C

FIG. 22

FIG. 23A

FIG. 23B

FIG. 23C

FIG. 24A

FIG. 24B

FIG. 25A

FIG. 25B

FIG. 25C

FIG. 26A

FIG. 26B

FIG. 27A

FIG. 27B

91

63 — 63

92

93

94

FIG. 27C

Nth column | (N+1)th column | (N+2)th column | (N+3)th column | (N+4)th column | (N+5)th column | (N+6)th column | (N+7)th column

X

Y

Mth row

(M+1)th row

(M+2)th row

(M+3)th row

V40

FIG. 28A

FIG. 28B

FIG. 29A

FIG. 29B

FIG. 29C

...

FIG. 30A

FIG. 30B

FIG. 30C

FIG. 31

FIG. 32A

FIG. 32B

FIG. 32C

FIG. 33

X
Y

| | | | | | |
|---|---|---|---|---|---|
| Q1 | Q2 | Q3 | Q1 | Q2 | Q3 |
| Q3 | Q2 | Q1 | Q3 | Q2 | Q1 |
| Q1 | Q2 | Q3 | Q1 | Q2 | Q3 |
| Q3 | Q2 | Q1 | Q3 | Q2 | Q1 |

FIG. 34A

X
Y
F1 F2 F3 F1 F2 F3

FIG. 34B

X
Y

FIG. 34C

X
Y
83 81 82   83 81 83 81 82   83 81

91
92
93
91

FIG. 35

FIG. 36

FIG. 37

FIG. 38

FIG. 39

FIG. 40

## INTERNATIONAL SEARCH REPORT

| International application No. |
| --- |
| **PCT/CN2024/104211** |

| A. | CLASSIFICATION OF SUBJECT MATTER |
| --- | --- |

H10K59/131(2023.01)i;  G09G3/3225(2016.01)i;  G09G3/32(2016.01)i

According to International Patent Classification (IPC) or to both national classification and IPC

| B. | FIELDS SEARCHED |
| --- | --- |

Minimum documentation searched (classification system followed by classification symbols)

IPC: H01L, H10K, G09G

Documentation searched other than minimum documentation to the extent that such documents are included in the fields searched

Electronic data base consulted during the international search (name of data base and, where practicable, search terms used)

VEN, CNABS, CNTXT, WOTXT, EPTXT, USTXT, CNKI, IEEE: 显示基板, 显示面板, 驱动, 发光, 像素, 电源线, 连接线, 网格, 网络, 功耗, display substrate, display panel, driving, light-emitting, pixel, power line, connecting line, grid, power consumption

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| PX | CN 221057129 U (BOE TECHNOLOGY GROUP CO., LTD. et al.) 31 May 2024 (2024-05-31) description, paragraphs [0005]-[0531], and figures 1-40 | 1-21 |
| Y | CN 116613175 A (BOE TECHNOLOGY GROUP CO., LTD. et al.) 18 August 2023 (2023-08-18) description, paragraphs [0005]-[0303], and figures 1-22 | 1-21 |
| Y | CN 115132810 A (BOE TECHNOLOGY GROUP CO., LTD. et al.) 30 September 2022 (2022-09-30) description, paragraphs [0035]-[0069], and figures 5-8 | 1-21 |
| A | US 2018061324 A1 (SAMSUNG DISPLAY CO., LTD.) 01 March 2018 (2018-03-01) entire document | 1-21 |
| A | CN 114743471 A (WUHAN CHINA STAR OPTOELECTRONICS SEMICONDUCTOR DISPLAY TECHNOLOGY CO., LTD.) 12 July 2022 (2022-07-12) entire document | 1-21 |

☐ Further documents are listed in the continuation of Box C.  ☑ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **13 September 2024** | **20 September 2024** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2024/104211**

| Patent document cited in search report | | | Publication date (day/month/year) | Patent family member(s) | | | Publication date (day/month/year) |
|---|---|---|---|---|---|---|---|
| CN | 221057129 | U | 31 May 2024 | None | | | |
| CN | 116613175 | A | 18 August 2023 | None | | | |
| CN | 115132810 | A | 30 September 2022 | None | | | |
| US | 2018061324 | A1 | 01 March 2018 | EP | 3288016 | A1 | 28 February 2018 |
| | | | | KR | 20180023098 | A | 07 March 2018 |
| | | | | KR | 102556883 | B1 | 20 July 2023 |
| | | | | US | 10629130 | B2 | 21 April 2020 |
| | | | | CN | 107767817 | A | 06 March 2018 |
| | | | | CN | 107767817 | B | 23 August 2022 |
| CN | 114743471 | A | 12 July 2022 | None | | | |

Form PCT/ISA/210 (patent family annex) (July 2022)

**REFERENCES CITED IN THE DESCRIPTION**

**Patent documents cited in the description**

• CN 202311068768